# EUROPEAN PATENT APPLICATION

(11) **EP 4 539 647 A1**
(43) Date of publication of application: **16.04.2025**
(21) Application number: 23820033.1
(22) Date of filing: 30.05.2023
(51) Int. Cl.: H10K 85/60, H10K 50/12

(54) **HOMOGENEOUS ORGANIC COMPLEX FOR ORGANIC ELECTROLUMINESCENT DEVICE AND ORGANIC ELECTROLUMINESCENT DEVICE COMPRISING SAME**

(30) Priority: 10.06.2022 KR 20220070982
(71) Applicant: Solus Advanced Materials Co., Ltd., Iksan-si, Jeollabuk-do 54584 (KR)
(72) Inventor: JO, Hyunjong, Yongin-si, Gyeonggi-do 16858 (KR); PARK, Hocheol, Yongin-si, Gyeonggi-do 16858 (KR); KIM, Youngbae, Yongin-si, Gyeonggi-do 16858 (KR); JUNG, Hwasoon, Yongin-si, Gyeonggi-do 16858 (KR); SONG, Hyobum, Yongin-si, Gyeonggi-do 16858 (KR); KIM, Geunhyeong, Yongin-si, Gyeonggi-do 16858 (KR)
(74) Representative: Office Freylinger
(86) International application number: PCT/KR2023/007349
(87) International publication number: WO 2023/239097

(57) **Abstract**

The present invention relates to a homogeneous organic complex for an organic electroluminescent device and an organic electroluminescent device comprising same, and more specifically, the present invention may provide: a homogeneous organic complex having a composition that is homogeneous at the molecular level without thermal damage; and an organic electroluminescent device comprising same in one or more organic layers, thereby having enhanced low voltage, high efficiency and long life characteristics.

## Description

### Technical Field

The present invention relates to a homogeneous organic complex for an organic electroluminescent device and an organic electroluminescent device comprising same. More specifically, the present invention pertains to a homogeneous organic complex uniform in composition at a molecular level without thermal damage, and an organic electroluminescent device incorporating one or more organic layers thereof, whereby the organic electroluminescent device exhibits enhanced low-voltage, high-efficiency, and long-lifespan characteristics.

### Background Art

An organic electroluminescent device (hereinafter referred to as "organic EL device") operates by applying a voltage between two electrodes, wherein holes are injected from the anode and electrons are injected from the cathode into the organic layer. The injected holes and electrons combine with each other, forming excitons, and light is emitted as the excitons transition to the ground state. Based on the functions thereof, the organic materials used in the organic layer can be classified into light-emitting materials, hole-injection materials, hole-transport materials, electron-transport materials, electron-injection materials, and so on.

To improve the performance of such organic EL devices, particularly in terms of lifespan, efficiency, and driving voltage, the organic layer is made of multiple organic compounds, for example, at least one host material having a dopant dispersed therein. The organic layer is formed by evaporating each of the organic compounds individually. Controlling the deposition rate of each organic compound with precision was difficult, and it led to relative waste in terms of material utilization. Additionally, when organic compounds are solidified into the form of powders, they can become electrostatically charged and handling them during deposition posed challenges.

Conventionally, techniques such as pre-mix methods, which involve mixing multiple organic compounds for application in organic layers, or pre-melting methods, which involve subjecting the organic materials to additional heat treatment, have been used. However, the pre-mix method does not achieve the desired level of uniform composition, and during pre-melting, thermal damage to the organic materials occurs due to heat treatment, inevitably leading to performance degradation in the final device.

### Disclosure of Invention

### Technical Problem

With the aim of solve the problems encountered in the related art, the present invention is to provide a novel organic layer composite material that ensures a more uniform composition than the conventional pre-mix method while fundamentally preventing the thermal damage caused by the conventional pre-melting method.

Also, the present invention is to provide an organic electroluminescent device that includes the new organic layer composite material and thus simultaneously achieves high efficiency, low voltage, and extended lifespan.

Other objectives and advantages of the present invention will become more apparent from the following detailed description and claims.

### Solution to Problem

To achieve the technical goals, the present invention provides a homogeneous organic complex composed of at least two types of organic compounds, wherein the homogeneous organic complex includes a first organic compound and a second organic compound, and is different in maximum emission wavelength from the first organic compound, the second organic compound, and a simple organic mixture of the first and second organic compounds.

In an embodiment of the present invention, the maximum emission wavelength of the homogeneous organic complex may shift to a longer wavelength than the maximum emission wavelength of the first organic compound, the second organic compound, and the simple organic mixture of the first and second organic compounds.

In an embodiment of the present invention, the homogeneous organic complex may be solid at room temperature.

In an embodiment of the present invention, the homogeneous organic complex may be formed by fully dissolving the first and second organic compounds in at least one organic solvent to create a homogeneous phase, which is then solidified.

In an embodiment of the present invention, the homogeneous organic complex may be compressed and molded under non-heat treatment conditions after solidification.

In an embodiment of the present invention, the solidified homogeneous organic complex may be in the form of a powder or stick, and the compressed and molded homogeneous organic complex may have a pellet shape selected from the group consisting of polyhedral, cylindrical, and spherical shapes.

In an embodiment of the present invention, the first and second organic compounds may have a deposition temperature difference of 0 to 30°C under a pressure of 10⁻⁶ torr.

In an embodiment of the present invention, the first and second organic compounds may be included at a weight ratio of 1:99 to 99:1.

In an embodiment of the present invention, the homogeneous organic complex may be free of inorganic substances and dopants.

In an embodiment of the present invention, the first and second organic compounds, which are same or different, may each independently be selected from the group consisting of host materials, electron injection materials, electron transport materials, electron blocking materials, hole injection materials, hole transport materials, hole blocking materials, and exciton blocking materials.

In an embodiment of the present invention, the first and second organic compounds may be host materials.

In an embodiment of the present invention, the first organic compound may have higher hole injection/transport properties than the second organic compound, and the second organic compound may have higher electron injection/transport properties than the first organic compound.

Furthermore, the present invention provides an organic electroluminescent device including: an anode; a cathode disposed facing the anode; and at least one organic layer disposed between the anode and the cathode, wherein the at least one organic layer includes the homogeneous organic complex.

In an embodiment of the present invention, the at least one organic layer may be formed by depositing the homogeneous organic complex, which is solid at room temperature.

Additionally, the present invention provides a method for manufacturing a homogeneous organic complex, the method including a first step of fully dissolving two or more types of vaporizable or sublimable organic compounds in at least one organic solvent to form a homogeneous phase and then solidifying same; and a second step of compressing the solidified homogeneous organic complex under non-heat treatment conditions to mold same.

### Advantageous Effects of Invention

According to an embodiment of the present invention, a homogeneous organic complex is formed using at least two types of vaporizable and/or sublimable organic compounds in a specified organic solvent, whereby the homogeneous organic complex can secure a more uniform mixture composition than that achieved by conventional pre-mix methods.

Additionally, since the present invention can easily configure a solid homogeneous organic complex of the desired size and shape without additional heat treatment, it fundamentally eliminates the thermal damage to materials associated with the conventional pre-melting method.

In addition, the present invention provides an organic electroluminescent device with high efficiency and long lifespan through simplification and streaming of the manufacturing process, which leads to the provision of a display panel with improved performance and lifespan.

The advantages according to the present invention are not limited by the contents exemplified above, and more various effects are included in the present specification.

### Best Mode for Carrying out the Invention

Hereinafter, a detailed description will be given of the present invention. The embodiments of the present invention are merely provided to make the disclosure of the present invention complete and to fully convey the scope of the present invention to those of ordinary skill in the art. The following embodiments may be embodied in many different forms and should not be construed as being limited to the embodiments set forth herein. Like reference numerals refer to like elements throughout the specification.

All terms (including technical and scientific terms) used in this specification may be interpreted as having the meaning commonly understood by those skilled in the art to which the present invention pertains, unless otherwise defined. Additionally, terms defined in generally used dictionaries should not be interpreted ideally or overly, unless explicitly defined otherwise.

Throughout the specification, when a certain part "includes" a certain component, it is understood that this is an open-ended term that allows the inclusion of other components, unless explicitly stated otherwise. Also, throughout the specification, terms such as "on" or "above" should be interpreted to include not only cases where a part is directly above or below a target part, but also cases where there is another part in between, and it does not necessarily imply a direction based on gravity. Furthermore, in this specification, terms such as "first" and "second" are used to distinguish components from each other, not to indicate any particular order or importance.

### <Homogeneous Organic Complex>

An embodiment of the present invention pertains to a homogeneous organic complex that includes at least two types of organic compounds for forming an organic layer in an organic electroluminescent device, wherein the at least two organic compounds are vaporizable or sublimable.

Specifically, in the present invention, a homogeneous organic complex with a molecular-level uniform composition is formed by utilizing the solubility parameter characteristics between at least two organic compounds and a predetermined organic solvent, without any pre-treatment such as additional heat treatment or mechanical mixing. This homogeneous organic complex not only has a more uniform composition than that achieved by the conventional pre-mixed method but also avoids the thermal damage typically caused to organic materials when the conventional pre-melting method is applied.

Conventionally, a complex has been formed by reacting one or more organic compounds with other reactants to establish chemical bonds (e.g., covalent, ionic, or coordination bonds), such as ionic compounds (e.g., Brønsted acids, halogen bonding substances), proton-donating compounds, and/or electron-pair-donating compounds. However, this approach requires the inclusion of materials other than the organic compounds used in organic electroluminescent devices (e.g., inorganic or organo-inorganic compounds), which can adversely affect the performance and stability of the device. Additionally, separate reactants and manufacturing processes are needed for chemical bonding, leading to complexities in manufacturing, increased process costs, and reduced productivity. In contrast, in the present invention, the homogeneous organic complex is formed by utilizing the solubility characteristics between at least two organic compounds and the organic solvent to achieve a molecular-level homogenized composition, which is then solidified by removing the organic solvent without chemical bonding with a third compound. This ensures that no substances potentially detrimental to device performance are included in the final product, while simultaneously enabling simplicity in the process, cost savings, and scalability for mass production.

Furthermore, since the solid homogeneous organic complex can be freely shaped with the desired size and form, the present invention facilitates the provision of an organic electroluminescent device with high efficiency and a long lifespan through simplification and streamlining of the manufacturing process.

The homogeneous organic complex of the present invention forms an organic complex with physical interactions between at least two organic compounds, resulting in optical properties entirely distinct from those of each individual organic compound or a simple heterogeneous mixture of the compounds.

In an specific embodiment, the homogeneous organic complex comprises at least two vaporizable or sublimable organic compounds including a first organic compound and a second organic compound, wherein the maximum emission wavelength of the homogeneous organic complex exhibits properties different from those of the first organic compound, the second organic compound, or a simple organic mixture of the two. Here, the simple organic mixture refers to a mere combination of the compounds without forming a complex.

Specifically, with greater stability in electrical energy compared to the first organic compound, the second organic compound, and a simple mixture thereof, the homogeneous organic complex according to the present invention shifts the maximum emission wavelength due to photon interaction toward a relatively stable longer wavelength region. Accordingly, the maximum emission wavelength (λmax) of the homogeneous organic complex may be shifted to a longer wavelength than the maximum emission wavelengths of the first organic compound, the second organic compound, and a heterogeneous organic mixture of the first and second organic compounds. In this regard, the extent of this wavelength shift is not particularly limited.

In another embodiment, the homogeneous organic complex may be solid at room temperature. For example, the homogeneous organic complex may be a solid material obtained by forming a homogeneous composition using the solubility parameter properties of at least two types of organic compounds and an organic solvent, followed by solvent removal.

In an embodiment, the homogeneous organic complex may be formed by fully dissolving the first and second organic compounds in at least one organic solvent to create a homogeneous phase, which is then solidified. The shape of the solidified homogeneous organic complex is not particularly limited and may be, for example, in the form of powder or sticks. If needed, the homogeneous organic complex, obtained as a solid mass, can be physically crushed using a mixer or similar equipment.

Since the homogeneous organic complex of the present invention is mixed at the molecular level in an appropriate solvent before being solidified, it fundamentally prevents the minimal inhomogeneity in composition that occurs with the solid-to-solid molecular mixing in conventional pre-melting methods. Additionally, because it uses solvent-based mixing, the mixture can be achieved without thermal damage at significantly lower temperatures than the pre-melting method.

To produce the homogeneous organic complex, it is appropriate to use at least one organic solvent with a solubility parameter similar to that of the at least two types of organic compounds to be mixed. So long as it dissolves the first and second organic compounds to form a homogeneous phase, any organic solvent can be employed without particular limitation. For example, commonly known organic solvents in the field may be used alone or as a mixture of two or more solvents. Non-limiting examples of usable organic solvents include tetrahydrofuran, methylene chloride, ethyl acetate, acetone, dimethyl ether, benzene, toluene, 1,2-dichlorobenzene, monochlorobenzene, methanol, ethanol, and isopropyl alcohol. No particular limitations are imparted to the mixing ratio between the two solvents. For example, the solvents may be mixed at a molar ratio of 1:99 to 99:1. This molar ratio can also be expressed in terms of weight ratio, and appropriate solvents can be selected using two or more co-solvents.

In another embodiment, the homogeneous organic complex may be obtained by compressing and molding the solidified homogeneous organic complex under non-heat treatment conditions.

The compression molding method is not particularly limited, and conventional molding methods known in the field may be used without restriction. By way of example, the complex may be injection-molded under a pressure of 20,000 to 40,000 kgf/cm². The shape of the compressed and molded homogeneous organic complex is not particularly limited and may be, for example, a pellet shape selected from the group consisting of polyhedral, cylindrical, and spherical shapes. It can also be freely molded into a solid form with the desired shape and/or size according to user preferences.

The at least two types of organic compounds that constitute the homogeneous organic complex of the present invention are not particularly limited, and organic compounds applicable as materials for the organic layer in organic electroluminescent devices via vaporization and/or sublimation can be used without restriction.

The homogeneous organic complex forms a homogeneous thin film in at least one organic layer provided in an organic electroluminescent device through conventional deposition methods known in the art. Accordingly, it is preferable for the first and second organic compounds constituting the homogeneous organic complex to have as similar deposition temperatures as possible. For example, the first and second organic compounds may have a deposition temperature difference of 0 to 30°C under a pressure of 10⁻⁶ torr.

Furthermore, the first and second organic compounds may be identical or different, and each may independently be selected from the group consisting of host materials, electron injection materials, electron transport materials, electron blocking materials, hole injection materials, hole transport materials, hole blocking materials, and exciton blocking materials. Specifically, the first and second organic compounds may be host materials, and more specifically, they may include at least two types of organic hosts without containing inorganic substances and dopants.

In the present invention, at least two types of organic compounds with strong electron properties and strong hole properties may be mixed to form the homogeneous organic complex, thereby improving the mobility of electrons and holes. For instance, the first organic compound may have relatively strong hole properties while the second organic compound may have relatively strong electron properties. This homogeneous organic complex, composed of a first organic compound with relatively strong hole properties and a second organic compound with relatively strong electron properties, exhibits bipolar characteristics. Compared to the use of the first or second organic compound alone, the homogenous organic complex can improve the mobility of electrons and holes, significantly enhancing the light emission efficiency.

Furthermore, in devices where materials with strongly unbalanced electron or hole properties are introduced into the emission layer, carrier recombination occurs at the interface between the emission layer and the electron or hole transport layer, leading to increased exciton formation and degradation of emission efficiency and lifespan. In contrast, in the present invention, the homogeneous organic complex of the first and second organic compounds is introduced as a material in the organic layer of a device, that is, as an emission layer material, so that the device thus fabricated balances carrier distribution within the emission layer, exhibiting improved light emission efficiency and lifespan characteristics.

The first organic compound usable in the present invention is not particularly limited, as long as it is a hole-transporting organic compound with stronger hole-transporting properties than the second organic compound.

The hole-transporting organic compound may be a hole-transporting host. For example, the hole-transporting host may be a carbazole-based compound.

Specifically, examples of the hole-transporting organic compound include, but are not limited to, compounds represented by Chemical Formula 1: 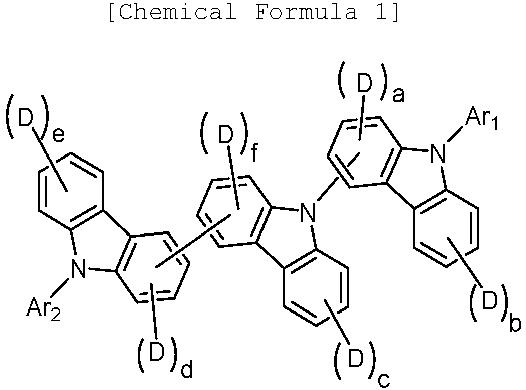 wherein,
D represents a deuterium atom,
a, d, and f are each an integer of 0 to 3,
b, c, and e are each an integer of 0 to 4,
Ar₁ and Ar₂, which are same or different, may each be independently selected from the group consisting of a hydrogen atom, a deuterium atom (D), a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphineoxide group, an alkyl phosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent groups,
the alkyl group, the alkenyl group, the alkynyl group, the cycloalkyl group, the heterocycloalkyl group, the aryl group, the heteroaryl group, the alkyloxy group, the aryloxy group, the alkylsilyl group, the arylsilyl group, the alkylboron group, the arylboron group, the alkylphosphine oxide group, the arylphosphine group, the arylphosphine oxide group, the arylamine group and fused ring of Ar₁ and Ar₂ may not or may each independently have one or more substituents selected from the group consisting of a deuterium atom, a halogen, a cyano group, a nitro group, an alkenyl group of C₂-C₄₀, an alkynyl group of C₂-C₄₀, a cycloalkyl group of C₃-C₄₀, a heterocycloalkyl group of 3 to 40 nuclear atoms, an alkyl group of C₁-C₄₀, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, with a proviso that when the substituents are plural in number, the substituents are the same as or different from each other.

In the compound represented by Chemical Formula 1, a, d, and f are each an integer of 0 to 3, b, c, and e are each an integer of 0 to 4. Herein, given that a, b, c, d, e, and f are each 0, it is meant that none of the hydrogen atoms on the compound are substituted with deuterium (D). Given that a, d, and f are each an integer of 1 to 3 and b, c, and e are each an integer of 1 to 4, it is meant that one or more hydrogen atoms on the compound are substituted with deuterium (D). In this regard, there may be 13≤a+b+c+d+e+f≤21. According to an embodiment, the number of deuterium atoms (D) contained in the compound of Chemical Formula 1 may be at least 13, or specifically at least 21. This compound of Chemical Formula 1 can enhance the stability of the chemical structure through deuterium (D) substitution, enabling the simultaneous realization of characteristics such as low voltage, high efficiency, and long lifespan of the organic electroluminescent device.

The deuterium may also be substituted with another substituent (R). When there are multiple substituents (R), they may be same or different. The other substituent (R) may be selected from the group consisting of a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide, an alkylphosphine oxide group of C₁-C₄₀, an arylphosphine group of C₆-C₆₀, an arylphosphine oxide group of C₆-C₆₀, and an arylamine group of C₆-C₆₀.

In the compound represented by Chemical Formula 1, Ar₁ and Ar₂, which are same or different, may each be independently selected from the group consisting of a hydrogen atom, a deuterium atom (D), a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group. Specifically, Ar₁ and Ar₂ are same or different and may each be independently selected from the group consisting of an aryl group of C₆-C₆₀ and a heteroaryl group of 5 to 60 nuclear atoms.

In an embodiment, Ar₁ and Ar₂ are same or different and may each be a substituent independently selected from the group consisting of the following substituents S1 to S4: 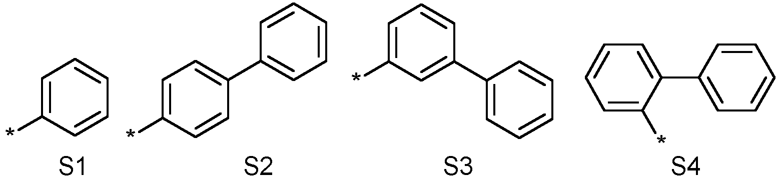 wherein, * represents a bonding site to Chemical Formula 1.

Depending on Ar₁ and Ar₂, the compound of Chemical Formula 1 may be a compound represented by Chemical Formula 2, but with no limitations thereto: 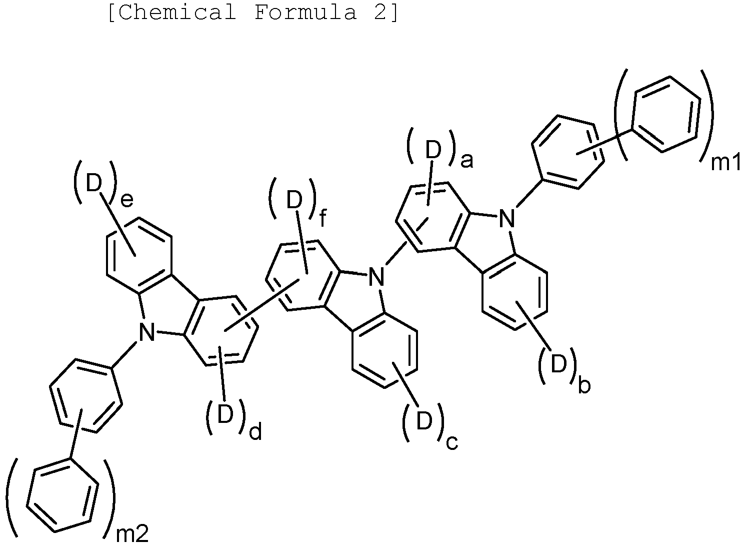 wherein,
a, b, c, d, e, and f are each as defined in Chemical Formula 1,
m1 and m2 are each 0 or 1.

In addition, the compound represented by Chemical Formula 1 may have various structures depending on the linkage positions between the carbazole moieties. In an embodiment, the compound of Chemical Formula 1 may be the compound represented by the following Chemical Formula 3: 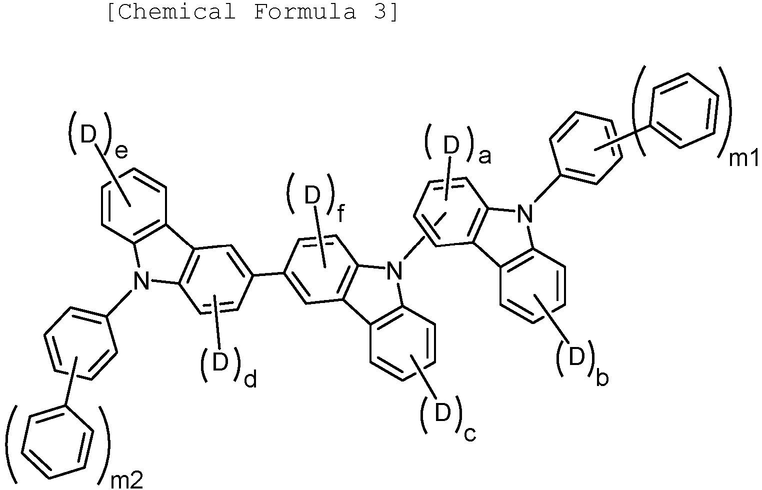 wherein,
a, b, c, d, e, and f are each as defined in Chemical Formula 1, and
m1 and m2 are each 0 or 1.

The compound represented by Chemical Formula 1 according to the present invention may be further specified as the following exemplary compounds, for example, compounds A-1 to D-4, but is not limited thereto:

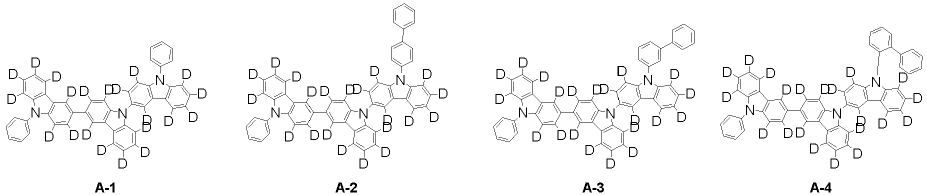

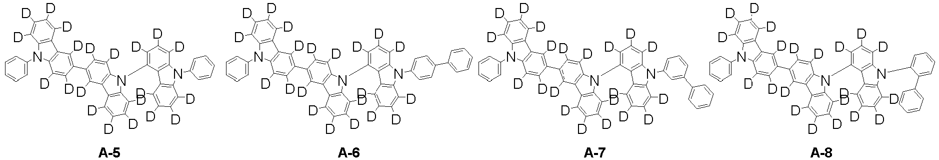

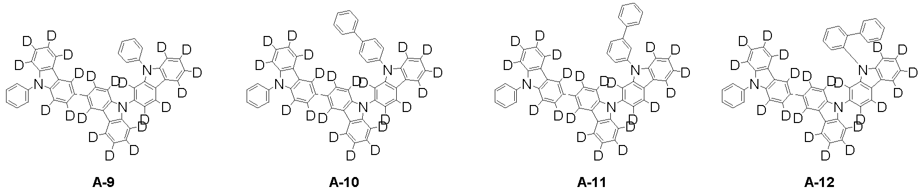

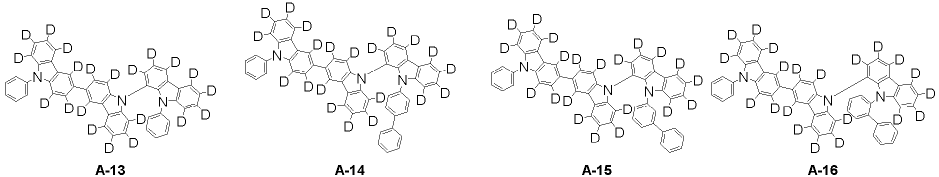

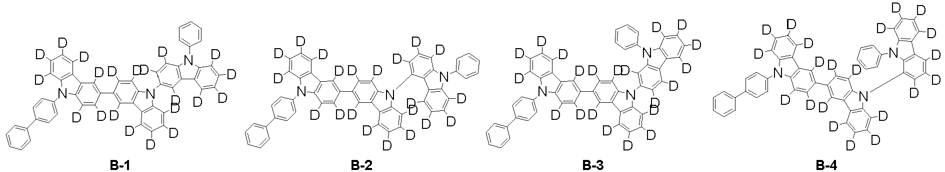

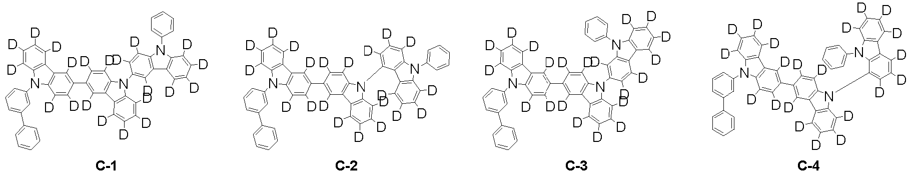

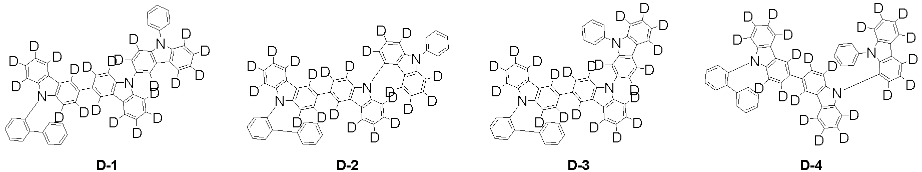

The second organic compound available in the present invention is not particularly limited as long as it is an electron-transporting organic compound with relatively strong electron-transporting properties than the first organic compound.

The electron-transporting organic compound may be an electron-transporting host. In an embodiment, the electron-transporting host may be an electron withdrawing group (EWG) represented by at least one of the following Chemical Formulas: 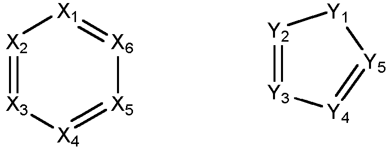 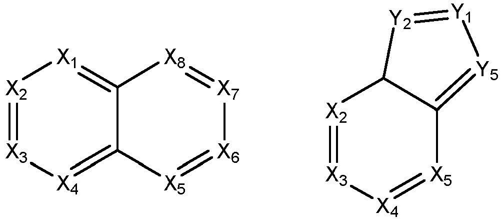 wherein,
X₁ to X₈ and Y₁ to Y₅, which are same or different, are each independently N or C(R), with a proviso that the monocyclic moiety or the polycyclic moiety comprises at least one N atom,
when two or more C(R) groups, the R's are same or different and are each independently selected from the group consisting of a hydrogen atom, a deuterium atom, a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, or may bond with an adjacent groups form a fuse ring,
the alkyl, alkenyl, alkynyl, aryl, heteroaryl, aryloxy, alkyloxy, cycloalkyl, heterocycloalkyl, arylamine, alkylsilyl, alkylboron, arylboron, arylphosphine, arylphosphine oxide, and arylamine groups of R may have at least one substituent selected from the group consisting of a hydrogen atom, a deuterium atom (D), a halogen, a cyano group, a nitro group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, and when the substituents are plural in number, the substituents are the same as or different from each other.

In an embodiment, the second organic compound may be an azine-based compound including at least one of nitrogen-containing moieties represented by the following Chemical Formulas. For example, the second organic compound may be an electron-transporting host including at least one moiety of triazine, pyrimidine, quinoline, quinazoline, and/or pyridine.

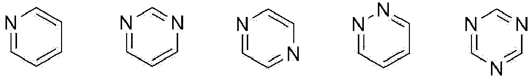

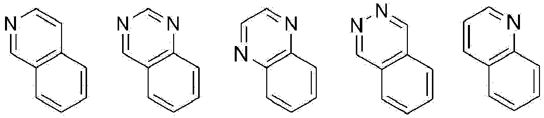

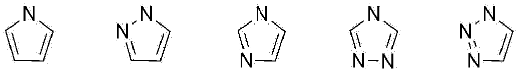

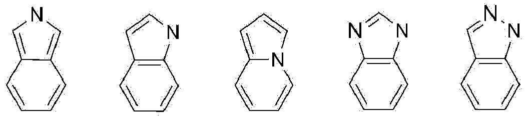

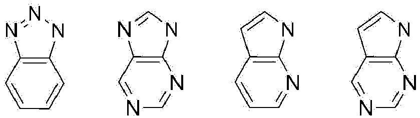

Specifically, the electron-transporting organic compound may be a compound represented by Chemical Formula 4, but is not limited thereto: 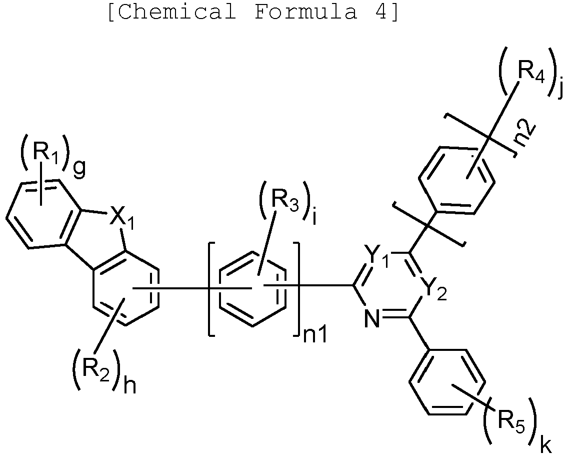 wherein,
D represents a deuterium atom,
h is an integer of 0 to 3,
g and I are each an integer of 0 to 4,
j and k are each an integer of 0 to 5,
n1 is an integer of 1 to 5,
n2 is an integer of 0 or 1,
X₁ is selected from the group consisting of O, S, Se, N(Ar₃), C(Ar₄)(Ar₅), and Si(Ar₆)(Ar₇),
Y₁ and Y₂, which are same or different, are each independently N or C(Ar₈), with a proviso that at least one of Y₁ and Y₂ is N,
Ar₃ to Ar₈ and R₁ to R₅, which are same or different, are each independently selected from the group consisting of a hydrogen atom, a deuterium atom (D), a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent groups, and
the alkyl, alkenyl, alkynyl, cycloalkyl, heterocycloalkyl, aryl, heteroaryl, alkyloxy, aryloxy, alkylsilyl, arylsilyl, alkylboron, arylboron, alkylphosphine oxide, arylphosphine, arylphosphine oxide, arylamine groups fused ring of Ar₃ to Ar₈ and R₁ to R₅ may not or may each independently have one or more substituents selected from the group consisting of a deuterium atom, a halogen, a cyano group, a nitro group, an alkenyl group of C₂-C₄₀, an alkynyl group of C₂-C₄₀, a cycloalkyl group of C₃-C₄₀, a heterocycloalkyl group of 3 to 40 nuclear atoms, an alkyl group of C₁-C₄₀, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, with a proviso that when there are two or more substituents, they may be same or different.

In the compound represented by Chemical Formula 4, Y₁ and Y₂, which are same or different, are each independently N or C(Ar₈), with a proviso that at least one of Y₁ and Y₂ is N.

Depending on Y₁ and Y₂, the moiety 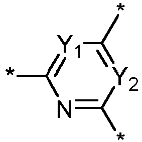 in the compound represented by Chemical Formula 4 may be selected from the group consisting of the following moieties Mo-1 to Mo-3: 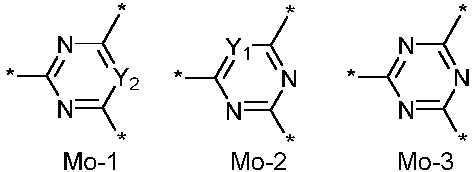 wherein,
* is a bonding site to Chemical Formula 4,
Y₁ and Y₂ are each independently C(Ar₈), and
Ar₈ is as defined in Chemical Formula 4.

In the compound represented by Chemical Formula 4, n1 is an integer of 1 to 5, and n2 is 0 or 1. In an embodiment, n1 may be 1 or 2 and n2 may be 0 or 1. In Chemical Formula 4, when n2 is 0, j is 1.

In the compound represented by Chemical Formula 4, X₁ is selected from the group consisting of O, S, Se, N(Ar₃), C (Ar₄)(Ar₅), and Si(Ar₆)(Ar₇). Depending on X₁, the dibenzo moiety may be a monovalent dibenzofuran group, a monovalent dibenzothiphene group, a monovalent fluorene group, etc.

Ar₃ to Ar₈, which are same or different, may each be independently selected from the group consisting of a hydrogen atom, a deuterium atom (D), a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group (e.g., Ar₃-R₁, Ar₃-R₂, Ar₄-Ar₅, Ar₆-Ar₇, Ar₄-R₁, Ar₄-R₂, Ar₆-R₁, Ar₆-R₂, etc.). Specifically, Ar₃ to Ar₈, which are same or different, may each be independently selected from the group consisting of an alkyl group of C₁-C₄₀, an aryl group of C₆-C₆₀ and a heteroaryl group of 5 to 60 nuclear atoms and may form a fused ring with an adjacent group (e.g., Ar₃-R₁, Ar₃-R₂, Ar₄-Ar₅, Ar₆-Ar₇, Ar₄-R₁, Ar₄-R₂, Ar₆-R₁, Ar₆-R₂, etc.). Here, the fused ring may be at least one selected from the group consisting of a fused aliphatic ring of C₃-C₆₀ (specifically, a fused aliphatic ring of C₃-C₃₀), a fused aromatic ring of C₆-C₆₀ (specifically, a fused aromatic ring of C₆-C₃₀), a 5- to 60-membered fused heteroaromatic ring (specifically, 5- to 30-membered fused heteroaromatic ring), a spiro ring of C₃-C₆₀, and a combination thereof.

According to an embodiment, the moiety 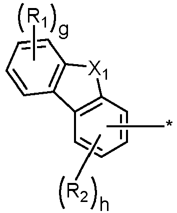 in Chemical Formula 4 may be selected from the group consisting of the following moieties Dz-1 to Dz-32, but with no limitations thereto: 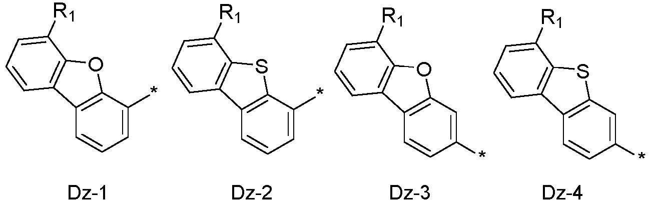 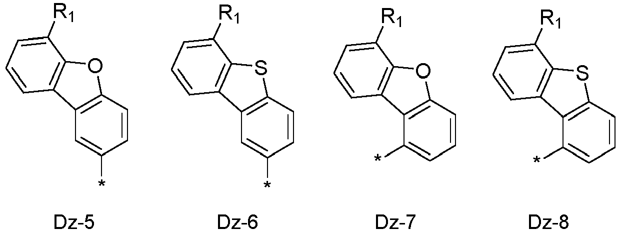 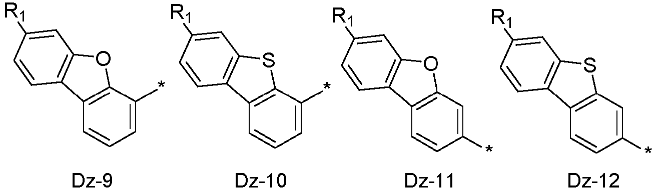 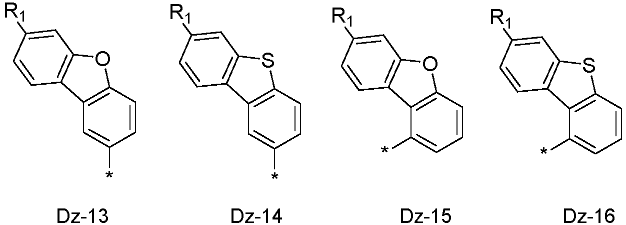 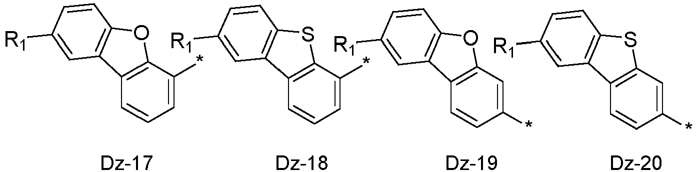 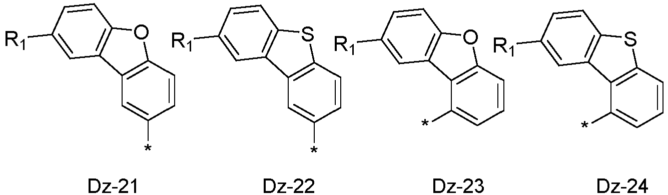 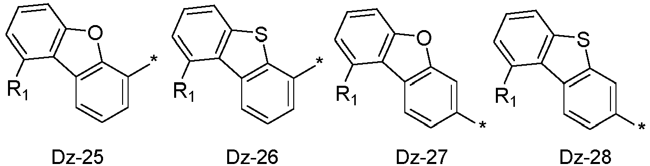 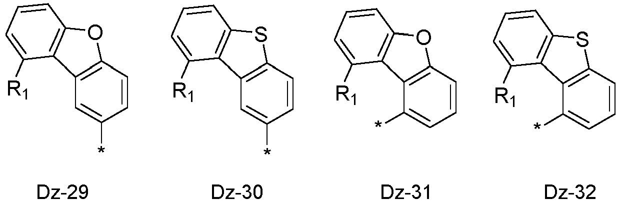 wherein,
* is a bonding site to Chemical Formula 4, and
R₁ may be an aryl group of C₆-C₆₀, and specifically a phenyl group.

In the compound represented by Chemical Formula 4, h is an integer of 0 to 3, g and i are each an integer of 0 to 4, and j and k are each an integer of 0 to 5. Here, given that g, h, i, j, and k are each 0, it is meant that none of the hydrogen atoms on the compound are substituted with deuterium (D). When h is an integer of 1 to 3, g and i are each an integer of 1 to 4, and j and k are each an integer of 1 to 5, one or more R₁ to R₅, which are same or different, may each independently selected from the group consisting of a deuterium atom (D), a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group. Specifically, one or more R₁ to R₅, which are same or different, may each be independently selected from the group consisting of a hydrogen atom, a halogen, a cyano group, a nitro group, an amino group, an alkyl group of C₁-C₄₀, an aryl group of C₆-C₆₀, and a heteroaryl group of 5 to 60 nuclear atoms.

The alkyl, alkenyl, alkynyl, cycloalkyl, heterocycloalkyl, aryl, heteroaryl, alkyloxy, aryloxy, alkylsilyl, arylsilyl, alkylboron, arylboron, alkylphosphine oxide, arylphosphine, arylphosphine oxide, and arylamine groups and the fused ring of Ar₃ to Ar₈ and R₁ to R₅ may not or may each independently have at least one substituent selected from the group consisting of a deuterium atom, a halogen, a cyano group, a nitro group, an alkenyl group of C₂-C₄₀, an alkynyl group of C₂-C₄₀, a cycloalkyl group of C₃-C₄₀, a heterocycloalkyl group of 3 to 40 nuclear atoms, an alkyl group of C₁-C₄₀, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀. When there are two or more substituents, they are same or different.

The compound of Chemical Formula 4 may be a compound represented by the following Chemical Formula 5, but is not limited thereto: 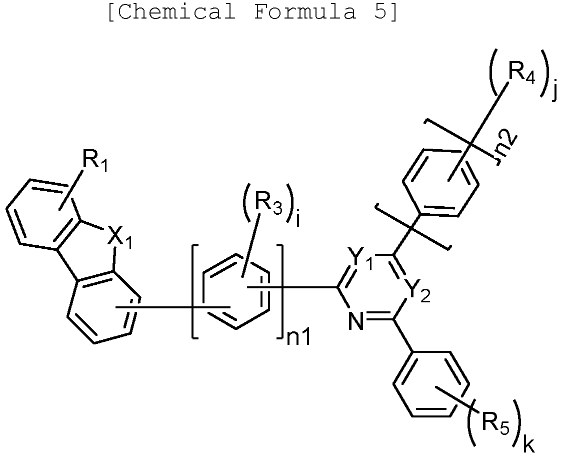 wherein,
i, j, k, R₁, R₃ to R₅, n1, n2, X₁, Y₁, and Y₂ are each as defined in Chemical Formula 4.

Specifically, the compound of Chemical Formula 4 may be a compound represented by the following Chemical Formula 6 or 7, but with no limitations thereto: 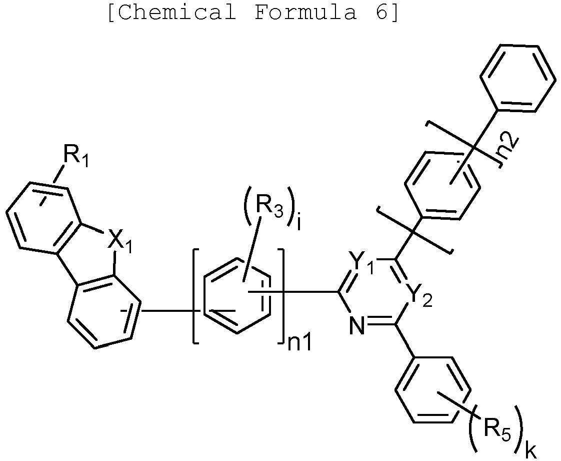 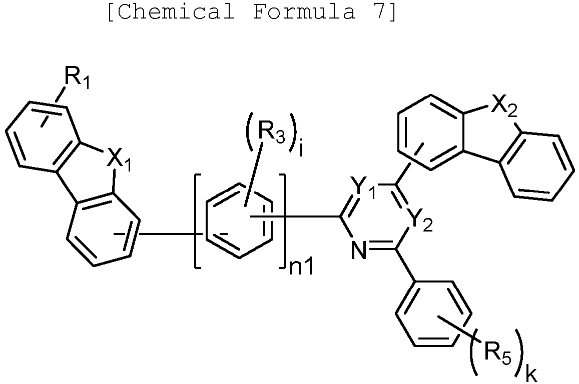 wherein,
i, k, R₁, R₃, R₅, n1, n2, Y₁, and Y₂ are each as defined in Chemical Formula 4,
X₁ and X₂ may each be O or S and specifically O.

More specifically, the compound of Chemical Formula 4 may be a compound represented by the following Chemical Formula 8 or 9, but is not limited thereto: 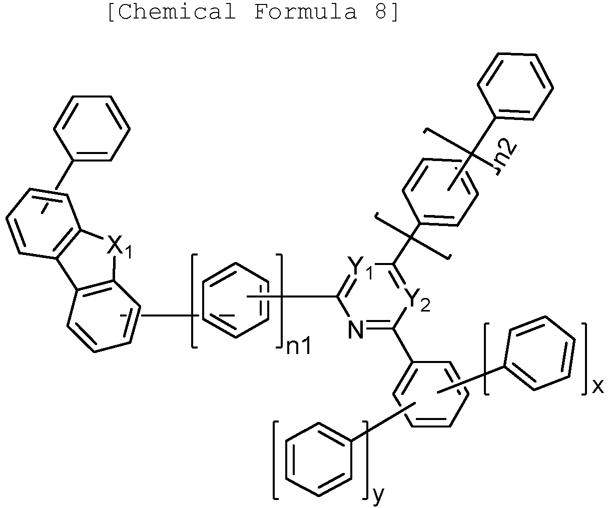 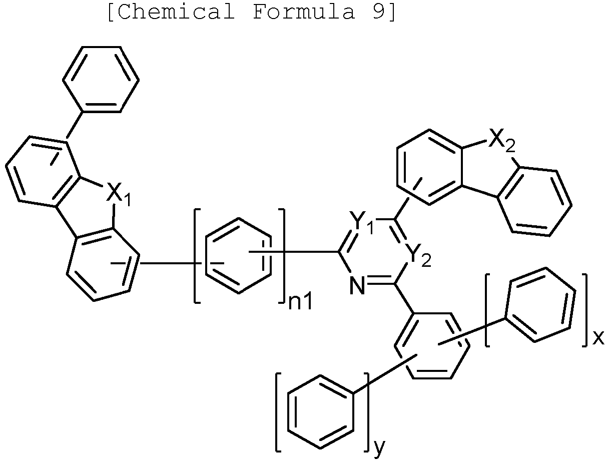 wherein,
n1, n2, Y₁, and Y₂ are each as defined in Chemical Formula 4, and specifically n1 is 1 or 2, n2 is 0 or 1, and Y₁ and Y₂ are both N,
x and y may each be 0 or 1,
X₁ and X₂ may each be O or S and specifically may be O.

The compound represented by Chemical Formula 2 according to the present invention may be further specified as the following exemplary compounds, for example, compounds E-1 to E-10, but is not limited thereto:

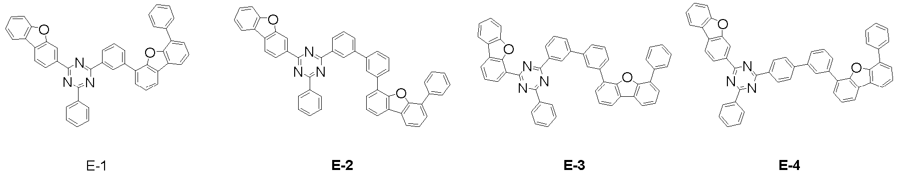

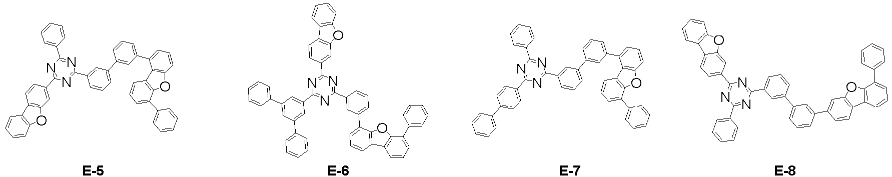

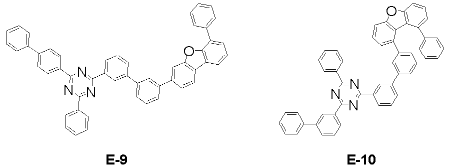

As used herein, the term "alkyl" refers to a monovalent substituent derived from a linear or branched saturated hydrocarbon having 1 to 40 carbon atoms. Examples include methyl, ethyl, propyl, isobutyl, sec-butyl, pentyl, isoamyl, hexyl, and the like, but are not limited thereto.

As used herein, the term "alkenyl" refers to a monovalent substituent derived from a linear or branched unsaturated hydrocarbon of 2 to 40 carbon atoms and containing at least one carbon-carbon double bond. Examples include vinyl, allyl, isopropenyl, 2-butenyl, and the like, but are not limited thereto.

As used herein, the term, "alkynyl" refers to a monovalent substituent derived from a linear or branched unsaturated hydrocarbon of 2 to 40 carbon atoms and containing at least one carbon-carbon triple bond. Examples include ethynyl, 2-propynyl, and the like, but are not limited thereto.

As used herein, the term "cycloalkyl" refers to a monovalent substituent derived from a monocyclic or polycyclic non-aromatic hydrocarbon of 3 to 40 carbon atoms. Examples of cycloalkyl include cyclopropyl, cyclopentyl, cyclohexyl, norbornyl, adamantyl, and the like, but are not limited thereto.

As used herein, the term "heterocycloalkyl" refers to a monovalent substituent derived from a non-aromatic hydrocarbon of 3 to 40 nuclear atoms, in which one or more carbon atoms, preferably 1 to 3 carbon atoms, in the ring are replaced by heteroatoms such as N, O, S, or Se. Examples of heterocycloalkyl include morpholinyl and piperazinyl, but are not limited thereto.

As used herein, the term "aryl" refers to a monovalent substituent derived from an aromatic hydrocarbon of 6 to 60 carbon atoms, either as a single ring or as a combination of two or more rings. The combination may include pendant rings or fused rings. Examples of aryl include phenyl, naphthyl, phenanthryl, and anthryl, but are not limited thereto.

As used herein, the term "heteroaryl" refers to a monovalent substituent derived from a mono- or polyheterocyclic aromatic hydrocarbon of 5 to 60 ring atoms, where one or more carbon atoms, preferably 1 to 3 carbon atoms, in the ring are replaced by heteroatoms such as N, O, S, or Se. It may include simple pendant or fused rings and may also include fused forms with aryl groups. Examples of such heteroaryl include: 6-membered monocyclic rings such as pyridyl, pyrazinyl, pyrimidinyl, pyridazinyl, and triazinyl; polycyclic rings such as phenoxathienyl, indolizinyl, indolyl, purinyl, quinolyl, benzothiazolyl, and carbazolyl; 2-furanyl; N-imidazolyl; 2-isoxazolyl; 2-pyridyl; and 2-pyrimidinyl, but are not limited thereto.

As used herein, the term "alkoxy" refers to a monovalent substituent represented by R'O-, where R' refers to an alkyl group of 1 to 40 carbon atoms, which may have a linear, branched, or cyclic structure. Examples of alkoxy include methoxy, ethoxy, n-propoxy, 1-propoxy, t-butoxy, n-butoxy, and pentoxy, but are not limited thereto.

As used herein, the term "aryloxy" refers to a monovalent substituent represented by RO-, where R refers to an aryl of 5 to 40 carbon atoms. Examples of such aryloxy include phenoxy, naphthoxy, diphenoxy, and the like, but are not limited thereto.

As used herein, the term "alkylsilyl" refers to a silyl substituted with an alkyl of 1 to 40 carbon atoms, and includes mono-, di-, and trialkylsilyl groups. In addition, "arylsilyl" refers to a silyl substituted with an aryl of 5 to 60 carbon atoms, and includes mono-, di-, and triarylsilyl, as well as polyarylsilyl.

As used herein, the term "alkylboron" refers to a boron group substituted with an alkyl group of 1 to 40 carbon atoms, and "arylboron" refers to a boron substituted with an aryl of 6 to 60 carbon atoms.

As used herein, the term "alkylphosphinyl" refers to a phosphine substituted with an alkyl of 1 to 40 carbon atoms, and includes mono- as well as dialkylphosphinyl. Likewise, "arylphosphinyl" refers to a phosphine substituted with a monoaryl or diaryl of 6 to 60 carbon atoms, and includes mono- as well as diarylphosphinyl groups.

As used herein, the term "aryl amine" refers to an amine substituted with an aryl of 6 to 60 carbon atoms, and includes mono- as well as diaryl amines.

As used herein, the term "heteroaryl amine" refers to an amine substituted with a heteroaryl of 5 to 60 nuclear atoms, and includes mono- as well as di-heteroaryl amines.

As used herein, "(aryl) (heteroaryl)amine" refers to an amine substituted with an aryl of 6 to 60 carbon atoms and a heteroaryl group of 5 to 60 ring atoms.

As used herein, the term "fused ring" refers to a fused aliphatic ring of 3 to 40 carbon atoms, a fused aromatic ring of 6 to 60 carbon atoms, a fused heteroaliphatic ring of 3 to 60 ring atoms, a fused heteroaromatic ring of 5 to 60 ring atoms, a spiro ring of 3 to 60 carbon atoms, or a combination thereof.

The homogeneous organic complex according to the present invention may be obtained by using the first organic compound and the second organic compound at a weight ratio of, for example, approximately 1:99 to 99:1. In an embodiment, the first organic compound and the second organic compound may be included at a weight ratio of 20:80 to 80:20. Given the specified range, the bipolar characteristics are more effectively implemented, thereby simultaneously improving the efficiency and lifespan of the device. The weight ratio described above can also be expressed as a molar ratio.

The homogeneous organic complex may be used as at least one organic material in an organic electroluminescent device, for example, as an emissive material, an absorptive material, a charge transport material, a charge injection material, a charge blocking material, or a combination thereof. Specifically, the homogeneous organic complex may be used as an emissive material, and more specifically as a host material.

The homogeneous organic complex according to the present invention may be manufactured by utilizing the solubility parameter properties of at least two types of organic compounds and an organic solvent.

An embodiment for manufacturing the homogeneous organic complex includes: a first step of fully dissolving two or more vaporizable or sublimable organic compounds in at least one organic solvent to form a homogeneous phase, followed by solidification; and a second step of compressing and molding the solidified homogeneous organic complex under non-heat treatment conditions.

In this regard, the molding conditions in the second step are not particularly limited and may involve injection molding under a pressure of, for example, 20,000 to 40,000 kgf/cm².

The solidified homogeneous organic complex prepared in the first step may be in the form of powder or sticks, and the homogeneous organic complex molded in the second step may have a pellet shape selected from the group consisting of polyhedral, cylindrical, and spherical shapes, but with no limitations thereto.

Additionally, since each component constituting the homogeneous organic complex according to the present invention is the same as described above, individual explanations therefor are omitted.

The pellet-shaped homogeneous organic complex manufactured as described above may be deposited as one of the organic layers in an organic electroluminescent device through conventional vacuum deposition methods, such as evaporation or sputtering.

### <Organic Electroluminescent Device>

Another embodiment of the present invention relates to an organic electroluminescent (EL) device that includes the homogeneous organic complex of the present invention as a material for at least one organic layer.

Specifically, the present invention provides an organic electroluminescent device including an anode, a cathode, and one or more organic layers interposed between the anode and the cathode, wherein at least one of the organic layers includes a homogeneous thin film formed from the homogeneous organic complex.

The one or more organic layers may include one or more of a hole injection layer, a hole transport layer, an emission layer, an emission auxiliary layer, a lifetime improvement layer, an electron transport layer, an electron transport auxiliary layer, and an electron injection layer. Specifically, the organic layer containing the homogeneous organic complex may be an emission layer.

In this regard, the first organic compound may be a hole-transporting host, and the second organic compound may be an electron-transporting host. The mixing ratio of the first and second organic compounds is not particularly limited and, for example, the first and second organic compound may be mixed at a weight ratio of 1:99 to 99:1, specifically at a weight ratio of 20:80 to 80:20.

The emission layer may further include commonly known hosts and/or dopants in addition to the first and second organic compounds described above. In this regard, the total content of the first and second organic compounds may be from 0 to 100 wt% based on the total amount of the host.

Furthermore, the total amount of the host may be approximately 70 to 99.9 wt% based on the total amount of the emission layer, and the dopant content may be approximately 0.1 to 30 wt% based on the total amount of the emission layer.

The structure of the organic electroluminescent device of the present invention is not particularly limited, but may be a structure in which a substrate, an anode, a hole injection layer, a hole transport layer, an emission auxiliary layer, an emission layer, an electron transport layer, and a cathode are sequentially stacked. At least one of the hole injection layer, hole transport layer, emission auxiliary layer, emission layer, electron transport layer, and electron injection layer may include the homogeneous organic complex, preferably with the emission layer containing the homogeneous organic complex. Additionally, an electron injection layer may be further laminated on the electron transport layer.

The organic electroluminescent device of the present invention may be structured to include an insulating layer or an adhesive layer at the interface between the electrode and the organic layer.

The organic electroluminescent device of the present invention can be fabricated by forming the organic layers and electrodes using materials and methods commonly known in the art, except that at least one of the organic layers includes the homogeneous organic complex described above.

The organic layers can be formed by dry film formation methods, such as vacuum deposition, sputtering, plasma coating, ion plating, and the like, but with no limitations thereto.

The substrate used in manufacturing the organic electroluminescent device of the present invention is not particularly limited and may be, for example, a silicon wafer, quartz, glass plate, metal plate, plastic film, or sheet.

Furthermore, so long as it is known in the art, any anode material may be used without limitation. Examples include: metals such as vanadium, chromium, copper, zinc, and gold, or alloys thereof; metal oxides such as zinc oxide, indium oxide, indium tin oxide (ITO), and indium zinc oxide (IZO); combinations of metals and oxides such as ZnO:Al or SnO₂:Sb; conductive polymers such as polythiophene, poly(3-methylthiophene), poly[3,4-(ethylenedioxy)thiophene] (PEDT), polypyrrole, and polyaniline; and carbon black, but are not limited thereto.

Similarly, any cathode material if known in the art can be used without limitation. Examples include: metals such as magnesium, calcium, sodium, potassium, titanium, indium, yttrium, lithium, gadolinium, aluminum, silver, tin, or lead, and alloys thereof; and multilayer materials such as LiF/Al or LiO₂/Al, but are not limited thereto.

Additionally, the materials for the hole injection layer, hole transport layer, electron injection layer, and electron transport layer are not particularly limited, and any conventional materials known in the art may be used without restriction.

A better understanding of the present invention may be obtained through the following examples, which are set forth to illustrate, but are not construed to limit, the present invention.

### <PREPARATION EXAMPLE 1-1> Cz-D1

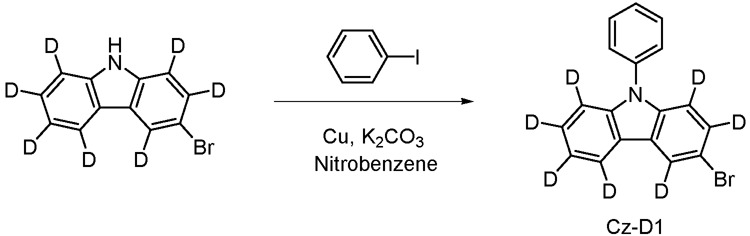

Under a nitrogen atmosphere, a mixture of 3-bromo-9H-carbazole-1,2,4,5,6,7,8-d7 (134.3 g, 530.6 mmol), iodobenzene (130.0 g, 636.7 mmol), Cu (16.8 g, 265.3 mmol), K₂CO₃(146.7 g, 1,061.3 mmol), and toluene (1000 ml) was stirred at 110°C for 12 hours.

After completion of the reaction, the reaction mixture was subjected to extraction with ethyl acetate, and the extract was dried over MgSO₄ and purified by column chromatography (Hexane:EA = 5:1 (v/v)) to afford Cz-D1 (125.7 g, yield 72%).
Mass (Calcd.: 329.25, Found: 329 g/mol)

### <PREPARATION EXAMPLE 1-2> Synthesis of Cz-D2

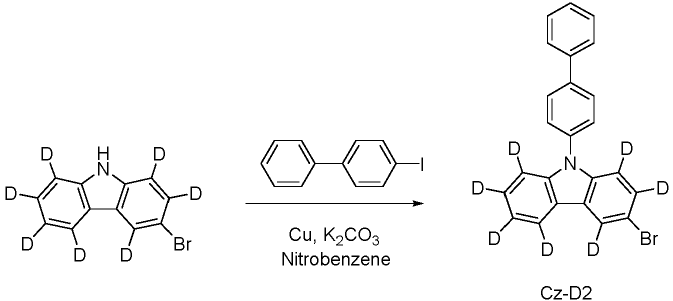

The same procedure as in Preparation Example 1-1, with the exception of using 4-iodo-1,1'-biphenyl (178.3 g, 636.7 mmol) instead of iodobenzene used in Preparation Example 1-1, was conducted to afford the target compound Cz-D2 (135.5 g, yield 63%).
Mass (Calcd.: 405.35, Found: 405 g/mol)

### <PREPARATION EXAMPLE 1-3> Synthesis of Cz-D3

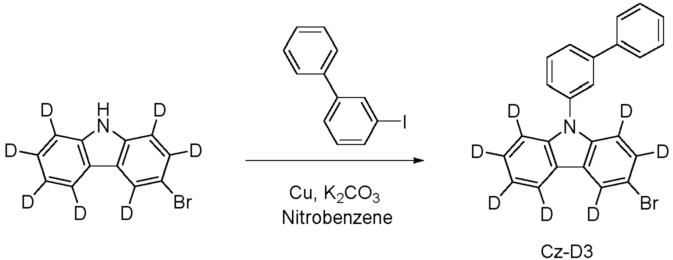

The same procedure as in Preparation Example 1-1, with the exception of using 3-iodo-1,1'-biphenyl (178.3 g, 636.7 mmol) instead of iodobenzene used in Preparation Example 1-1, was conducted to afford the target compound Cz-D3 (148.4 g, yield 69%).
Mass (Calcd.: 405.35, Found: 405 g/mol)

### <PREPARATION EXAMPLE 1-4> Synthesis of Cz-D4

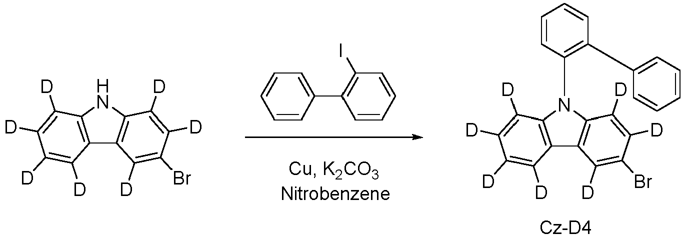

The same procedure as in Preparation Example 1-1, with the exception of using 2-iodo-1,1'-biphenyl (178.3 g, 636.7 mmol) instead of iodobenzene, was conducted to afford the target compound Cz-D4 (96.8 g, yield 45%).
Mass (Calcd.: 405.35, Found: 405 g/mol)

### <PREPARATION EXAMPLE 2-1> Synthesis of Synthesis of Cz-D5

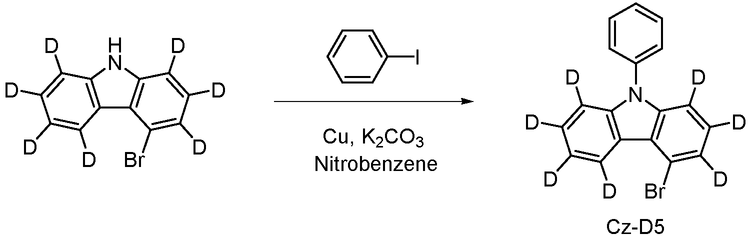

The same procedure as in Preparation Example 1-1, with the exception of using 4-bromo-9H-carbazole-1,2,3,5,6,7,8-d7 (134.3 g, 530.6 mmol) instead of 3-bromo-9H-carbazole-1,2,4,5,6,7,8-d7 used in Preparation Example 1-1, was conducted to afford the target compound Cz-D5 (117.1 g, yield 67%).
Mass (Calcd.: 329.25, Found: 329 g/mol)

### <PREPARATION EXAMPLE 2-2> Synthesis of Cz-D6

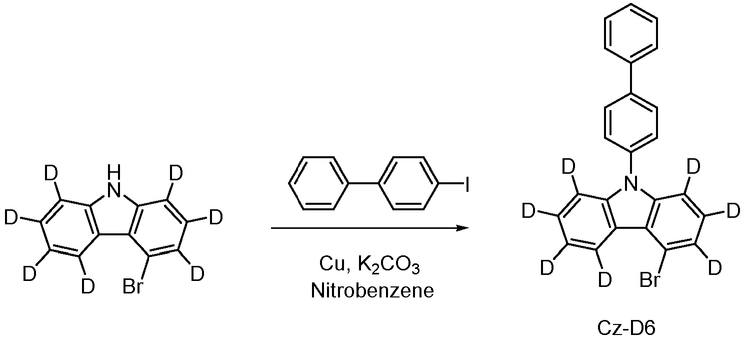

The same procedure as in Preparation Example 2-1, with the exception of using 4-iodo-1,1'-biphenyl (178.3 g, 636.7 mmol) instead of iodobenzene used in Preparation Example 2-1, was conducted to afford the target compound Cz-D6 (139.8 g, yield 65%).
Mass (Calcd.: 405.35, Found: 405 g/mol)

### <PREPARATION EXAMPLE 2-3> Synthesis of Cz-D7

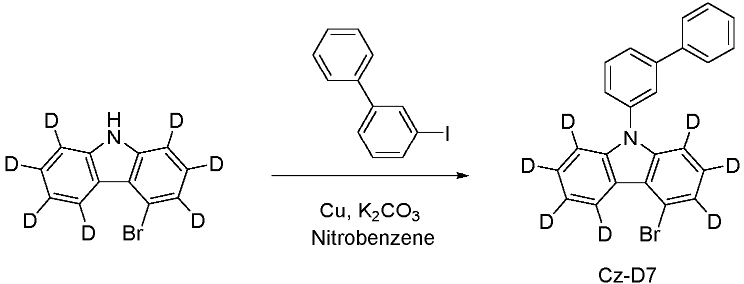

The same procedure as in Preparation Example 2-1, with the exception of using 3-iodo-1,1'-biphenyl (178.3 g, 636.7 mmol) instead of iodobenzene used in Preparation Example 2-1, was conducted to afford the target compound Cz-D7 (152.7 g, yield 71%).
Mass (Calcd.: 405.35, Found: 405 g/mol)

### <PREPARATION EXAMPLE 2-4> Synthesis of Cz-D8

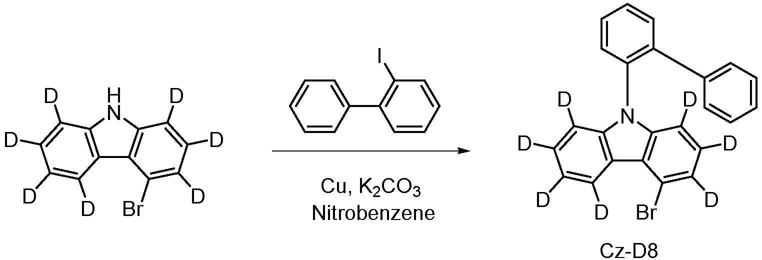

The same procedure as in Preparation Example 2-1, with the exception of using 2-iodo-1,1'-biphenyl (178.3 g, 636.7 mmol) instead of iodobenzene used in Preparation Example 2-1, was conducted to afford the target compound Cz-D8 (75.2 g, yield 35%).
Mass (Calcd.: 405.35, Found: 405 g/mol)

### <PREPARATION EXAMPLE 3-1> Synthesis of Cz-D9

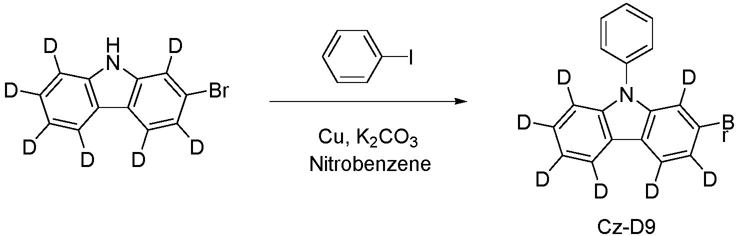

The same procedure as in Preparation Example 1-1, with the exception of using 2-bromo-9H-carbazole-1,3,4,5,6,7,8-d7 (134.3 g, 530.6 mmol) instead of 3-bromo-9H-carbazole-1,2,4,5,6,7,8-d7 used in Preparation Example 1-1, was conducted to afford the target compound Cz-D9 (134.5 g, yield 77%).
Mass (Calcd.: 329.25, Found: 329 g/mol)

### <PREPARATION EXAMPLE 3-2> Synthesis of Cz-D10

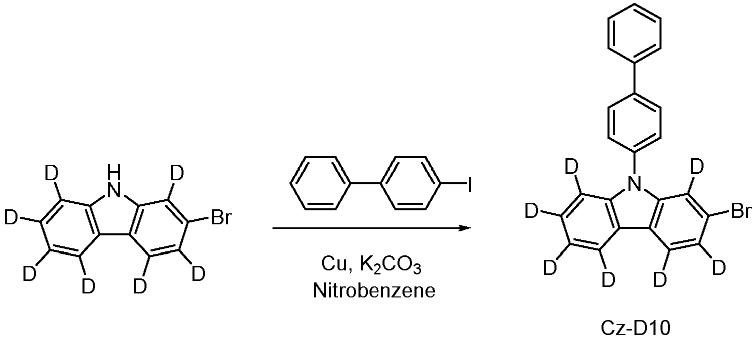

The same procedure as in Preparation Example 3-1, with the exception of using 4-iodo-1,1'-biphenyl (178.3 g, 636.7 mmol) instead of iodobenzene used in Preparation Example 3-1, was conducted to afford the target compound Cz-D10 (159.1 g, yield 74%).
Mass (Calcd.: 405.35, Found: 405 g/mol)

### <PREPARATION EXAMPLE 3-3> Synthesis of Cz-D11

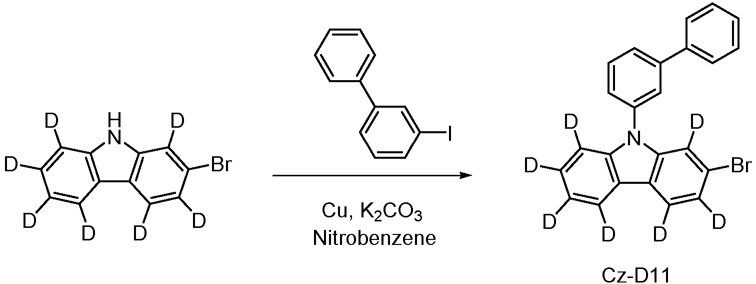

The same procedure as in Preparation Example 3-1, with the exception of using 3-iodo-1,1'-biphenyl (178.3 g, 636.7 mmol) instead of iodobenzene used in Preparation Example 3-1, was conducted to afford the target compound Cz-D11 (163.4 g, yield 76%).
Mass (Calcd.: 405.35, Found: 405 g/mol)

### <PREPARATION EXAMPLE 3-4> Synthesis of Cz-D12

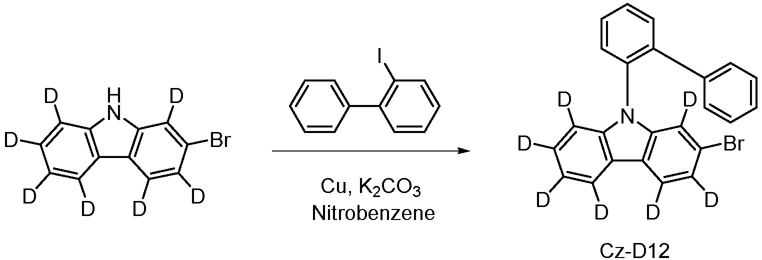

The same procedure as in Preparation Example 3-1, with the exception of using 2-iodo-1,1'-biphenyl (178.3 g, 636.7 mmol) instead of iodobenzene used in Preparation Example 3-1, was conducted to afford the target compound Cz-D12 (92.4 g, yield 43%).
Mass (Calcd.: 405.35, Found: 405 g/mol)

### <PREPARATION EXAMPLE 4-1> Synthesis of Cz-D13

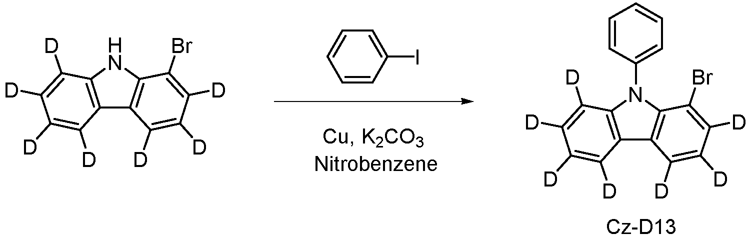

The same procedure as in Preparation Example 1-1, with the exception of using 1-bromo-9H-carbazole-2,3,4,5,6,7,8-d7 (134.3 g, 530.6 mmol) instead of 3-bromo-9H-carbazole-1,2,4,5,6,7,8-d7 used in Preparation Example 1-1, was conducted to afford the target compound Cz-D13 (94.3 g, yield 54%).
Mass (Calcd.: 329.25, Found: 329 g/mol)

### <PREPARATION EXAMPLE 4-2> Synthesis of Cz-D14

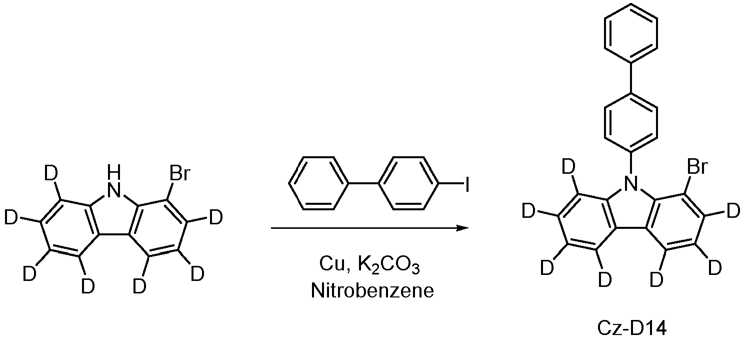

The same procedure as in Preparation Example 4-1, with the exception of using 4-iodo-1,1'-biphenyl (178.3 g, 636.7 mmol) instead of iodobenzene used in Preparation Example 4-1, was conducted to afford the target compound Cz-D14 (122.6 g, yield 57%).
Mass (Calcd.: 405.35, Found: 405 g/mol)

### <PREPARATION EXAMPLE 4-3> Synthesis of Cz-D15

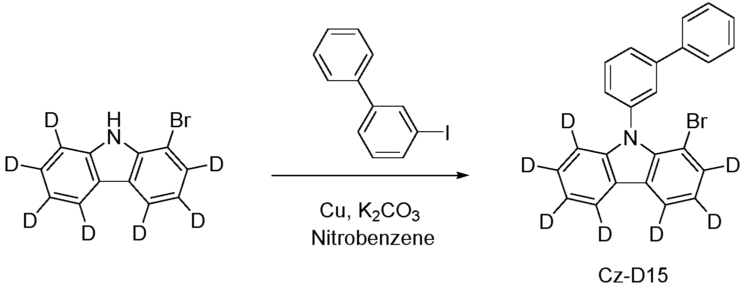

The same procedure as in Preparation Example 4-1, with the exception of using 3-iodo-1,1'-biphenyl (178.3 g, 636.7 mmol) instead of iodobenzene used in Preparation Example 4-1, was conducted to afford the target compound Cz-D15 (111.8 g, yield 52%).
Mass (Calcd.: 405.35, Found: 405 g/mol)

### <PREPARATION EXAMPLE 4-4> Synthesis of Cz-D16

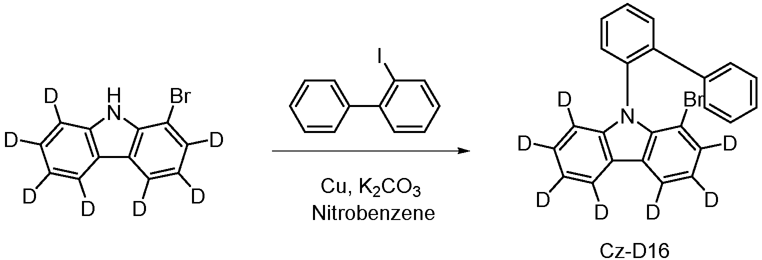

The same procedure as in Preparation Example 4-1, with the exception of using 2-iodo-1,1'-biphenyl (178.3 g, 636.7 mmol) instead of iodobenzene used in Preparation Example 4-1, was conducted to afford the target compound Cz-D16 (68.8 g, yield 32%).
Mass (Calcd.: 405.35, Found: 405 g/mol)

### <PREPARATION EXAMPLE 5-1> Synthesis of_BCz-D1

### <step 1> Synthesis of 9-phenyl-3-(4,4,5,5-tetramethyl-1,3,2-dioxaborolan-2-yl)-9H-carbazole-1,2,4,5,6,7,8-d7

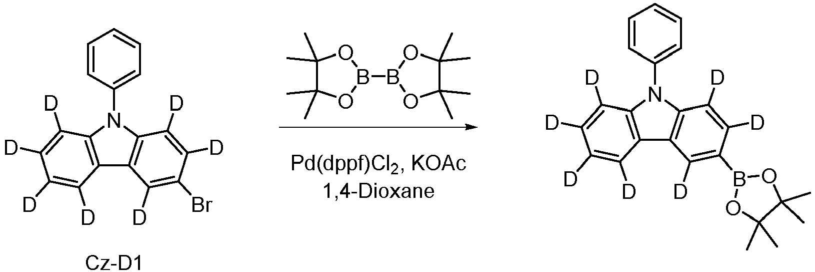

Under a nitrogen atmosphere, a mixture of Cz-D1 (100.0 g, 303.7 mmol), 4,4,4',4',5,5, 5',5'-octamethyl-2,2'-bi(1,3,2-dioxaborolane) (84.8 g, 334.1 mmol), Pd(dppf)Cl₂(26.6 g, 30.3 mmol), KOAc (85.8 g, 911.1 mmol), and 1,4-dioxane (1000 ml) was stirred at 130°C for 12 hours.

After completion of the reaction, the reaction mixture was subjected to extraction with ethyl acetate, and the extract was dried over MgSO₄ and purified by column chromatography (Hexane:EA = 8:1 (v/v)) to afford 9-phenyl-3-(4,4,5,5-tetramethyl-1,3,2-dioxaborolan-2-yl)-9H-carbazole-1,2,4,5,6,7,8-d7 (96.0 g, yield 84%).
Mass (Calcd.: 376.3, Found: 376 g/mol)

### <step 2> Synthesis of BCz-D1

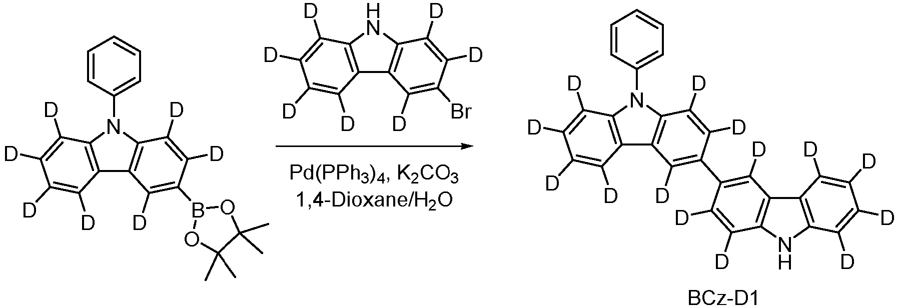

Under a nitrogen atmosphere, a mixture of 9-phenyl-3-(4,4,5,5-tetramethyl-1,3,2-dioxaborolan-2-yl)-9H-carbazole-1,2,4,5,6,7,8-d7 (96.0 g, 255.1 mmol), 3-bromo-9H-carbazole-1,2,4,5,6,7,8-d7 (77.5 g, 306.1 mmol), Pd (PPh₃)₄(14.7 g, 12.7 mmol), K₂CO₃ (88.1 g, 637.8 mmol), 1,4-dioxane/H₂O (1000 ml/250 ml) was stirred at 120°C for 4 hours.

After completion of the reaction, the reaction mixture was subjected to methylene chloride and the extract was added with MgSO₄ and filtered. The organic layer thus obtained was cleared of the solvent and purified by column chromatography (Hexane:EA = 7:1 (v/v)) to afford BCz-D1 (71.1 g, yield 66%).
Mass (Calcd.: 422.59, Found: 422 g/mol)

### <PREPARATION EXAMPLE 5-2> Synthesis of BCz-D2

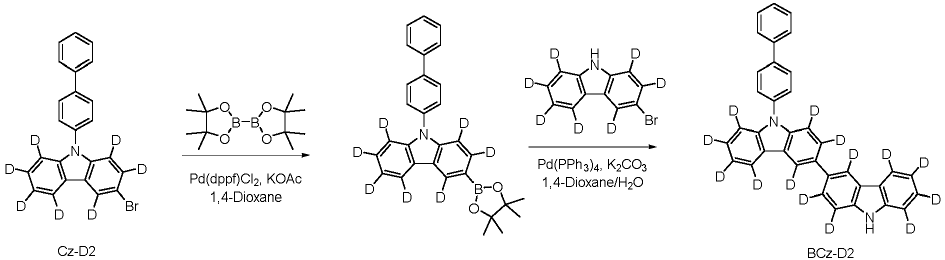

The same procedure as in Preparation Example 5-1, with the exception of using Cz-D2 (100g, 246.7 mmol) instead of Cz-D1 used in Preparation Example 5-1, was conducted to afford the target compound BCz-D2 (66.4 g, final yield 54.0%).
Mass (Calcd.: 498.69, Found: 498 g/mol)

### <PREPARATION EXAMPLE 5-3> Synthesis of BCz-D3

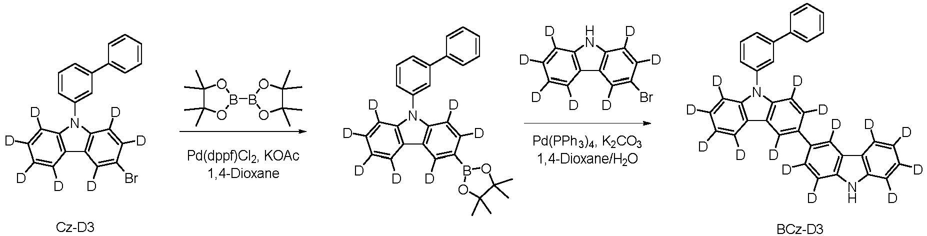

The same procedure as in Preparation Example 5-1, with the exception of using Cz-D3 (100g, 246.7 mmol) instead of Cz-D1 used in Preparation Example 5-1, was conducted to afford the target compound BCz-D3 (59.7 g, final yield 48.5%).
Mass (Calcd.: 498.69, Found: 498 g/mol)

### <PREPARATION EXAMPLE 5-4> Synthesis of BCz-D4

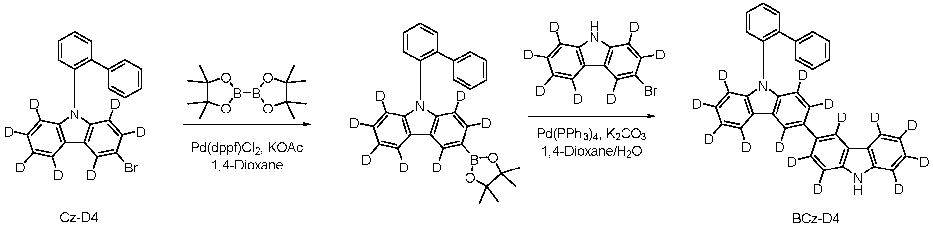

The same procedure as in Preparation Example 5-1, with the exception of using Cz-D4 (100g, 246.7 mmol) instead of Cz-D1 used in Preparation Example 5-1, was conducted to afford the target compound BCz-D4 (59.4 g, final yield 48.3%).
Mass (Calcd.: 498.69, Found: 498 g/mol)

### [SYNTHESIS EXAMPLE 1] Synthesis of A-1

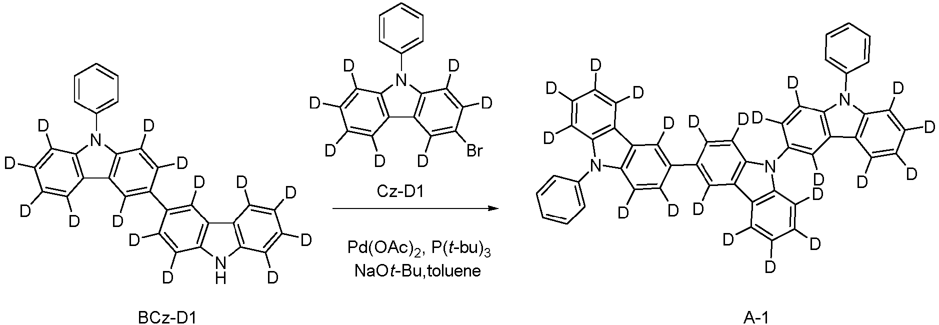

Under a nitrogen atmosphere, a mixture of BCz-D1 (10.0 g, 23.6 mmol) obtained in Preparation Example 5-1, Cz-D1 (9.3 g, 28.3 mmol), Pd(OAc)₂(1.36 g, 1.18 mmol), P(t-Bu)₃(0.57 ml, 2.36 mmol), NaO(t-Bu) (4.55 g, 47.3 mmol), and toluene (100 ml) was stirred at 110°C for 5 hours. After completion of the reaction, the reaction mixture was concentrated by removing toluene, and the solid salt was filtered and purified by recrystallization to afford the target compound A-1 (13.0 g, yield 82%).
Mass (Calcd.: 670.93, Found: 670 g/mol)

### [SYNTHESIS EXAMPLE 2] Synthesis of A-2

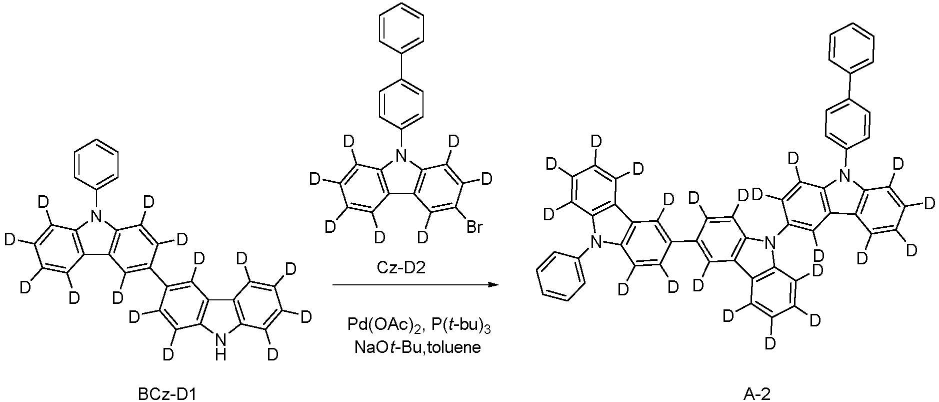

The same procedure as in Synthesis Example 1, with the exception of using Cz-D2 (10.0 g, 23.6 mmol) obtained in preparation example 1-2 instead of Cz-D1 used in Synthesis Example 1, was conducted to afford the target compound A-2 (13.8 g, yield 78%).
Mass (Calcd.: 747.02, Found: 747 g/mol)

### [SYNTHESIS EXAMPLE 3] Synthesis of A-3

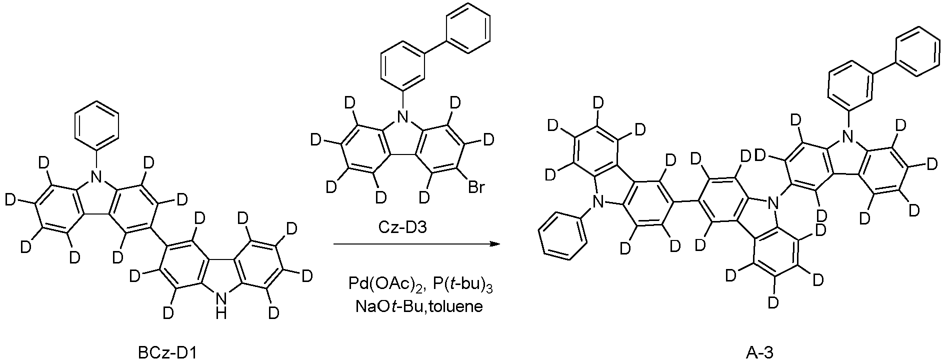

The same procedure as in Synthesis Example 1-1, with the exception of using Cz-D3 (10.0 g, 23.6 mmol) prepared in Preparation Example 1-3 instead of Cz-D1 used in Synthesis Example 1, was conducted to afford the target compound A-3 (13.2 g, yield 75%).
Mass (Calcd.: 747.02, Found: 747 g/mol)

### [SYNTHESIS EXAMPLE 4] Synthesis of A-4

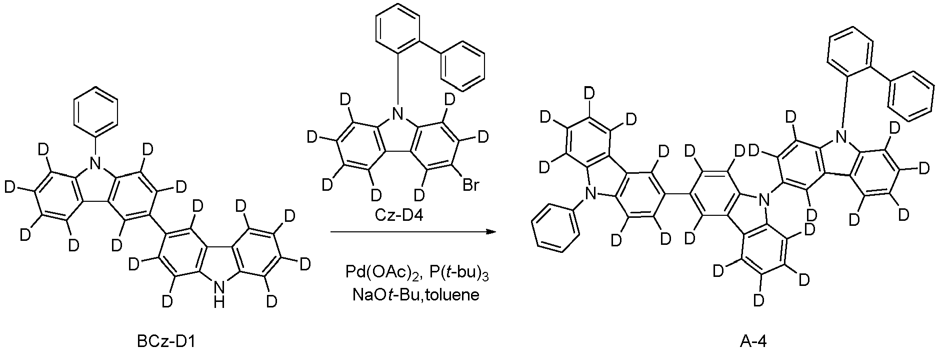

The same procedure as in Synthesis Example 1, with the exception of using Cz-D4 (10.0 g, 23.6 mmol) obtained in preparation example 1-4 instead of Cz-D1 used in Synthesis Example 1, was conducted to afford the target compound A-4 (12.2 g, yield 69%).
Mass (Calcd.: 747.02, Found: 747 g/mol)

### [SYNTHESIS EXAMPLE 5] Synthesis of A-5

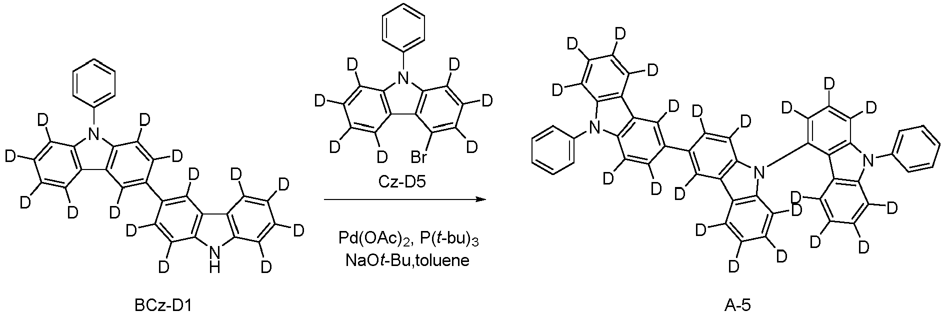

The same procedure as in Synthesis Example 1, with the exception of using Cz-D5 (9.3 g, 23.6 mmol) prepared in Preparation Example 2-1 instead of Cz-D1 used in Synthesis Example 1, was conducted to afford the target compound A-5 (8.73 g, yield 55%).
Mass (Calcd.: 670.93, Found: 670 g/mol)

### [SYNTHESIS EXAMPLE 6] Synthesis of A-6

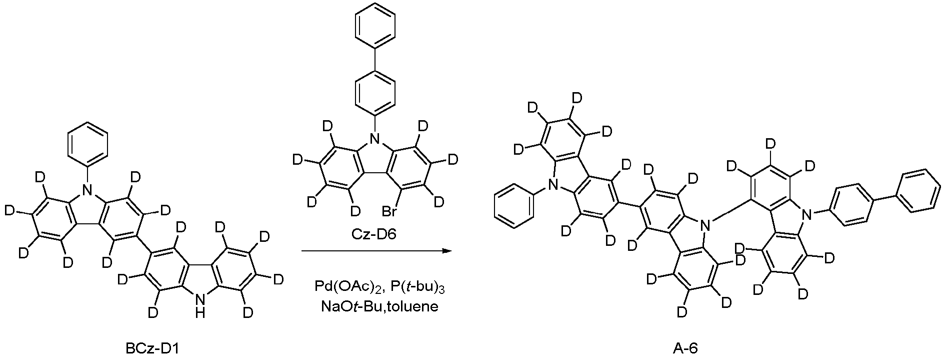

The same procedure as in Synthesis Example 1, with the exception of using Cz-D6 (10.0 g, 23.6 mmol) prepared in Preparation Example 2-2 instead of Cz-D1 used in Synthesis Example 1, was conducted to afford the target compound A-6 (7.42 g, yield 42%).
Mass (Calcd.: 747.02, Found: 747 g/mol)

### [SYNTHESIS EXAMPLE 7] Synthesis of A-7

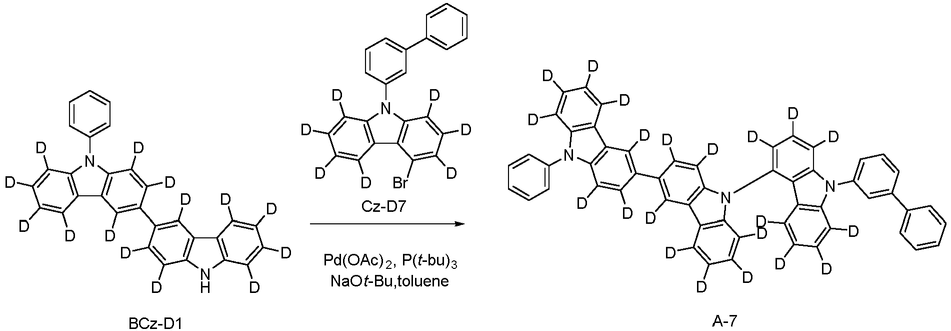

The same procedure as in Synthesis Example 1, with the exception of using Cz-D7 (10.0 g, 23.6 mmol) prepared in Preparation Example 2-3 instead of Cz-D1 used in Synthesis Example 1, was conducted to afford the target compound A-7 (8.83 g, yield 50%).
Mass (Calcd.: 747.02, Found: 747 g/mol)

### [SYNTHESIS EXAMPLE 8] Synthesis of A-8

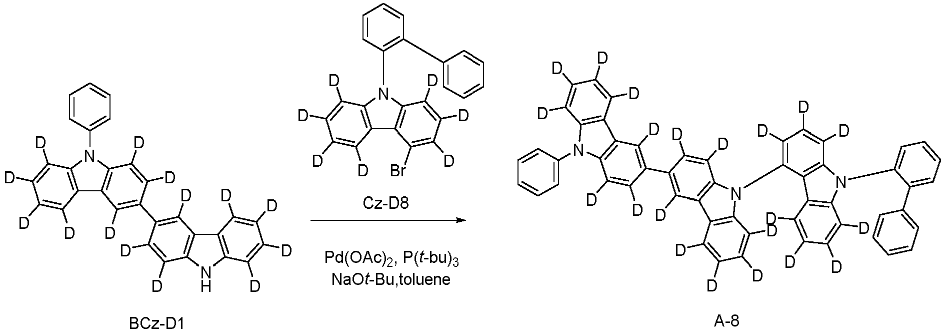

The same procedure as in Synthesis Example 1, with the exception of using Cz-D8 (10.0 g, 23.6 mmol) prepared in Preparation Example 2-4 instead of Cz-D1 used in Synthesis Example 1, was conducted to afford the target compound A-8 (9.89 g, yield 56%).
Mass (Calcd.: 747.02, Found: 747 g/mol)

### [SYNTHESIS EXAMPLE 9] Synthesis of A-9

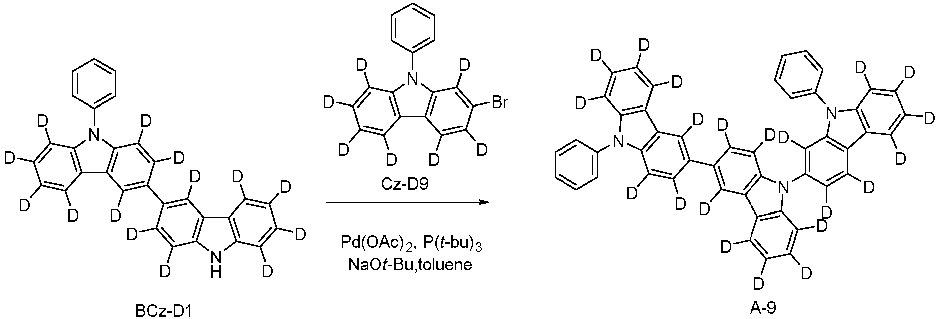

The same procedure as in Synthesis Example 1, with the exception of using Cz-D9 (9.3 g, 23.6 mmol) prepared in Preparation Example 3-1 instead of Cz-D1 used in Synthesis Example 1, was conducted to afford the target compound A-9 (8.41 g, yield 53%).
Mass (Calcd.: 670.93, Found: 670 g/mol)

### [SYNTHESIS EXAMPLE 10] Synthesis of A-10

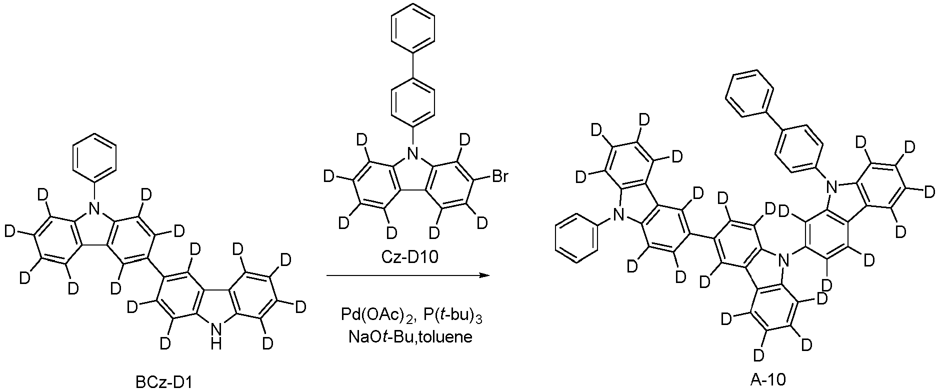

The same procedure as in Synthesis Example 1, with the exception of using Cz-D10 (10.0 g, 23.6 mmol) prepared in Preparation Example 3-2 instead of Cz-D1 used in Synthesis Example 1, was conducted to afford the target compound A-10 (8.66 g, yield 49%).
Mass (Calcd.: 747.02, Found: 747 g/mol)

### [SYNTHESIS EXAMPLE 11] Synthesis of A-11

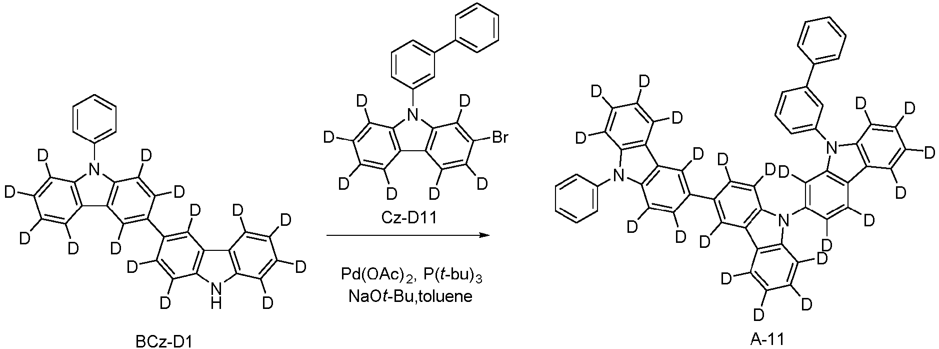

The same procedure as in Synthesis Example 1, with the exception of using Cz-D11 (10.0 g, 23.6 mmol) prepared in Preparation Example 3-3 instead of Cz-D1 used in Synthesis Example 1, was conducted to afford the target compound A-11 (9.01 g, yield 51%).
Mass (Calcd.: 747.02, Found: 747 g/mol)

### [SYNTHESIS EXAMPLE 12] Synthesis of A-12

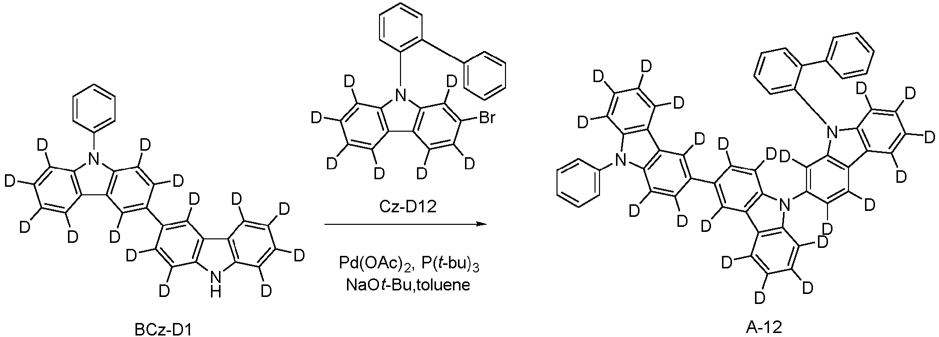

The same procedure as in Synthesis Example 1, with the exception of using Cz-D12 (10.0 g, 23.6 mmol) prepared in Preparation Example 3-4 instead of Cz-D1 used in Synthesis Example 1, was conducted to afford the target compound A-12 (9.19 g, yield 52%).
Mass (Calcd.: 747.02, Found: 747 g/mol)

### [SYNTHESIS EXAMPLE 13] Synthesis of A-13

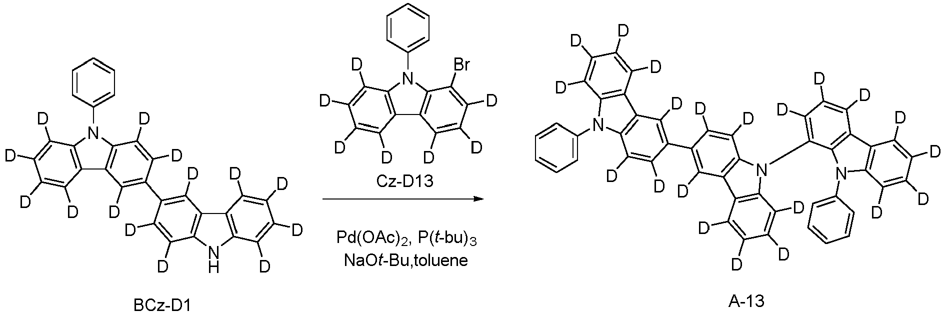

The same procedure as in Synthesis Example 1, with the exception of using Cz-D13 (9.3 g, 23.6 mmol) prepared in Preparation Example 4-1 instead of Cz-D1 used in Synthesis Example 1, was conducted to afford the target compound A-13 (9.52 g, yield 60%).

Mass (Calcd.: 670.93, Found: 670 g/mol)

### [SYNTHESIS EXAMPLE 14] Synthesis of A-14

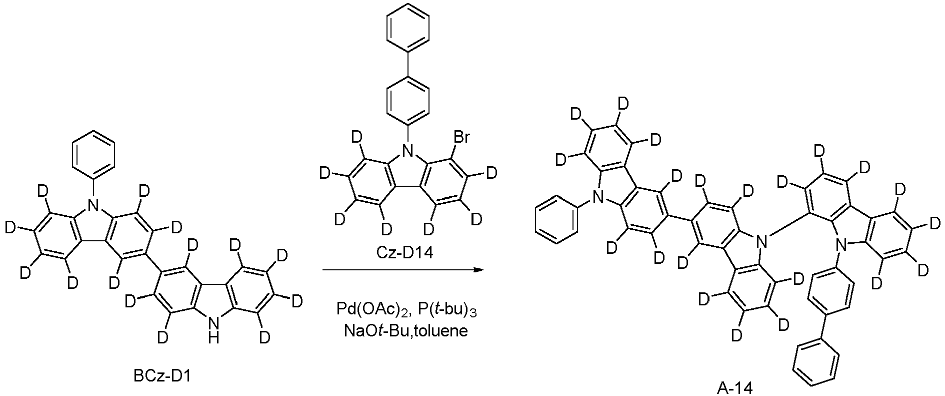

The same procedure as in Synthesis Example 1, with the exception of using Cz-D14 (10.0 g, 23.6 mmol) prepared in Preparation Example 4-2 instead of Cz-D1 used in Synthesis Example 1, was conducted to afford the target compound A-14 (10.78 g, yield 61%).
Mass (Calcd.: 747.02, Found: 747 g/mol)

### [SYNTHESIS EXAMPLE 15] Synthesis of A-15

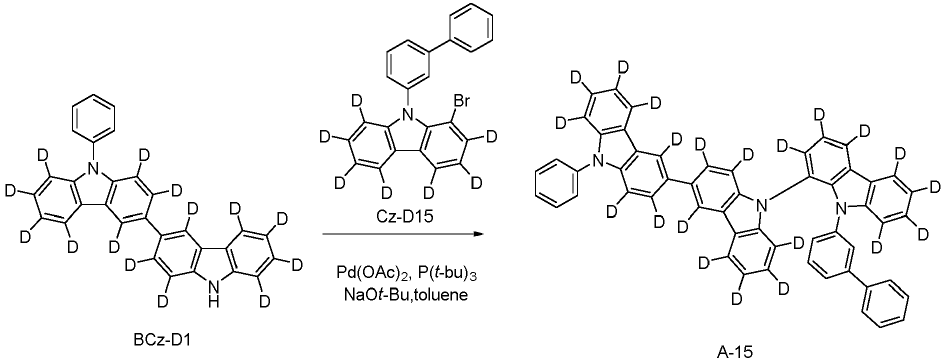

The same procedure as in Synthesis Example 1, with the exception of using Cz-D15 (10.0 g, 23.6 mmol) prepared in Preparation Example 4-3 instead of Cz-D1 used in Synthesis Example 1, was conducted to afford the target compound A-15 (11.13 g, yield 63%).
Mass (Calcd.: 747.02, Found: 747 g/mol)

### [SYNTHESIS EXAMPLE 16] Synthesis of A-16

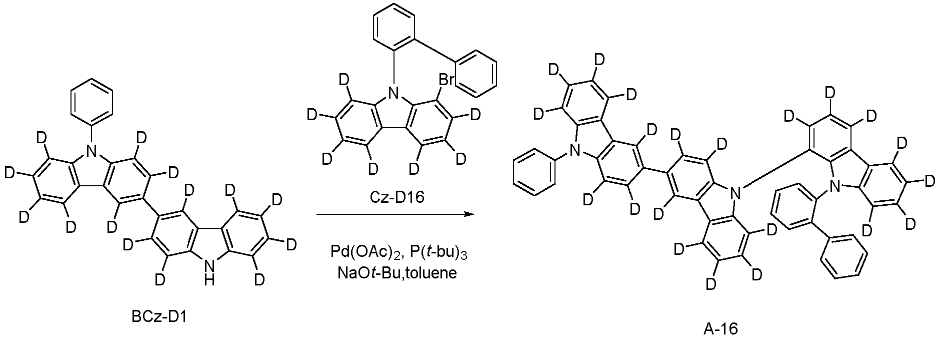

The same procedure as in Synthesis Example 1, with the exception of using Cz-D16 (10.0 g, 23.6 mmol) prepared in Preparation Example 4-4 instead of Cz-D1 used in Synthesis Example 1, was conducted to afford the target compound A-16 (9.02 g, yield 51%).
Mass (Calcd.: 747.02, Found: 747 g/mol)

### [SYNTHESIS EXAMPLE 17] Synthesis of B-1

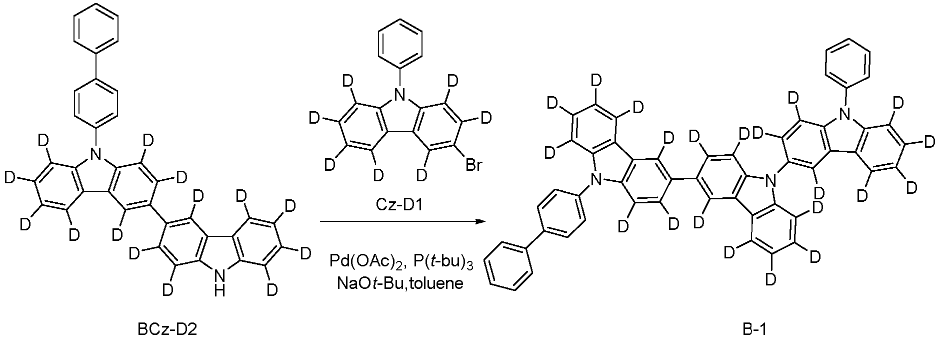

Under a nitrogen atmosphere, a mixture of BCz-D2 (10.0 g, 20.1 mmol) obtained in Preparation Example 5-2, Cz-D1 (7.9 g, 24.1 mmol), Pd(OAc)₂(1.15 g, 1.0 mmol), P(t-Bu)₃(0.49 ml, 2.0 mmol), NaO(t-Bu) (3.85 g, 40.1 mmol), and toluene (100 ml) was stirred at 110°C for 5 hours. After completion of the reaction, the reaction mixture was concentrated by removing toluene, and the solid salt was purified by recrystallization to afford the target compound B-1 (10.2 g, yield 62%).
Mass (Calcd.: 747.02, Found: 747 g/mol)

### [SYNTHESIS EXAMPLE 18] Synthesis of B-2

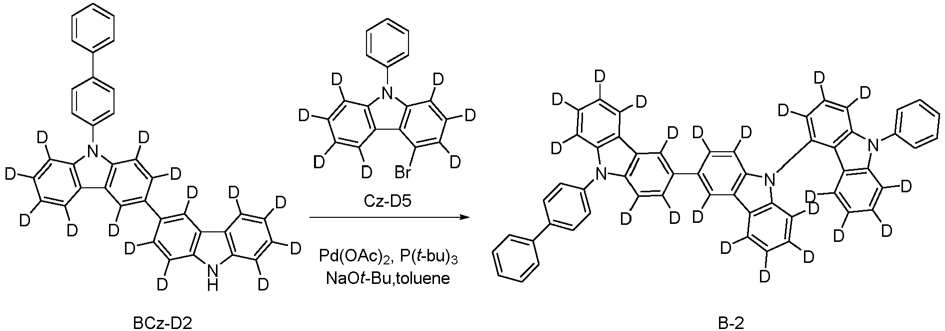

The same procedure as in Synthesis Example 17, with the exception of using Cz-D5 (7.9 g, 24.1 mmol) obtained in Preparation Example 2-1, instead of Cz-D1 used in Synthesis Example 17, was conducted to afford the target compound B-2 (8.5 g, yield 48%).
Mass (Calcd.: 747.02, Found: 747 g/mol)

### [SYNTHESIS EXAMPLE 19] Synthesis of B-3

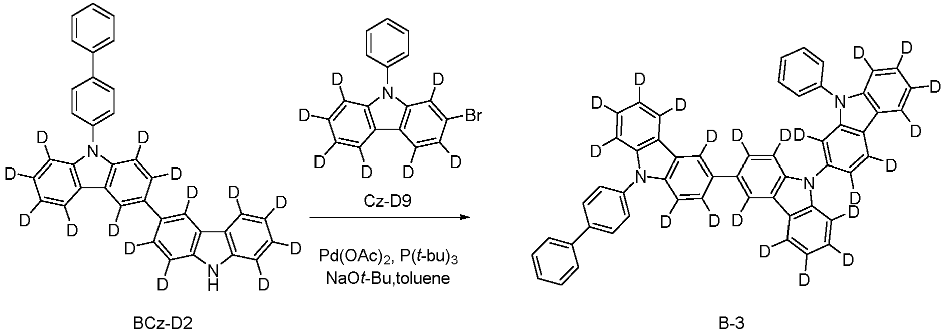

The same procedure as in Synthesis Example 17, with the exception of using Cz-D9 (7.9 g, 24.1 mmol) obtained in Preparation Example 3-1 instead of Cz-D1 used in Synthesis Example 17, was conducted to afford the target compound B-3 (11.1 g, yield 63%).
Mass (Calcd.: 747.02, Found: 747 g/mol)

### [SYNTHESIS EXAMPLE 20] Synthesis of B-4

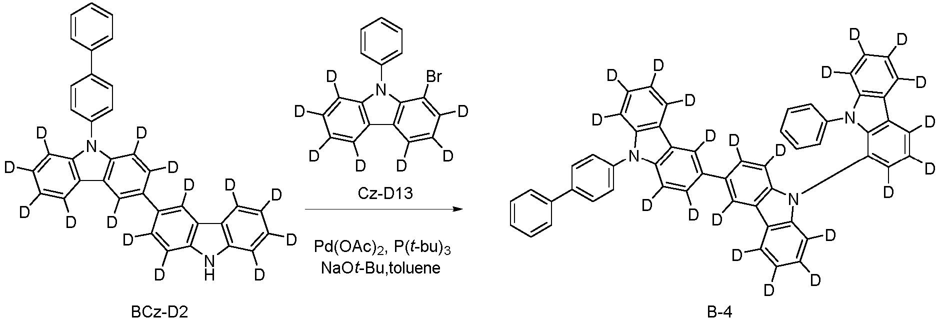

The same procedure as in Preparation Example 17, with the exception of using Cz-D13 (7.9 g, 24.1 mmol) obtained in Preparation Example 4-1 instead of Cz-D1 used in Synthesis Example 17, was conducted to afford the target compound B-4 (7.42 g, yield 42%).
Mass (Calcd.: 747.02, Found: 747 g/mol)

### [SYNTHESIS EXAMPLE 21] Synthesis of C-1

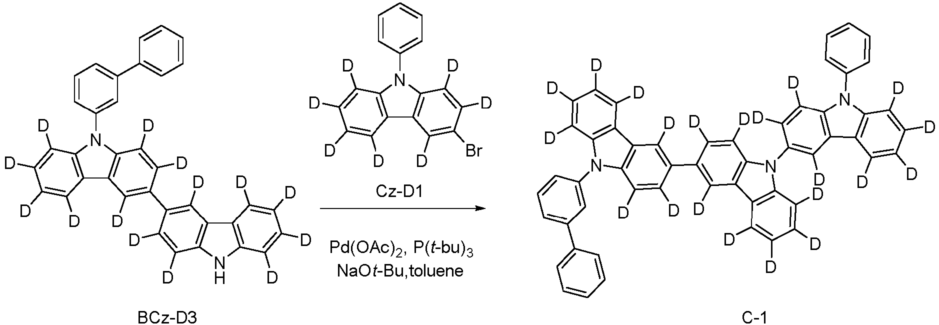

Under a nitrogen atmosphere, a mixture of BCz-D3 (10.0 g, 20.1 mmol) obtained in Preparation Example 5-3, Cz-D1 (7.9 g, 24.1 mmol) obtained in Preparation Example 1-1, Pd(OAc)₂(1.15 g, 1.0 mmol), P(t-Bu)₃(0.49 ml, 2.0 mmol), NaO(*t*-Bu) (3.85 g, 40.1 mmol), and toluene (100 ml) was stirred at 110°C for 5 hours. After completion of the reaction, the reaction mixture was concentrated by removing toluene, and the solid salt was filtered and purified by recrystallization to afford the target compound C-1 (9.4 g, yield 63%)
Mass (Calcd.: 747.02, Found: 747 g/mol)

### [SYNTHESIS EXAMPLE 22] Synthesis of C-2

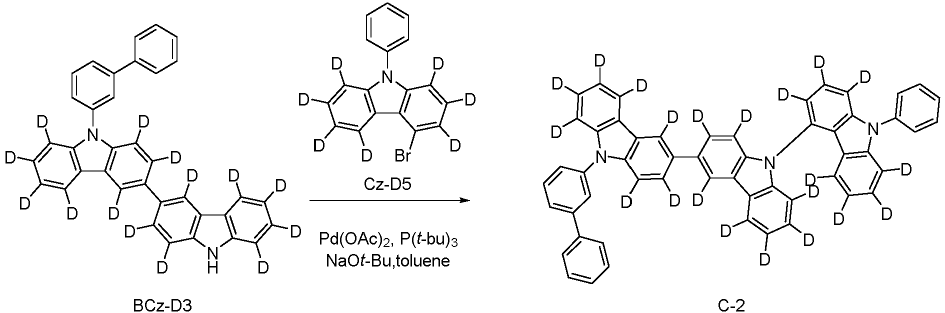

The same procedure as in Synthesis Example 21, with the exception of using Cz-D5 (7.9 g, 24.1 mmol) obtained in Preparation Example 2-1 instead of Cz-D1 used in Synthesis Example 21, was conducted to afford the target compound C-2 (7.78 g, yield 44%).
Mass (Calcd.: 747.02, Found: 747 g/mol)

### [SYNTHESIS EXAMPLE 23] Synthesis of C-3

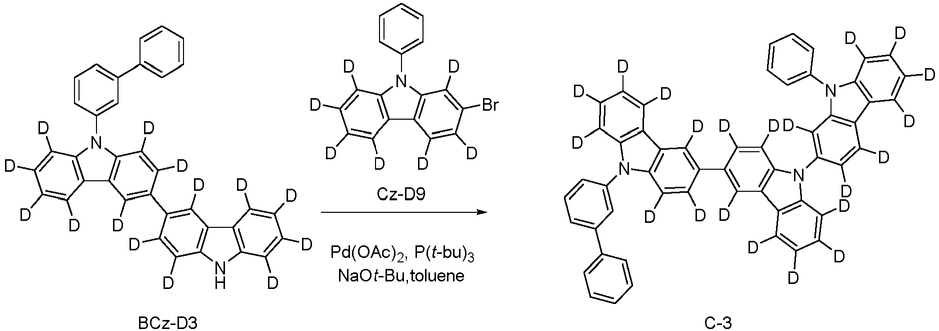

The same procedure as in Synthesis Example 21, with the exception of using Cz-D9 (7.9 g, 24.1 mmol) obtained in Preparation Example 3-1 instead of Cz-D1 used in Synthesis Example 21, was conducted to afford the target compound C-3 (11.67 g, yield 66%).

Mass (Calcd.: 747.02, Found: 747 g/mol)

### [SYNTHESIS EXAMPLE 24] Synthesis of C-4

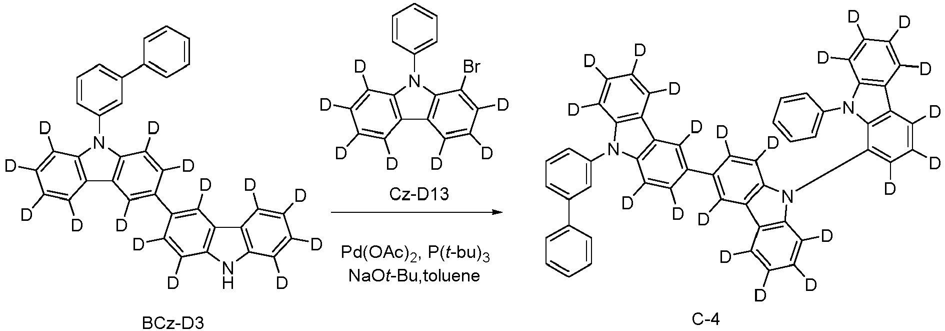

The same procedure as in Synthesis Example 21, with the exception of using Cz-D13 (7.9 g, 24.1 mmol) obtained in Preparation Example 4-1 instead of Cz-D1 used in Synthesis Example 21, was conducted to afford the target compound C-4 (6.89 g, yield 39%).
Mass (Calcd.: 747.02, Found: 747 g/mol)

### [SYNTHESIS EXAMPLE 25] Synthesis of D-1

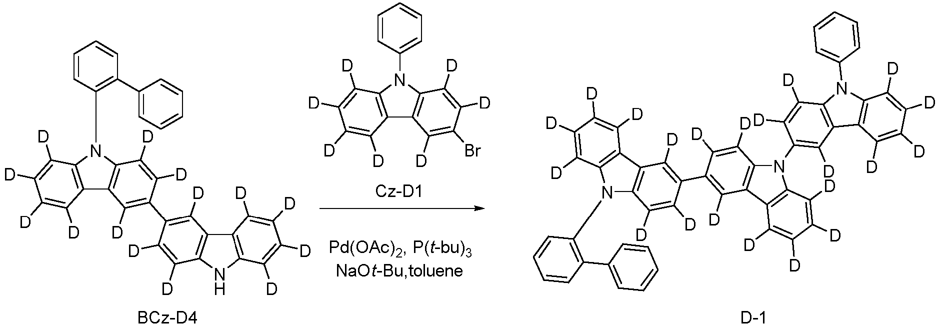

Under a nitrogen atmosphere, a mixture of BCz-D4 (10.0 g, 20.1 mmol) obtained in Preparation Example 5-4, Cz-D1 (7.9 g, 24.1 mmol) obtained in Preparation Example 1-1, Pd(OAc)₂(1.15 g, 1.0 mmol), P(t-Bu)₃(0.49 ml, 2.0 mmol), NaO(*t-*Bu) (3.85 g, 40.1 mmol), and toluene (100 ml) was stirred at 110°C for 5 hours. After completion of the reaction, the reaction mixture was concentrated by removing toluene, and the solid salt was filtered and purified by recrystallization to afford the target compound D-1 (8.1 g, yield 54%).
Mass (Calcd.: 747.02, Found: 747 g/mol)

### [SYNTHESIS EXAMPLE 26] Synthesis of D-2

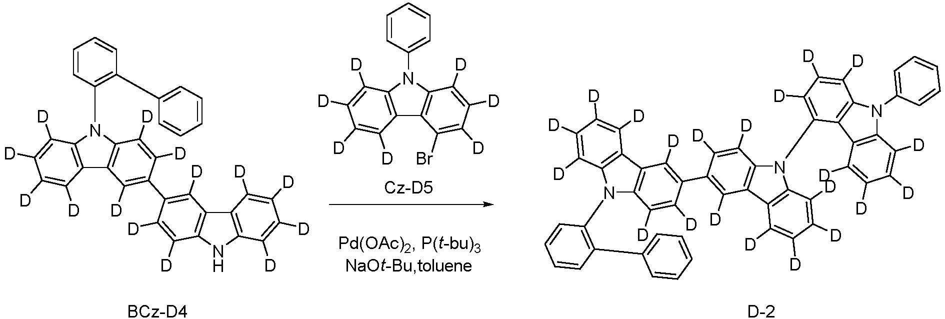

The same procedure as in Synthesis Example 25, with the exception of using Cz-D5 (7.9 g, 24.1 mmol) obtained in Preparation Example 2-1 instead of Cz-D1 used in Synthesis Example 25, was conducted to afford the target compound D-2 (7.24 g, yield 41%).
Mass (Calcd.: 747.02, Found: 747 g/mol)

### [SYNTHESIS EXAMPLE 27] Synthesis of D-3

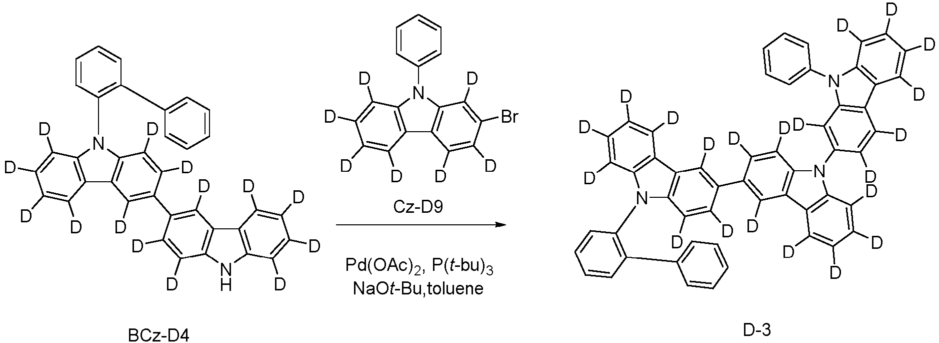

The same procedure as in Synthesis Example 25, with the exception of using Cz-D9 (7.9 g, 24.1 mmol) obtained in Preparation Example 3-1 instead of Cz-D1 used in Synthesis Example 25, was conducted to afford the target compound D-3 (8.41 g, yield 51%).
Mass (Calcd.: 747.02, Found: 747 g/mol)

### [SYNTHESIS EXAMPLE 28] Synthesis of D-4

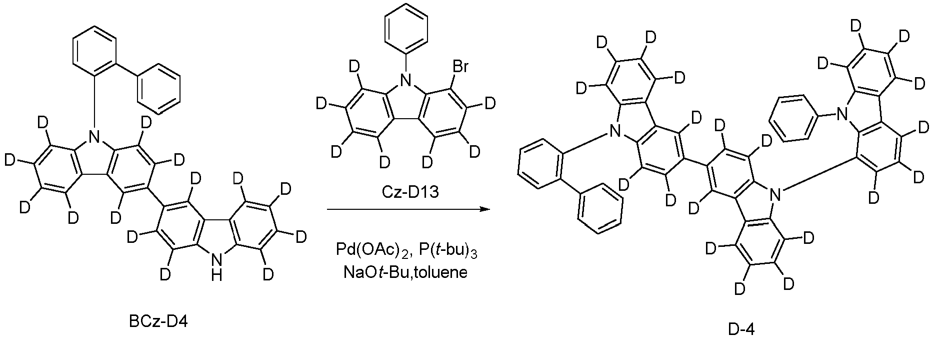

The same procedure as in Synthesis Example 25, with the exception of using Cz-D13 (7.9 g, 24.1 mmol) obtained in Preparation Example 4-1 instead of Cz-D1 used in Synthesis Example 25, was conducted to afford the target compound D-4 (5.47 g, yield 31%).
Mass (Calcd.: 747.02, Found: 747 g/mol)

### [PREPARATION EXAMPLE 6] Synthesis of DBF-1

### <Step 1> Synthesis of 4-(3-chlorophenyl)-6-phenyldibenzo[b,d]furan

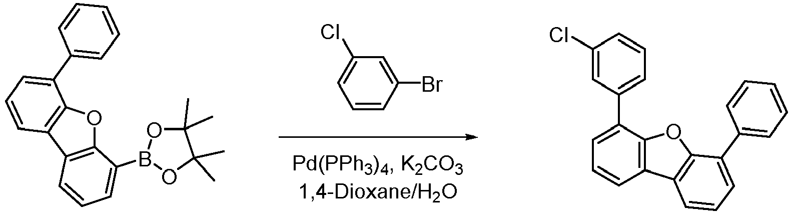

Under a nitrogen atmosphere, 4,4,5,5-tetramethyl-2-(6-phenyldibenzo[b,d]furan-4-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 4-(3-chlorophenyl)-6-phenyldibenzo[b,d]furan (48.9 g, yield 51%).
Mass (Calcd.: 354.83, Found: 354 g/mol)

### <step 2> Synthesis of DBF-1

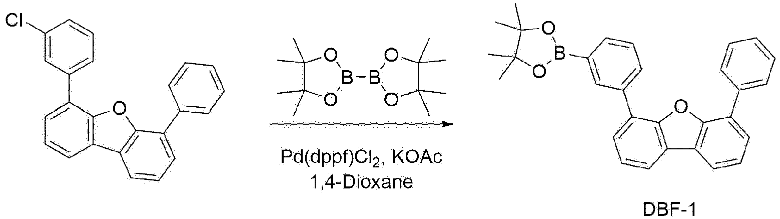

Under a nitrogen atmosphere, 4-(3-chlorophenyl)-6-phenyldibenzo[b,d]furan (48.9 g, 137.7 mmol) obtained in <step 1>, 4,4,4',4',5,5, 5',5'-octamethyl-2,2'-bi(1,3,2-dioxaborolane) (38.5 g, 151.5 mmol), Pd(dppf)Cl₂ (12.1 g, 13.8 mmol), KOAc (38.9 g, 413.2 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:DCM = 4:1 (v/v)) to afford DBF-1 (26.4 g, yield 43%).
Mass (Calcd.: 446.35, Found: 446 g/mol)

### [PREPARATION EXAMPLE 7] Synthesis of DBF-2

### <step 1> Synthesis of 4-(4-chlorophenyl)-6-phenyldibenzo[b,d]furan

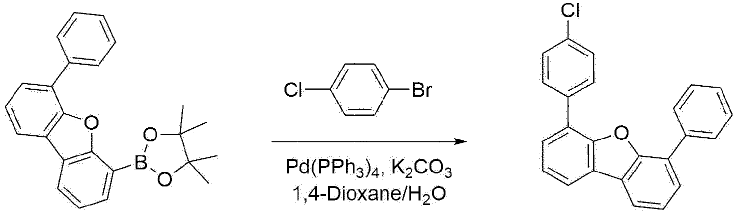

Under a nitrogen atmosphere, 4,4,5,5-tetramethyl-2-(6-phenyldibenzo[b,d]furan-4-yl)-1,3,2-dioxaborolane (100.0 g, 270.0 mmol), 1-bromo-4-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 4-(4-chlorophenyl)-6-phenyldibenzo[b,d]furan (60.4 g, yield 63%).
Mass (Calcd.: 354.83, Found: 354 g/mol)

### <step 2> Synthesis of DBF-2

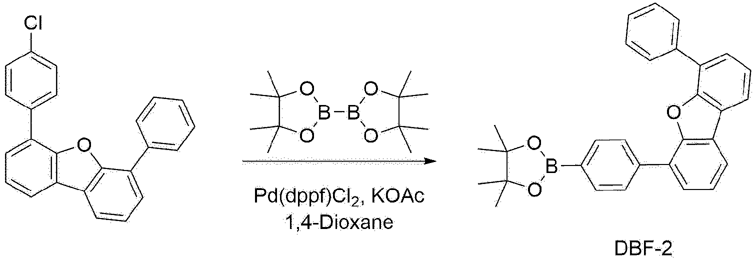

Under a nitrogen atmosphere, 4-(4-chlorophenyl)-6-phenyldibenzo[b,d]furan (60.4 g, 170.2 mmol) obtained in <step 1> , 4,4,4',4',5,5, 5',5'-octamethyl-2,2'-bi(1,3,2-dioxaborolane) (47.5 g, 187.2 mmol), Pd(dppf)Cl₂ (14.9 g, 17.0 mmol), KOAc (48.1 g, 510.4 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄, followed by purification by column chromatography (Hexane:DCM = 4:1 (v/v)) to afford DBF-2 (36.5 g, yield 48%).
Mass (Calcd.: 446.35, Found: 446 g/mol)

### [PREPARATION EXAMPLE 8] Synthesis of DBF-3

### <step 1> Synthesis of 3-(3-chlorophenyl)-6-phenyldibenzo[b,d]furan

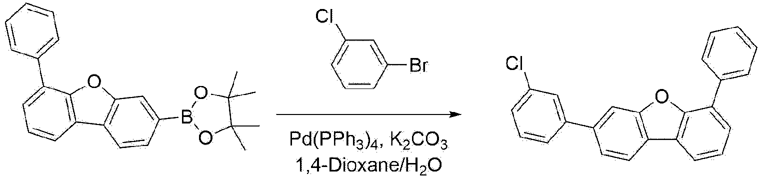

Under a nitrogen atmosphere, 4,4,5,5-tetramethyl-2-(6-phenyldibenzo[b,d]furan-3-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 3-(3-chlorophenyl)-6-phenyldibenzo[b,d]furan (68.0 g, yield 71%).
Mass (Calcd.: 354.83, Found: 354 g/mol)

### <step 2> Synthesis of DBF-3

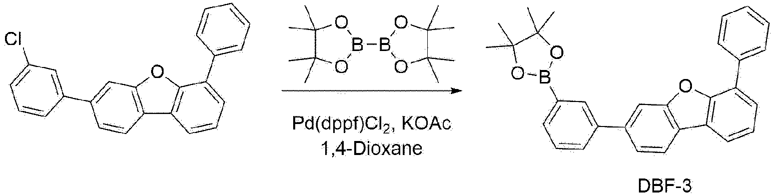

Under a nitrogen atmosphere, 3-(3-chlorophenyl)-6-phenyldibenzo[b,d]furan (68.0 g, 191.8 mmol) obtained in <step 1>, 4,4,4',4',5,5, 5',5'-octamethyl-2,2'-bi(1,3,2-dioxaborolane) (53.6 g, 210.9 mmol), Pd(dppf)Cl₂ (16.8 g, 19.2 mmol), KOAc (54.2 g, 575.3 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:DCM = 4:1 (v/v)) to afford DBF-3 (54.8 g, yield 64%).
Mass (Calcd.: 446.35, Found: 446 g/mol)

### [PREPARATION EXAMPLE 9] Synthesis of DBF-4

### <step 1> Synthesis of 1-(3-chlorophenyl)-6-phenyldibenzo[b,d]furan

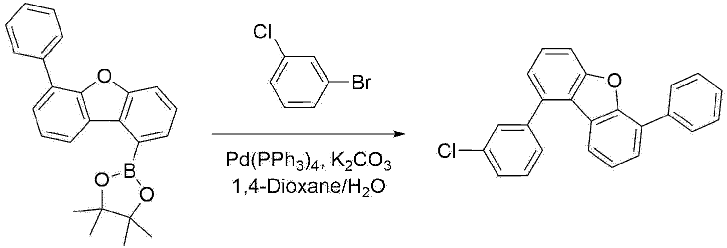

Under a nitrogen atmosphere, 4,4,5,5-tetramethyl-2-(6-phenyldibenzo[b,d]furan-1-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 1-(3-chlorophenyl)-6-phenyldibenzo[b,d]furan (62.3 g, yield 65%) .
Mass (Calcd.: 354.83, Found: 354 g/mol)

### <step 2> Synthesis of DBF-4

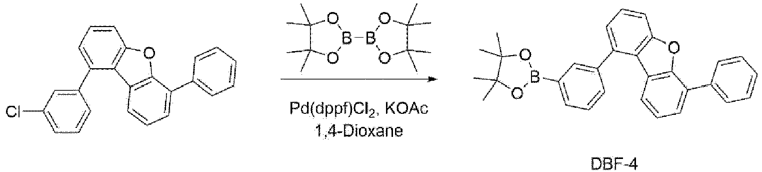

Under a nitrogen atmosphere, 1-(3-chlorophenyl)-6-phenyldibenzo[b,d]furan (62.3 g, 175.6 mmol) obtained in <step 1>, 4,4,4',4',5,5, 5',5'-octamethyl-2,2'-bi(1,3,2-dioxaborolane) (49.0 g, 193.1 mmol), Pd(dppf)Cl₂ (15.4 g, 17.6 mmol), KOAc (49.6 g, 526.7 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:DCM = 4:1 (v/v)) afforded DBF-4 (45.4 g, yield 58%).
Mass (Calcd.: 446.35, Found: 446 g/mol)

### [PREPARATION EXAMPLE 10] Synthesis of DBF-5

### <Step 1> Synthesis of 1-(3-chlorophenyl)-9-phenyldibenzo[b,d]furan

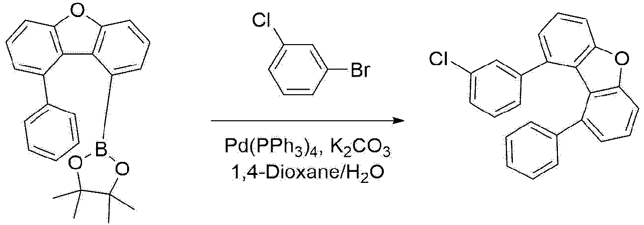

Under a nitrogen atmosphere, 4,4,5,5-tetramethyl-2-(9-phenyldibenzo[b,d]furan-1-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 1-(3-chlorophenyl)-9-phenyldibenzo[b,d]furan (68.0 g, yield 71%).
Mass (Calcd.: 354.83, Found: 354 g/mol)

### <Step 2> Synthesis of DBF-5

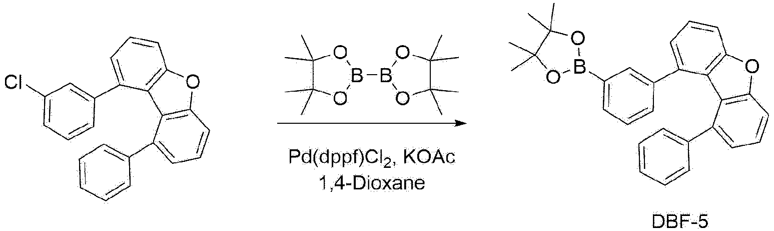

Under a nitrogen atmosphere, 1-(3-chlorophenyl)-9-phenyldibenzo[b,d]furan (68.0 g, 191.8 mmol) obtained in <step 1>, 4,4,4',4',5,5, 5',5'-octamethyl-2,2'-bi(1,3,2-dioxaborolane) (53.6 g, 210.9 mmol), Pd(dppf)Cl₂ (16.8 g, 19.2 mmol), KOAc (54.2 g, 575.3 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:DCM = 4:1 (v/v)) afforded DBF-5 (41.9 g, yield 49%).
Mass (Calcd.: 446.35, Found: 446 g/mol)

### [SYNTHESIS EXAMPLE 29] Synthesis of E-1

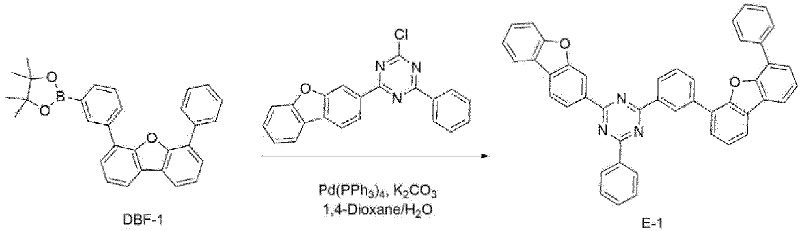

Under a nitrogen atmosphere, DBF-1 (10.0 g, 22.4 mmol) obtained in Preparation Example 6, 2-chloro-4-(dibenzo[b,d]furan-3-yl)-6-phenyl-1,3,5-triazine (9.6 g, 26.9 mmol), Pd(PPh₃)₄ (1.3 g, 1.1 mmol), K₂CO₃ (7.7 g, 56.0 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:EA = 4:1 (v/v)) to afford the target compound E-1 (11.8 g, yield 82%).
Mass (Calcd.: 641.73, Found: 641 g/mol)

### [SYNTHESIS EXAMPLE 30] Synthesis of E-2

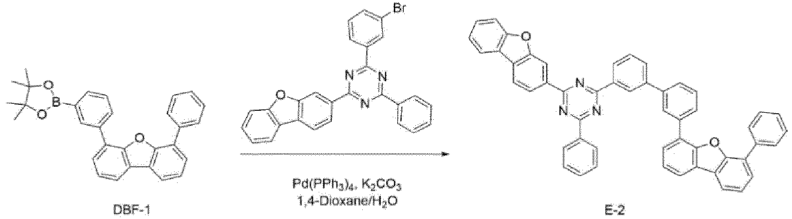

The same procedure as in Synthesis Example 29, with the exception of using 2-(3-bromophenyl)-4-(dibenzo[b,d]furan-3-yl)-6-phenyl-1,3,5-triazine (12.9 g, 26.9 mmol) instead of 2-chloro-4-(dibenzo[b,d]furan-3-yl)-6-phenyl-1,3,5-triazine used in Synthesis Example 29, was conducted to afford the target compound E-2 (11.9 g, yield 74%).
Mass (Calcd.: 717.83, Found: 717 g/mol)

### [SYNTHESIS EXAMPLE 31] Synthesis of E-3

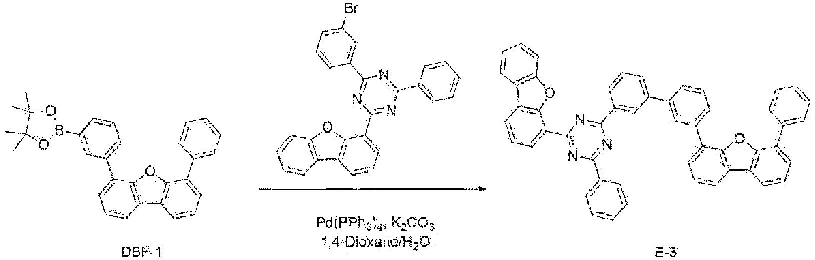

The same procedure as in Synthesis Example 29, with the exception of using 2-(3-bromophenyl)-4-(dibenzo[b,d]furan-4-yl)-6-phenyl-1,3,5-triazine (12.9 g, 26.9 mmol) instead of 2-chloro-4-(dibenzo[b,d]furan-3-yl)-6-phenyl-1,3,5-triazine used in Synthesis Example 29, was conducted to afford the target compound E-3 (11.4 g, yield 71%).
Mass (Calcd.: 717.83, Found: 717 g/mol)

### [SYNTHESIS EXAMPLE 32] Synthesis of E-4

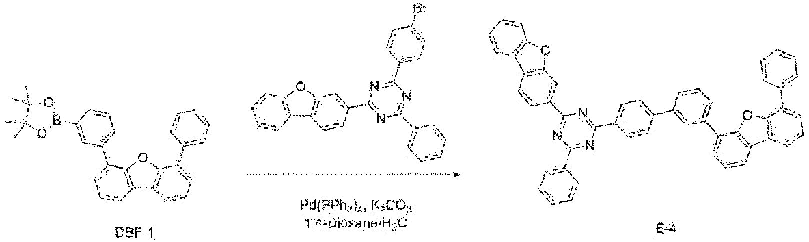

The same procedure as in Synthesis Example 29, with the exception of using 2-(4-bromophenyl)-4-(dibenzo[b,d]furan-3-yl)-6-phenyl-1,3,5-triazine (12.9 g, 26.9 mmol) instead of 2-chloro-4-(dibenzo[b,d]furan-3-yl)-6-phenyl-1,3,5-triazine used in Synthesis Example 29, was conducted to afford the target compound E-4 (12.7 g, yield 79%).
Mass (Calcd.: 717.83, Found: 717 g/mol)

### [SYNTHESIS EXAMPLE 33] Synthesis of E-5

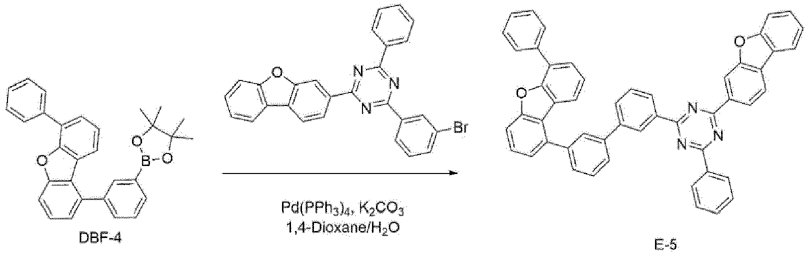

The same procedure as in Synthesis Example 29, with the exception of using DBF-4 (10.0 g, 22.4 mmol) obtained in Preparation Example 9 and 2-(3-bromophenyl)-4-(dibenzo[b,d]furan-3-yl)-6-phenyl-1,3,5-triazine (12.9 g, 26.9 mmol) instead of DBF-1 (10.0 g, 22.4 mmol) and 2-chloro-4-(dibenzo[b,d]furan-3-yl)-6-phenyl-1,3,5-triazine used in Synthesis Example 29, respectively, was conducted to afford the target compound E-5 (9.8 g, yield 61%).
Mass (Calcd.: 717.83, Found: 717 g/mol)

### [SYNTHESIS EXAMPLE 34] Synthesis of E-6

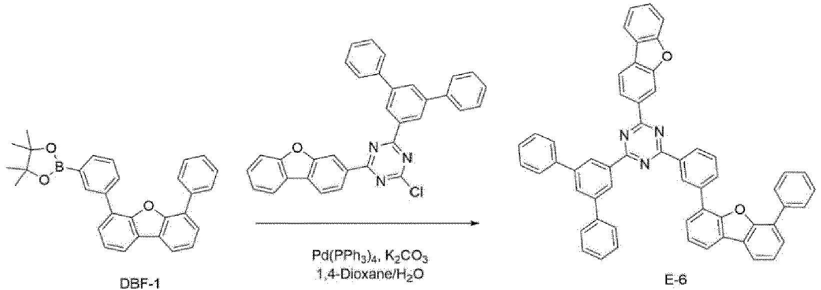

The same procedure as in Synthesis Example 29, with the exception of using 2-([1,1':3',1''-terphenyl]-5'-yl)-4-chloro-6-(dibenzo[b,d]furan-3-yl)-1,3,5-triazine (13.7 g, 26.9 mmol) instead of 2-chloro-4-(dibenzo[b,d]furan-3-yl)-6-phenyl-1,3,5-triazine used in Synthesis Example 29, was conducted to afford the target compound E-6 (9.6 g, yield 54%).
Mass (Calcd.: 793.93, Found: 793 g/mol)

### [SYNTHESIS EXAMPLE 35] Synthesis of E-7

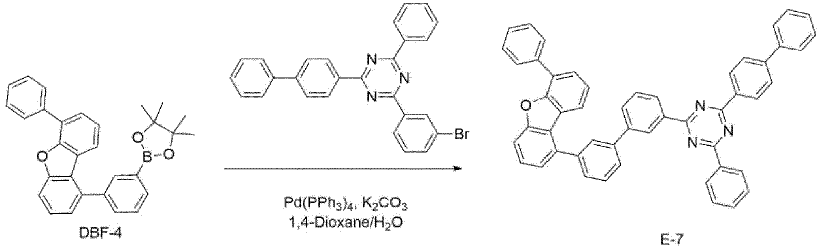

The same procedure as in Synthesis Example 29, with the exception of using DBF-4 (10.0 g, 22.4 mmol) obtained in Preparation Example 9 and 2-([1,1'-biphenyl]-4-yl)-4-(3-bromophenyl)-6-phenyl-1,3,5-triazine (12.5 g, 26.9 mmol) instead of DBF-1 (10.0 g, 22.4 mmol) and 2-chloro-4-(dibenzo[b,d]furan-3-yl)-6-phenyl-1,3,5-triazine used in Synthesis Example 29, respectively, was conducted to afford the target compound E-7 (9.8 g, yield 62%).
Mass (Calcd.: 703.85, Found: 703 g/mol)

### [SYNTHESIS EXAMPLE 36] Synthesis of E-8

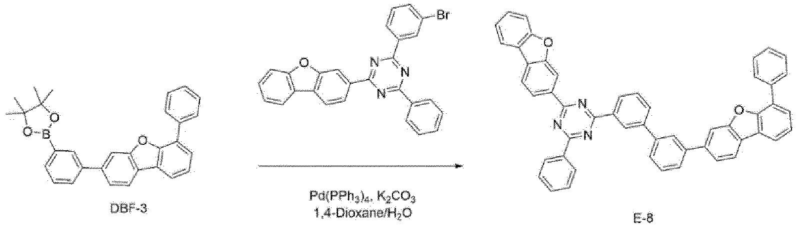

The same procedure as in Synthesis Example 29, with the exception of using DBF-3 (10.0 g, 22.4 mmol) obtained in Preparation Example 8 and 2-(3-bromophenyl)-4-(dibenzo[b,d]furan-3-yl)-6-phenyl-1,3,5-triazine (12.9 g, 26.9 mmol) instead of DBF-1 (10.0 g, 22.4 mmol) and 2-chloro-4-(dibenzo[b,d]furan-3-yl)-6-phenyl-1,3,5-triazine used in Synthesis Example 29, was conducted to afford the target compound E-8 (10.8 g, yield 67%).
Mass (Calcd.: 717.83, Found: 717 g/mol)

### [SYNTHESIS EXAMPLE 37] Synthesis of E-9

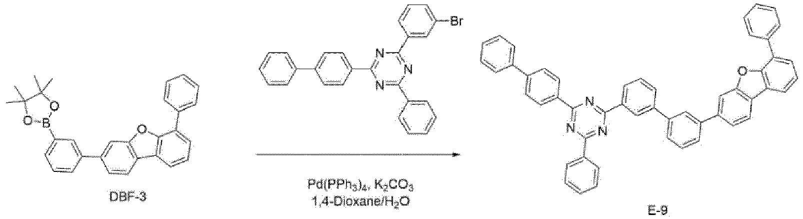

The same procedure as in Synthesis Example 29, with the exception of using DBF-3 (10.0 g, 22.4 mmol) obtained in Preparation Example 8 and 2-([1,1'-biphenyl]-4-yl)-4-(3-bromophenyl)-6-phenyl-1,3,5-triazine (12.5 g, 26.9 mmol) instead of DBF-1 (10.0 g, 22.4 mmol) and 2-chloro-4-(dibenzo[b,d]furan-3-yl)-6-henyl-1,3,5-triazine used in Synthesis Example 29, respectively, was conducted to afford the target compound E-9 (11.4 g, yield 72%).
Mass (Calcd.: 703.85, Found: 703 g/mol)

### [SYNTHESIS EXAMPLE 38] Synthesis of E-10

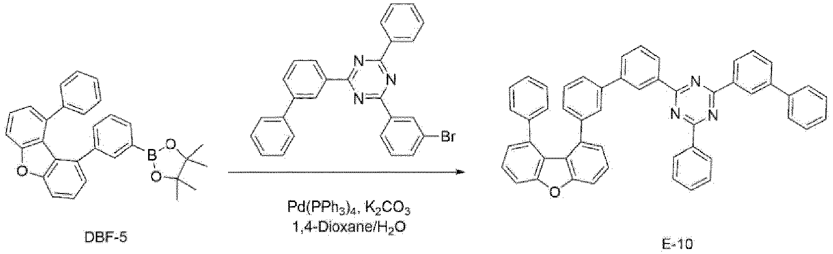

The same procedure as in Synthesis Example 29, with the exception of using DBF-5 (10.0 g, 22.4 mmol) obtained in Preparation Example 10 and 2-([1,1'-biphenyl]-3-yl)-4-(3-bromophenyl)-6-phenyl-1,3,5-triazine (12.5 g, 26.9 mmol) instead of DBF-1 (10.0 g, 22.4 mmol) and 2-chloro-4-(dibenzo[b,d]furan-3-yl)-6-phenyl-1,3,5-triazine used in Synthesis Example 29, respectively, was conducted to afford the target compound E-10 (10.4 g, yield 66%).
Mass (Calcd.: 703.85, Found: 703 g/mol)

### [EXAMPLE 1] Fabrication of Green Organic EL Device

Compound A-1 with hole properties and compound E-1 with electron properties were homogeneously mixed at a weight ratio of 60 : 40 and then fully dissolved in tetrahydrofuran (THF) and stirred for one day. After the stirring was completed, the solvent was removed from the mixture by spray drying to obtain a homogeneous organic complex HOC-1 which was used for the fabrication of a green organic EL device according to the following procedure. In this regard, compound A-1 was a first organic compound with hole properties, synthesized in Synthesis Example 1 while compound E-1 was a second organic compound with electron properties, synthesized in Synthesis Example 29. In addition, the aforementioned weight ratio was given as an example to exhibit excellent performance, but the weight ratio is not limited thereto.

First, a glass substrate with an indium tin oxide (ITO) thin film coating of 1500 Å thickness was cleansed by ultrasonication with distilled water. After cleansing with distilled water, ultrasonic cleansing was performed with solvents such as isopropyl alcohol, acetone, and methanol. The substrate was dried and then transferred to a UV ozone cleaner (Power Sonic 405, Hwashin Tech), where the substrate was cleaned with UV for 5 minutes before being transferred to a vacuum deposition machine.

On the prepared ITO transparent electrode, organic electroluminescent elements were fabricated by sequentially depositing m-MTDATA (60 nm)/TCTA (80 nm) homogeneous organic complex HOC-1 + 10 % Ir(ppy)₃(300nm)/BCP (10 nm)/Alq₃(30 nm)/LiF (1 nm)/Al (200 nm) .

The structures of m-MTDATA, TCTA, Ir (ppy)₃, CBP, and BCP are as follows:

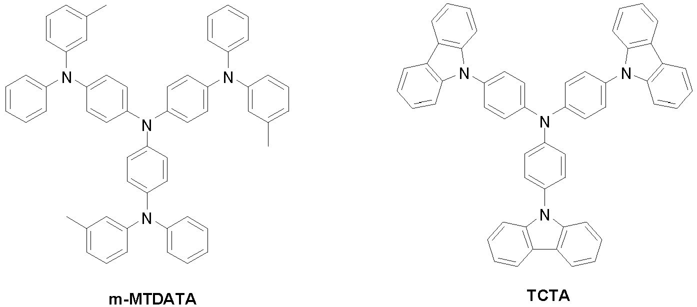

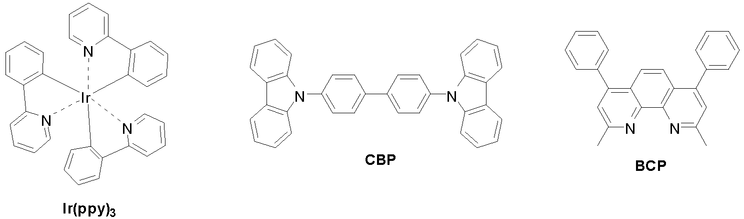

### [EXAMPLES 2-280] Fabrication of Green Organic EL Devices

Green organic EL devices were fabricated in the same manner as in Example 1, with the exception of using the homogeneous organic complexes HOC-2 to HOC-280, instead of HOC-1, as emission host materials used for the formation of emission layers.

### [COMPARATIVE EXAMPLE 1] Fabrication of Green Organic EL Device

A green organic EL device was fabricated in the same manner as in Example 1, with the exception of using comA, prepared by simply grinding and mixing compound A-1 and compound E-1 with a grinder, instead of the homogenous organic complex HOC-1, as an emission host material used for the formation of an emission layer.

### [EVALUATION EXAMPLE 1: Spectroscopic Properties]

The homogeneous organic complexes HOC-1 to HOC-280 prepared in Examples 1 to 280 were measured for maximum emission wavelength, and the results are summarized in Table 1. In this regard, the maximum emission wavelength of compounds A-1 - D-4 and compounds E-1 - E-10, which were individual components, were also measured. As a control, the simple mixture comA of Comparative Example 1 was measured for maximum emission wavelength.

**TABLE 1**

| | Sample | Max. Emission Wavelength (λₘₐₓ, nm) | Sample | Max. Emission Wavelength (λₘₐₓ, nm) | Sample | Max. Emission Wavelength (λₘₐₓ, nm) |
|---|---|---|---|---|---|---|
| Ex. 1 | A-1 | 380 | E-1 | 416 | Homo. organic complex HOC-1 | 500 |
| Ex. 2 | A-1 | 380 | E-2 | 415 | HOC-2 | 498 |
| Ex. 3 | A-1 | 380 | E-3 | 415 | HOC-3 | 499 |
| Ex. 4 | A-1 | 380 | E-4 | 417 | HOC-4 | 501 |
| Ex. 5 | A-1 | 380 | E-5 | 415 | HOC-5 | 502 |
| Ex. 6 | A-1 | 380 | E-6 | 415 | HOC-6 | 505 |
| Ex. 7 | A-1 | 380 | E-7 | 418 | HOC-7 | 499 |
| Ex. 8 | A-1 | 380 | E-8 | 412 | HOC-8 | 489 |
| Ex. 9 | A-1 | 380 | E-9 | 419 | HOC-9 | 511 |
| Ex. 10 | A-1 | 380 | E-10 | 414 | HOC-10 | 510 |
| Ex. 11 | A-2 | 378 | E-1 | 416 | HOC-11 | 504 |
| Ex. 12 | A-2 | 378 | E-2 | 415 | HOC-12 | 503 |
| Ex. 13 | A-2 | 378 | E-3 | 415 | HOC-13 | 504 |
| Ex. 14 | A-2 | 378 | E-4 | 417 | HOC-14 | 504 |
| Ex. 15 | A-2 | 378 | E-5 | 415 | HOC-15 | 499 |
| Ex. 16 | A-2 | 378 | E-6 | 415 | HOC-16 | 498 |
| Ex. 17 | A-2 | 378 | E-7 | 418 | HOC-17 | 501 |
| Ex. 18 | A-2 | 378 | E-8 | 412 | HOC-18 | 501 |
| Ex. 19 | A-2 | 378 | E-9 | 419 | HOC-19 | 502 |
| Ex. 20 | A-2 | 378 | E-10 | 414 | HOC-20 | 501 |
| Ex. 21 | A-3 | 377 | E-1 | 416 | HOC-21 | 502 |
| Ex. 22 | A-3 | 377 | E-2 | 415 | HOC-22 | 504 |
| Ex. 23 | A-3 | 377 | E-3 | 415 | HOC-23 | 506 |
| Ex. 24 | A-3 | 377 | E-4 | 417 | HOC-24 | 505 |
| Ex. 25 | A-3 | 377 | E-5 | 415 | HOC-25 | 505 |
| Ex. 26 | A-3 | 377 | E-6 | 415 | HOC-26 | 501 |
| Ex. 27 | A-3 | 377 | E-7 | 418 | HOC-27 | 499 |
| Ex. 28 | A-3 | 377 | E-8 | 412 | HOC-28 | 499 |
| Ex. 29 | A-3 | 377 | E-9 | 419 | HOC-29 | 497 |
| Ex. 30 | A-3 | 377 | E-10 | 414 | HOC-30 | 496 |
| Ex. 31 | A-4 | 380 | E-1 | 416 | HOC-31 | 499 |
| Ex. 32 | A-4 | 380 | E-2 | 415 | HOC-32 | 501 |
| Ex. 33 | A-4 | 380 | E-3 | 415 | HOC-33 | 499 |
| Ex. 34 | A-4 | 380 | E-4 | 417 | HOC-34 | 502 |
| Ex. 35 | A-4 | 380 | E-5 | 415 | HOC-35 | 495 |
| Ex. 36 | A-4 | 380 | E-6 | 415 | HOC-36 | 494 |
| Ex. 37 | A-4 | 380 | E-7 | 418 | HOC-37 | 501 |
| Ex. 38 | A-4 | 380 | E-8 | 412 | HOC-38 | 503 |
| Ex. 39 | A-4 | 380 | E-9 | 419 | HOC-39 | 505 |
| Ex. 40 | A-4 | 380 | E-10 | 414 | HOC-40 | 503 |
| Ex. 41 | A-5 | 382 | E-1 | 416 | HOC-41 | 501 |
| Ex. 42 | A-5 | 382 | E-2 | 415 | HOC-42 | 500 |
| Ex. 43 | A-5 | 382 | E-3 | 415 | HOC-43 | 501 |
| Ex. 44 | A-5 | 382 | E-4 | 417 | HOC-44 | 501 |
| Ex. 45 | A-5 | 382 | E-5 | 415 | HOC-45 | 500 |
| Ex. 46 | A-5 | 382 | E-6 | 415 | HOC-46 | 502 |
| Ex. 47 | A-5 | 382 | E-7 | 418 | HOC-47 | 504 |
| Ex. 48 | A-5 | 382 | E-8 | 412 | HOC-48 | 500 |
| Ex. 49 | A-5 | 382 | E-9 | 419 | HOC-49 | 499 |
| Ex. 50 | A-5 | 382 | E-10 | 414 | HOC-50 | 499 |
| Ex. 51 | A-6 | 376 | E-1 | 416 | HOC-51 | 501 |
| Ex. 52 | A-6 | 376 | E-2 | 415 | HOC-52 | 500 |
| Ex. 53 | A-6 | 376 | E-3 | 415 | HOC-53 | 501 |
| Ex. 54 | A-6 | 376 | E-4 | 417 | HOC-54 | 500 |
| Ex. 55 | A-6 | 376 | E-5 | 415 | HOC-55 | 500 |
| Ex. 56 | A-6 | 376 | E-6 | 415 | HOC-56 | 502 |
| Ex. 57 | A-6 | 376 | E-7 | 418 | HOC-57 | 499 |
| Ex. 58 | A-6 | 376 | E-8 | 412 | HOC-58 | 491 |
| Ex. 59 | A-6 | 376 | E-9 | 419 | HOC-59 | 499 |
| Ex. 60 | A-6 | 376 | E-10 | 414 | HOC-60 | 502 |
| Ex. 61 | A-7 | 381 | E-1 | 416 | HOC-61 | 495 |
| Ex. 62 | A-7 | 381 | E-2 | 415 | HOC-62 | 494 |
| Ex. 63 | A-7 | 381 | E-3 | 415 | HOC-63 | 501 |
| Ex. 64 | A-7 | 381 | E-4 | 417 | HOC-64 | 503 |
| Ex. 65 | A-7 | 381 | E-5 | 415 | HOC-65 | 505 |
| Ex. 66 | A-7 | 381 | E-6 | 415 | HOC-66 | 503 |
| Ex. 67 | A-7 | 381 | E-7 | 418 | HOC-67 | 501 |
| Ex. 68 | A-7 | 381 | E-8 | 412 | HOC-68 | 500 |
| Ex. 69 | A-7 | 381 | E-9 | 419 | HOC-69 | 501 |
| Ex. 70 | A-7 | 381 | E-10 | 414 | HOC-70 | 501 |
| Ex. 71 | A-8 | 381 | E-1 | 416 | HOC-71 | 500 |
| Ex. 72 | A-8 | 381 | E-2 | 415 | HOC-72 | 502 |
| Ex. 73 | A-8 | 381 | E-3 | 415 | HOC-73 | 504 |
| Ex. 74 | A-8 | 381 | E-4 | 417 | HOC-74 | 500 |
| Ex. 75 | A-8 | 381 | E-5 | 415 | HOC-75 | 499 |
| Ex. 76 | A-8 | 381 | E-6 | 415 | HOC-76 | 499 |
| Ex. 77 | A-8 | 381 | E-7 | 418 | HOC-77 | 501 |
| Ex. 78 | A-8 | 381 | E-8 | 412 | HOC-78 | 500 |
| Ex. 79 | A-8 | 381 | E-9 | 419 | HOC-79 | 501 |
| Ex. 80 | A-8 | 381 | E-10 | 414 | HOC-80 | 500 |
| Ex. 81 | A-9 | 381 | E-1 | 416 | HOC-81 | 504 |
| Ex. 82 | A-9 | 381 | E-2 | 415 | HOC-82 | 499 |
| Ex. 83 | A-9 | 381 | E-3 | 415 | HOC-83 | 498 |
| Ex. 84 | A-9 | 381 | E-4 | 417 | HOC-84 | 501 |
| Ex. 85 | A-9 | 381 | E-5 | 415 | HOC-85 | 501 |
| Ex. 86 | A-9 | 381 | E-6 | 415 | HOC-86 | 502 |
| Ex. 87 | A-9 | 381 | E-7 | 418 | HOC-87 | 501 |
| Ex. 88 | A-9 | 381 | E-8 | 412 | HOC-88 | 502 |
| Ex. 89 | A-9 | 381 | E-9 | 419 | HOC-89 | 504 |
| Ex. 90 | A-9 | 381 | E-10 | 414 | HOC-90 | 506 |
| Ex. 91 | A-10 | 378 | E-1 | 416 | HOC-91 | 501 |
| Ex. 92 | A-10 | 378 | E-2 | 415 | HOC-92 | 502 |
| Ex. 93 | A-10 | 378 | E-3 | 415 | HOC-93 | 504 |
| Ex. 94 | A-10 | 378 | E-4 | 417 | HOC-94 | 503 |
| Ex. 95 | A-10 | 378 | E-5 | 415 | HOC-95 | 504 |
| Ex. 96 | A-10 | 378 | E-6 | 415 | HOC-96 | 504 |
| Ex. 97 | A-10 | 378 | E-7 | 418 | HOC-97 | 499 |
| Ex. 98 | A-10 | 378 | E-8 | 412 | HOC-98 | 498 |
| Ex. 99 | A-10 | 378 | E-9 | 419 | HOC-99 | 501 |
| Ex. 100 | A-10 | 378 | E-10 | 414 | HOC-100 | 501 |
| Ex. 101 | A-11 | 381 | E-1 | 416 | HOC-101 | 502 |
| Ex. 102 | A-11 | 381 | E-2 | 415 | HOC-102 | 501 |
| Ex. 103 | A-11 | 381 | E-3 | 415 | HOC-103 | 502 |
| Ex. 104 | A-11 | 381 | E-4 | 417 | HOC-104 | 504 |
| Ex. 105 | A-11 | 381 | E-5 | 415 | HOC-105 | 502 |
| Ex. 106 | A-11 | 381 | E-6 | 415 | HOC-106 | 504 |
| Ex. 107 | A-11 | 381 | E-7 | 418 | HOC-107 | 500 |
| Ex. 108 | A-11 | 381 | E-8 | 412 | HOC-108 | 499 |
| Ex. 109 | A-11 | 381 | E-9 | 419 | HOC-109 | 499 |
| Ex. 110 | A-11 | 381 | E-10 | 414 | HOC-110 | 501 |
| Ex. 111 | A-12 | 384 | E-1 | 416 | HOC-111 | 500 |
| Ex. 112 | A-12 | 384 | E-2 | 415 | HOC-112 | 501 |
| Ex. 113 | A-12 | 384 | E-3 | 415 | HOC-113 | 500 |
| Ex. 114 | A-12 | 384 | E-4 | 417 | HOC-114 | 504 |
| Ex. 115 | A-12 | 384 | E-5 | 415 | HOC-115 | 499 |
| Ex. 116 | A-12 | 384 | E-6 | 415 | HOC-116 | 498 |
| Ex. 117 | A-12 | 384 | E-7 | 418 | HOC-117 | 501 |
| Ex. 118 | A-12 | 384 | E-8 | 412 | HOC-118 | 501 |
| Ex. 119 | A-12 | 384 | E-9 | 419 | HOC-119 | 502 |
| Ex. 120 | A-12 | 384 | E-10 | 414 | HOC-120 | 501 |
| Ex. 121 | A-13 | 383 | E-1 | 416 | HOC-121 | 502 |
| Ex. 122 | A-13 | 383 | E-2 | 415 | HOC-122 | 503 |
| Ex. 123 | A-13 | 383 | E-3 | 415 | HOC-123 | 501 |
| Ex. 124 | A-13 | 383 | E-4 | 417 | HOC-124 | 500 |
| Ex. 125 | A-13 | 383 | E-5 | 415 | HOC-125 | 501 |
| Ex. 126 | A-13 | 383 | E-6 | 415 | HOC-126 | 501 |
| Ex. 127 | A-13 | 383 | E-7 | 418 | HOC-127 | 500 |
| Ex. 128 | A-13 | 383 | E-8 | 412 | HOC-128 | 502 |
| Ex. 129 | A-13 | 383 | E-9 | 419 | HOC-129 | 504 |
| Ex. 130 | A-13 | 383 | E-10 | 414 | HOC-130 | 500 |
| Ex. 131 | A-14 | 378 | E-1 | 416 | HOC-131 | 499 |
| Ex. 132 | A-14 | 378 | E-2 | 415 | HOC-132 | 499 |
| Ex. 133 | A-14 | 378 | E-3 | 415 | HOC-133 | 501 |
| Ex. 134 | A-14 | 378 | E-4 | 417 | HOC-134 | 500 |
| Ex. 135 | A-14 | 378 | E-5 | 415 | HOC-135 | 501 |
| Ex. 136 | A-14 | 378 | E-6 | 415 | HOC-136 | 500 |
| Ex. 137 | A-14 | 378 | E-7 | 418 | HOC-137 | 500 |
| Ex. 138 | A-14 | 378 | E-8 | 412 | HOC-138 | 502 |
| Ex. 139 | A-14 | 378 | E-9 | 419 | HOC-139 | 499 |
| Ex. 140 | A-14 | 378 | E-10 | 414 | HOC-140 | 491 |
| Ex. 141 | A-15 | 377 | E-1 | 416 | HOC-141 | 499 |
| Ex. 142 | A-15 | 377 | E-2 | 415 | HOC-142 | 502 |
| Ex. 143 | A-15 | 377 | E-3 | 415 | HOC-143 | 495 |
| Ex. 144 | A-15 | 377 | E-4 | 417 | HOC-144 | 494 |
| Ex. 145 | A-15 | 377 | E-5 | 415 | HOC-145 | 501 |
| Ex. 146 | A-15 | 377 | E-6 | 415 | HOC-146 | 503 |
| Ex. 147 | A-15 | 377 | E-7 | 418 | HOC-147 | 505 |
| Ex. 148 | A-15 | 377 | E-8 | 412 | HOC-148 | 503 |
| Ex. 149 | A-15 | 377 | E-9 | 419 | HOC-149 | 501 |
| Ex. 150 | A-15 | 377 | E-10 | 414 | HOC-150 | 500 |
| Ex. 151 | A-16 | 384 | E-1 | 416 | HOC-151 | 501 |
| Ex. 152 | A-16 | 384 | E-2 | 415 | HOC-152 | 501 |
| Ex. 153 | A-16 | 384 | E-3 | 415 | HOC-153 | 500 |
| Ex. 154 | A-16 | 384 | E-4 | 417 | HOC-154 | 502 |
| Ex. 155 | A-16 | 384 | E-5 | 415 | HOC-155 | 504 |
| Ex. 156 | A-16 | 384 | E-6 | 415 | HOC-156 | 500 |
| Ex. 157 | A-16 | 384 | E-7 | 418 | HOC-157 | 499 |
| Ex. 158 | A-16 | 384 | E-8 | 412 | HOC-158 | 499 |
| Ex. 159 | A-16 | 384 | E-9 | 419 | HOC-159 | 501 |
| Ex. 160 | A-16 | 384 | E-10 | 414 | HOC-160 | 500 |
| Ex. 161 | B-1 | 379 | E-1 | 416 | HOC-161 | 501 |
| Ex. 162 | B-1 | 379 | E-2 | 415 | HOC-162 | 500 |
| Ex. 163 | B-1 | 379 | E-3 | 415 | HOC-163 | 504 |
| Ex. 164 | B-1 | 379 | E-4 | 417 | HOC-164 | 499 |
| Ex. 165 | B-1 | 379 | E-5 | 415 | HOC-165 | 500 |
| Ex. 166 | B-1 | 379 | E-6 | 415 | HOC-166 | 499 |
| Ex. 167 | B-1 | 379 | E-7 | 418 | HOC-167 | 499 |
| Ex. 168 | B-1 | 379 | E-8 | 412 | HOC-168 | 501 |
| Ex. 169 | B-1 | 379 | E-9 | 419 | HOC-169 | 500 |
| Ex. 170 | B-1 | 379 | E-10 | 414 | HOC-170 | 501 |
| Ex. 171 | B-2 | 379 | E-1 | 416 | HOC-171 | 500 |
| Ex. 172 | B-2 | 379 | E-2 | 415 | HOC-172 | 504 |
| Ex. 173 | B-2 | 379 | E-3 | 415 | HOC-173 | 502 |
| Ex. 174 | B-2 | 379 | E-4 | 417 | HOC-174 | 501 |
| Ex. 175 | B-2 | 379 | E-5 | 415 | HOC-175 | 502 |
| Ex. 176 | B-2 | 379 | E-6 | 415 | HOC-176 | 504 |
| Ex. 177 | B-2 | 379 | E-7 | 418 | HOC-177 | 506 |
| Ex. 178 | B-2 | 379 | E-8 | 412 | HOC-178 | 505 |
| Ex. 179 | B-2 | 379 | E-9 | 419 | HOC-179 | 505 |
| Ex. 180 | B-2 | 379 | E-10 | 414 | HOC-180 | 501 |
| Ex. 181 | B-3 | 380 | E-1 | 416 | HOC-181 | 499 |
| Ex. 182 | B-3 | 380 | E-2 | 415 | HOC-182 | 499 |
| Ex. 183 | B-3 | 380 | E-3 | 415 | HOC-183 | 500 |
| Ex. 184 | B-3 | 380 | E-4 | 417 | HOC-184 | 502 |
| Ex. 185 | B-3 | 380 | E-5 | 415 | HOC-185 | 504 |
| Ex. 186 | B-3 | 380 | E-6 | 415 | HOC-186 | 500 |
| Ex. 187 | B-3 | 380 | E-7 | 418 | HOC-187 | 499 |
| Ex. 188 | B-3 | 380 | E-8 | 412 | HOC-188 | 499 |
| Ex. 189 | B-3 | 380 | E-9 | 419 | HOC-189 | 501 |
| Ex. 190 | B-3 | 380 | E-10 | 414 | HOC-190 | 500 |
| Ex. 191 | B-4 | 382 | E-1 | 416 | HOC-191 | 501 |
| Ex. 192 | B-4 | 382 | E-2 | 415 | HOC-192 | 500 |
| Ex. 193 | B-4 | 382 | E-3 | 415 | HOC-193 | 504 |
| Ex. 194 | B-4 | 382 | E-4 | 417 | HOC-194 | 499 |
| Ex. 195 | B-4 | 382 | E-5 | 415 | HOC-195 | 500 |
| Ex. 196 | B-4 | 382 | E-6 | 415 | HOC-196 | 499 |
| Ex. 197 | B-4 | 382 | E-7 | 418 | HOC-197 | 499 |
| Ex. 198 | B-4 | 382 | E-8 | 412 | HOC-198 | 501 |
| Ex. 199 | B-4 | 382 | E-9 | 419 | HOC-199 | 500 |
| Ex. 200 | B-4 | 382 | E-10 | 414 | HOC-200 | 501 |
| Ex. 201 | C-1 | 381 | E-1 | 416 | HOC-201 | 500 |
| Ex. 202 | C-1 | 381 | E-2 | 415 | HOC-202 | 504 |
| Ex. 203 | C-1 | 381 | E-3 | 415 | HOC-203 | 501 |
| Ex. 204 | C-1 | 381 | E-4 | 417 | HOC-204 | 501 |
| Ex. 205 | C-1 | 381 | E-5 | 415 | HOC-205 | 502 |
| Ex. 206 | C-1 | 381 | E-6 | 415 | HOC-206 | 501 |
| Ex. 207 | C-1 | 381 | E-7 | 418 | HOC-207 | 502 |
| Ex. 208 | C-1 | 381 | E-8 | 412 | HOC-208 | 503 |
| Ex. 209 | C-1 | 381 | E-9 | 419 | HOC-209 | 501 |
| Ex. 210 | C-1 | 381 | E-10 | 414 | HOC-210 | 500 |
| Ex. 211 | C-2 | 382 | E-1 | 416 | HOC-211 | 501 |
| Ex. 212 | C-2 | 382 | E-2 | 415 | HOC-212 | 501 |
| Ex. 213 | C-2 | 382 | E-3 | 415 | HOC-213 | 500 |
| Ex. 214 | C-2 | 382 | E-4 | 417 | HOC-214 | 502 |
| Ex. 215 | C-2 | 382 | E-5 | 415 | HOC-215 | 504 |
| Ex. 216 | C-2 | 382 | E-6 | 415 | HOC-216 | 500 |
| Ex. 217 | C-2 | 382 | E-7 | 418 | HOC-217 | 499 |
| Ex. 218 | C-2 | 382 | E-8 | 412 | HOC-218 | 499 |
| Ex. 219 | C-2 | 382 | E-9 | 419 | HOC-219 | 501 |
| Ex. 220 | C-2 | 382 | E-10 | 414 | HOC-220 | 500 |
| Ex. 221 | C-3 | 381 | E-1 | 416 | HOC-221 | 501 |
| Ex. 222 | C-3 | 381 | E-2 | 415 | HOC-222 | 500 |
| Ex. 223 | C-3 | 381 | E-3 | 415 | HOC-223 | 500 |
| Ex. 224 | C-3 | 381 | E-4 | 417 | HOC-224 | 502 |
| Ex. 225 | C-3 | 381 | E-5 | 415 | HOC-225 | 499 |
| Ex. 226 | C-3 | 381 | E-6 | 415 | HOC-226 | 491 |
| Ex. 227 | C-3 | 381 | E-7 | 418 | HOC-227 | 499 |
| Ex. 228 | C-3 | 381 | E-8 | 412 | HOC-228 | 502 |
| Ex. 229 | C-3 | 381 | E-9 | 419 | HOC-229 | 495 |
| Ex. 230 | C-3 | 381 | E-10 | 414 | HOC-230 | 502 |
| Ex. 231 | C-4 | 385 | E-1 | 416 | HOC-231 | 501 |
| Ex. 232 | C-4 | 385 | E-2 | 415 | HOC-232 | 502 |
| Ex. 233 | C-4 | 385 | E-3 | 415 | HOC-233 | 504 |
| Ex. 234 | C-4 | 385 | E-4 | 417 | HOC-234 | 506 |
| Ex. 235 | C-4 | 385 | E-5 | 415 | HOC-235 | 505 |
| Ex. 236 | C-4 | 385 | E-6 | 415 | HOC-236 | 505 |
| Ex. 237 | C-4 | 385 | E-7 | 418 | HOC-237 | 501 |
| Ex. 238 | C-4 | 385 | E-8 | 412 | HOC-238 | 499 |
| Ex. 239 | C-4 | 385 | E-9 | 419 | HOC-239 | 499 |
| Ex. 240 | C-4 | 385 | E-10 | 414 | HOC-240 | 500 |
| Ex. 241 | D-1 | 379 | E-1 | 416 | HOC-241 | 502 |
| Ex. 242 | D-1 | 379 | E-2 | 415 | HOC-242 | 500 |
| Ex. 243 | D-1 | 379 | E-3 | 415 | HOC-243 | 499 |
| Ex. 244 | D-1 | 379 | E-4 | 417 | HOC-244 | 499 |
| Ex. 245 | D-1 | 379 | E-5 | 415 | HOC-245 | 501 |
| Ex. 246 | D-1 | 379 | E-6 | 415 | HOC-246 | 500 |
| Ex. 247 | D-1 | 379 | E-7 | 418 | HOC-247 | 501 |
| Ex. 248 | D-1 | 379 | E-8 | 412 | HOC-248 | 500 |
| Ex. 249 | D-1 | 379 | E-9 | 419 | HOC-249 | 504 |
| Ex. 250 | D-1 | 379 | E-10 | 414 | HOC-250 | 499 |
| Ex. 251 | D-2 | 379 | E-1 | 416 | HOC-251 | 500 |
| Ex. 252 | D-2 | 379 | E-2 | 415 | HOC-252 | 499 |
| Ex. 253 | D-2 | 379 | E-3 | 415 | HOC-253 | 499 |
| Ex. 254 | D-2 | 379 | E-4 | 417 | HOC-254 | 501 |
| Ex. 255 | D-2 | 379 | E-5 | 415 | HOC-255 | 500 |
| Ex. 256 | D-2 | 379 | E-6 | 415 | HOC-256 | 501 |
| Ex. 257 | D-2 | 379 | E-7 | 418 | HOC-257 | 500 |
| Ex. 258 | D-2 | 379 | E-8 | 412 | HOC-258 | 504 |
| Ex. 259 | D-2 | 379 | E-9 | 419 | HOC-259 | 502 |
| Ex. 260 | D-2 | 379 | E-10 | 414 | HOC-260 | 501 |
| Ex. 261 | D-3 | 380 | E-1 | 416 | HOC-261 | 502 |
| Ex. 262 | D-3 | 380 | E-2 | 415 | HOC-262 | 504 |
| Ex. 263 | D-3 | 380 | E-3 | 415 | HOC-263 | 506 |
| Ex. 264 | D-3 | 380 | E-4 | 417 | HOC-264 | 505 |
| Ex. 265 | D-3 | 380 | E-5 | 415 | HOC-265 | 505 |
| Ex. 266 | D-3 | 380 | E-6 | 415 | HOC-266 | 501 |
| Ex. 267 | D-3 | 380 | E-7 | 418 | HOC-267 | 499 |
| Ex. 268 | D-3 | 380 | E-8 | 412 | HOC-268 | 499 |
| Ex. 269 | D-3 | 380 | E-9 | 419 | HOC-269 | 500 |
| Ex. 270 | D-3 | 380 | E-10 | 414 | HOC-270 | 502 |
| Ex. 271 | D-4 | 381 | E-1 | 416 | HOC-271 | 500 |
| Ex. 272 | D-4 | 381 | E-2 | 415 | HOC-272 | 499 |
| Ex. 273 | D-4 | 381 | E-3 | 415 | HOC-273 | 499 |
| Ex. 274 | D-4 | 381 | E-4 | 417 | HOC-274 | 501 |
| Ex. 275 | D-4 | 381 | E-5 | 415 | HOC-275 | 501 |
| Ex. 276 | D-4 | 381 | E-6 | 415 | HOC-276 | 500 |
| Ex. 277 | D-4 | 381 | E-7 | 418 | HOC-277 | 501 |
| Ex. 278 | D-4 | 381 | E-8 | 412 | HOC-278 | 500 |
| Ex. 279 | D-4 | 381 | E-9 | 419 | HOC-279 | 504 |
| Ex. 280 | D-4 | 381 | E-10 | 414 | HOC-280 | 501 |
| C. Ex. 1 | A-1 | 380 | E-1 | 416 | Simple Mix. comA | 414 |

As shown in Table 1, it was confirmed that the homogeneous organic complex HOC-1 of the present invention, prepared in Example 1, exhibited maximum emission wavelength characteristics in the relatively longer wavelength region compared to compound A-1, compound E-1, and the simple mixture of compounds A-1 and E-1, comA (Comparative Example 1). The data demonstrates that the homogeneous organic complex of the present invention forms a more electrically stable complex. Similarly, the homogeneous organic complexes HOC-2 to HOC-280 in Examples 2 to 280 also showed maximum emission wavelength characteristics in the relatively longer wavelength region compared to each raw material compound.

### [EVALUATION EXAMPLE 2: Evaluation for Physical Properties of Organic EL Devices]

The green organic EL devices fabricated in Examples 1 to 280 and Comparative Example 1 were each measured for driving voltage, current efficiency, and lifespan T₉₇ at a current density of 10 mA/cm², and the results are shown in Table 2 below.

**TABLE 2**

| Sample | Raw material of pellet | | Host | Driving Volt. (V) | EL Peak nm) | Curren t effic. (cd/A) | Lifespan (hr, T₉₇) |
|---|---|---|---|---|---|---|---|
| | 1^{st} Organic | 2^{nd} Organic | | | | | |
| | Cpd. | Cpd. | | | | | |
| Ex. 1 | A-1 | E-1 | Homo. Organic complex HOC-1 | 3.7 | 516 | 140.3 | 400 |
| Ex. 2 | A-1 | E-2 | HOC-2 | 3.84 | 516 | 144.2 | 402 |
| Ex. 3 | A-1 | E-3 | HOC-3 | 3.45 | 518 | 146.1 | 392 |
| Ex. 4 | A-1 | E-4 | HOC-4 | 3.54 | 518 | 144.3 | 399 |
| Ex. 5 | A-1 | E-5 | HOC-5 | 3.65 | 518 | 145.1 | 391 |
| Ex. 6 | A-1 | E-6 | HOC-6 | 3.45 | 517 | 145.4 | 403 |
| Ex. 7 | A-1 | E-7 | HOC-7 | 3.56 | 515 | 144.2 | 412 |
| Ex. 8 | A-1 | E-8 | HOC-8 | 3.67 | 518 | 146.1 | 421 |
| Ex. 9 | A-1 | E-9 | HOC-9 | 3.54 | 518 | 144.3 | 391 |
| Ex. 10 | A-1 | E-10 | HOC-10 | 3.56 | 517 | 145.1 | 404 |
| Ex. 11 | A-2 | E-1 | HOC-11 | 3.45 | 515 | 141.4 | 401 |
| Ex. 12 | A-2 | E-2 | HOC-12 | 3.52 | 516 | 144.3 | 370 |
| Ex. 13 | A-2 | E-3 | HOC-13 | 3.74 | 516 | 142.3 | 380 |
| Ex. 14 | A-2 | E-4 | HOC-14 | 3.54 | 515 | 144.2 | 391 |
| Ex. 15 | A-2 | E-5 | HOC-15 | 3.55 | 518 | 144.2 | 403 |
| Ex. 16 | A-2 | E-6 | HOC-16 | 3.67 | 518 | 146.1 | 412 |
| Ex. 17 | A-2 | E-7 | HOC-17 | 3.54 | 517 | 144.3 | 421 |
| Ex. 18 | A-2 | E-8 | HOC-18 | 3.56 | 515 | 141.4 | 391 |
| Ex. 19 | A-2 | E-9 | HOC-19 | 3.45 | 517 | 145.4 | 403 |
| Ex. 20 | A-2 | E-10 | HOC-20 | 3.56 | 515 | 144.2 | 412 |
| Ex. 21 | A-3 | E-1 | HOC-21 | 3.67 | 518 | 146.1 | 421 |
| Ex. 22 | A-3 | E-2 | HOC-22 | 3.54 | 518 | 144.3 | 391 |
| Ex. 23 | A-3 | E-3 | HOC-23 | 3.56 | 517 | 145.1 | 404 |
| Ex. 24 | A-3 | E-4 | HOC-24 | 3.45 | 515 | 141.4 | 401 |
| Ex. 25 | A-3 | E-5 | HOC-25 | 3.52 | 516 | 144.3 | 370 |
| Ex. 26 | A-3 | E-6 | HOC-26 | 3.56 | 518 | 142.3 | 380 |
| Ex. 27 | A-3 | E-7 | HOC-27 | 3.56 | 518 | 144.2 | 391 |
| Ex. 28 | A-3 | E-8 | HOC-28 | 3.84 | 516 | 146.1 | 403 |
| Ex. 29 | A-3 | E-9 | HOC-29 | 3.45 | 518 | 144.3 | 412 |
| Ex. 30 | A-3 | E-10 | HOC-30 | 3.54 | 518 | 145.1 | 421 |
| Ex. 31 | A-4 | E-1 | HOC-31 | 3.65 | 518 | 141.4 | 391 |
| Ex. 32 | A-4 | E-2 | HOC-32 | 3.48 | 517 | 145.4 | 403 |
| Ex. 33 | A-4 | E-3 | HOC-33 | 3.56 | 517 | 144.2 | 412 |
| Ex. 34 | A-4 | E-4 | HOC-34 | 3.84 | 515 | 146.1 | 421 |
| Ex. 35 | A-4 | E-5 | HOC-35 | 3.45 | 518 | 144.3 | 391 |
| Ex. 36 | A-4 | E-6 | HOC-36 | 3.54 | 515 | 145.1 | 404 |
| Ex. 37 | A-4 | E-7 | HOC-37 | 3.48 | 518 | 141.4 | 401 |
| Ex. 38 | A-4 | E-8 | HOC-38 | 3.81 | 516 | 142.3 | 380 |
| Ex. 39 | A-4 | E-9 | HOC-39 | 3.54 | 515 | 144.2 | 391 |
| Ex. 40 | A-4 | E-10 | HOC-40 | 3.65 | 518 | 146.1 | 403 |
| Ex. 41 | A-5 | E-1 | HOC-41 | 3.55 | 518 | 144.3 | 412 |
| Ex. 42 | A-5 | E-2 | HOC-42 | 3.67 | 517 | 145.1 | 421 |
| Ex. 43 | A-5 | E-3 | HOC-43 | 3.54 | 515 | 141.4 | 391 |
| Ex. 44 | A-5 | E-4 | HOC-44 | 3.45 | 518 | 145.4 | 403 |
| Ex. 45 | A-5 | E-5 | HOC-45 | 3.54 | 518 | 144.2 | 412 |
| Ex. 46 | A-5 | E-6 | HOC-46 | 3.65 | 518 | 146.1 | 421 |
| Ex. 47 | A-5 | E-7 | HOC-47 | 3.48 | 517 | 144.2 | 391 |
| Ex. 48 | A-5 | E-8 | HOC-48 | 3.67 | 517 | 142.3 | 391 |
| Ex. 49 | A-5 | E-9 | HOC-49 | 3.54 | 515 | 144.3 | 404 |
| Ex. 50 | A-5 | E-10 | HOC-50 | 3.45 | 518 | 142.3 | 374 |
| Ex. 51 | A-6 | E-1 | HOC-51 | 3.54 | 518 | 145.4 | 390 |
| Ex. 52 | A-6 | E-2 | HOC-52 | 3.65 | 518 | 146.1 | 403 |
| Ex. 53 | A-6 | E-3 | HOC-53 | 3.48 | 517 | 144.3 | 412 |
| Ex. 54 | A-6 | E-4 | HOC-54 | 3.45 | 517 | 145.1 | 421 |
| Ex. 55 | A-6 | E-5 | HOC-55 | 3.54 | 518 | 144.2 | 391 |
| Ex. 56 | A-6 | E-6 | HOC-56 | 3.48 | 517 | 143.1 | 403 |
| Ex. 57 | A-6 | E-7 | HOC-57 | 3.45 | 515 | 146.5 | 412 |
| Ex. 58 | A-6 | E-8 | HOC-58 | 3.56 | 516 | 141.8 | 421 |
| Ex. 59 | A-6 | E-9 | HOC-59 | 3.48 | 515 | 140.7 | 391 |
| Ex. 60 | A-6 | E-10 | HOC-60 | 3.81 | 516 | 144.3 | 404 |
| Ex. 61 | A-7 | E-1 | HOC-61 | 3.54 | 516 | 142.3 | 401 |
| Ex. 62 | A-7 | E-2 | HOC-62 | 3.65 | 518 | 142.4 | 411 |
| Ex. 63 | A-7 | E-3 | HOC-63 | 3.55 | 515 | 144.3 | 404 |
| Ex. 64 | A-7 | E-4 | HOC-64 | 3.81 | 518 | 142.3 | 374 |
| Ex. 65 | A-7 | E-5 | HOC-65 | 3.56 | 518 | 145.4 | 390 |
| Ex. 66 | A-7 | E-6 | HOC-66 | 3.58 | 518 | 146.1 | 403 |
| Ex. 67 | A-7 | E-7 | HOC-67 | 3.89 | 517 | 144.3 | 412 |
| Ex. 68 | A-7 | E-8 | HOC-68 | 3.56 | 517 | 145.1 | 421 |
| Ex. 69 | A-7 | E-9 | HOC-69 | 3.84 | 518 | 144.2 | 391 |
| Ex. 70 | A-7 | E-10 | HOC-70 | 3.45 | 517 | 143.1 | 403 |
| Ex. 71 | A-8 | E-1 | HOC-71 | 3.54 | 515 | 146.5 | 412 |
| Ex. 72 | A-8 | E-2 | HOC-72 | 3.48 | 516 | 141.8 | 421 |
| Ex. 73 | A-8 | E-3 | HOC-73 | 3.45 | 515 | 140.7 | 391 |
| Ex. 74 | A-8 | E-4 | HOC-74 | 3.56 | 516 | 144.3 | 404 |
| Ex. 75 | A-8 | E-5 | HOC-75 | 3.48 | 516 | 142.3 | 401 |
| Ex. 76 | A-8 | E-6 | HOC-76 | 3.81 | 518 | 142.4 | 411 |
| Ex. 77 | A-8 | E-7 | HOC-77 | 3.54 | 516 | 144.2 | 412 |
| Ex. 78 | A-8 | E-8 | HOC-78 | 3.65 | 515 | 146.1 | 421 |
| Ex. 79 | A-8 | E-9 | HOC-79 | 3.55 | 518 | 144.3 | 391 |
| Ex. 80 | A-8 | E-10 | HOC-80 | 3.81 | 516 | 141.2 | 390 |
| Ex. 81 | A-9 | E-1 | HOC-81 | 3.56 | 518 | 142.4 | 411 |
| Ex. 82 | A-9 | E-2 | HOC-82 | 3.58 | 518 | 146.2 | 402 |
| Ex. 83 | A-9 | E-3 | HOC-83 | 3.89 | 517 | 143.1 | 392 |
| Ex. 84 | A-9 | E-4 | HOC-84 | 3.56 | 515 | 146.5 | 399 |
| Ex. 85 | A-9 | E-5 | HOC-85 | 3.52 | 516 | 141.8 | 370 |
| Ex. 86 | A-9 | E-6 | HOC-86 | 3.74 | 515 | 140.7 | 380 |
| Ex. 87 | A-9 | E-7 | HOC-87 | 3.84 | 518 | 144.1 | 385 |
| Ex. 88 | A-9 | E-8 | HOC-88 | 3.45 | 518 | 144.3 | 412 |
| Ex. 89 | A-9 | E-9 | HOC-89 | 3.54 | 518 | 142.3 | 391 |
| Ex. 90 | A-9 | E-10 | HOC-90 | 3.65 | 517 | 144.3 | 412 |
| Ex. 91 | A-10 | E-1 | HOC-91 | 3.55 | 517 | 145.1 | 421 |
| Ex. 92 | A-10 | E-2 | HOC-92 | 3.67 | 518 | 144.2 | 391 |
| Ex. 93 | A-10 | E-3 | HOC-93 | 3.54 | 517 | 143.1 | 403 |
| Ex. 94 | A-10 | E-4 | HOC-94 | 3.56 | 515 | 146.5 | 412 |
| Ex. 95 | A-10 | E-5 | HOC-95 | 3.45 | 516 | 141.8 | 421 |
| Ex. 96 | A-10 | E-6 | HOC-96 | 3.52 | 515 | 140.7 | 391 |
| Ex. 97 | A-10 | E-7 | HOC-97 | 3.74 | 516 | 144.3 | 404 |
| Ex. 98 | A-10 | E-8 | HOC-98 | 3.54 | 516 | 142.3 | 401 |
| Ex. 99 | A-10 | E-9 | HOC-99 | 3.65 | 518 | 142.4 | 411 |
| Ex. 100 | A-10 | E-10 | HOC-100 | 3.55 | 516 | 144.2 | 412 |
| Ex. 101 | A-11 | E-1 | HOC-101 | 3.67 | 515 | 146.1 | 421 |
| Ex. 102 | A-11 | E-2 | HOC-102 | 3.54 | 518 | 144.3 | 391 |
| Ex. 103 | A-11 | E-3 | HOC-103 | 3.56 | 516 | 141.2 | 390 |
| Ex. 104 | A-11 | E-4 | HOC-104 | 3.45 | 518 | 142.3 | 374 |
| Ex. 105 | A-11 | E-5 | HOC-105 | 3.54 | 517 | 145.4 | 390 |
| Ex. 106 | A-11 | E-6 | HOC-106 | 3.56 | 515 | 144.2 | 391 |
| Ex. 107 | A-11 | E-7 | HOC-107 | 3.45 | 518 | 146.1 | 403 |
| Ex. 108 | A-11 | E-8 | HOC-108 | 3.56 | 518 | 144.3 | 412 |
| Ex. 109 | A-11 | E-9 | HOC-109 | 3.48 | 517 | 145.1 | 391 |
| Ex. 110 | A-11 | E-10 | HOC-110 | 3.48 | 515 | 141.4 | 403 |
| Ex. 111 | A-12 | E-1 | HOC-111 | 3.81 | 516 | 144.3 | 412 |
| Ex. 112 | A-12 | E-2 | HOC-112 | 3.54 | 516 | 142.3 | 421 |
| Ex. 113 | A-12 | E-3 | HOC-113 | 3.65 | 518 | 142.3 | 391 |
| Ex. 114 | A-12 | E-4 | HOC-114 | 3.56 | 518 | 144.3 | 404 |
| Ex. 115 | A-12 | E-5 | HOC-115 | 3.45 | 518 | 142.3 | 374 |
| Ex. 116 | A-12 | E-6 | HOC-116 | 3.54 | 517 | 145.4 | 390 |
| Ex. 117 | A-12 | E-7 | HOC-117 | 3.56 | 515 | 144.2 | 391 |
| Ex. 118 | A-12 | E-8 | HOC-118 | 3.45 | 518 | 146.1 | 403 |
| Ex. 119 | A-12 | E-9 | HOC-119 | 3.56 | 518 | 144.3 | 412 |
| Ex. 120 | A-12 | E-10 | HOC-120 | 3.48 | 517 | 145.1 | 391 |
| Ex. 121 | A-13 | E-1 | HOC-121 | 3.48 | 515 | 141.4 | 403 |
| Ex. 122 | A-13 | E-2 | HOC-122 | 3.81 | 516 | 144.3 | 412 |
| Ex. 123 | A-13 | E-3 | HOC-123 | 3.55 | 516 | 141.8 | 412 |
| Ex. 124 | A-13 | E-4 | HOC-124 | 3.67 | 515 | 140.7 | 421 |
| Ex. 125 | A-13 | E-5 | HOC-125 | 3.54 | 518 | 144.1 | 391 |
| Ex. 126 | A-13 | E-6 | HOC-126 | 3.56 | 518 | 144.3 | 404 |
| Ex. 127 | A-13 | E-7 | HOC-127 | 3.45 | 518 | 142.3 | 374 |
| Ex. 128 | A-13 | E-8 | HOC-128 | 3.54 | 517 | 145.4 | 390 |
| Ex. 129 | A-13 | E-9 | HOC-129 | 3.56 | 515 | 144.2 | 391 |
| Ex. 130 | A-13 | E-10 | HOC-130 | 3.45 | 518 | 146.1 | 403 |
| Ex. 131 | A-14 | E-1 | HOC-131 | 3.56 | 518 | 144.3 | 412 |
| Ex. 132 | A-14 | E-2 | HOC-132 | 3.48 | 517 | 145.1 | 391 |
| Ex. 133 | A-14 | E-3 | HOC-133 | 3.48 | 515 | 141.4 | 403 |
| Ex. 134 | A-14 | E-4 | HOC-134 | 3.81 | 516 | 144.3 | 412 |
| Ex. 135 | A-14 | E-5 | HOC-135 | 3.54 | 516 | 142.3 | 421 |
| Ex. 136 | A-14 | E-6 | HOC-136 | 3.65 | 518 | 142.3 | 391 |
| Ex. 137 | A-14 | E-7 | HOC-137 | 3.55 | 517 | 145.4 | 404 |
| Ex. 138 | A-14 | E-8 | HOC-138 | 3.67 | 515 | 144.2 | 401 |
| Ex. 139 | A-14 | E-9 | HOC-139 | 3.54 | 518 | 146.1 | 411 |
| Ex. 140 | A-14 | E-10 | HOC-140 | 3.45 | 518 | 144.3 | 374 |
| Ex. 141 | A-15 | E-1 | HOC-141 | 3.54 | 517 | 145.1 | 390 |
| Ex. 142 | A-15 | E-2 | HOC-142 | 3.45 | 518 | 142.3 | 374 |
| Ex. 143 | A-15 | E-3 | HOC-143 | 3.54 | 517 | 145.4 | 390 |
| Ex. 144 | A-15 | E-4 | HOC-144 | 3.56 | 515 | 144.2 | 391 |
| Ex. 145 | A-15 | E-5 | HOC-145 | 3.45 | 518 | 146.1 | 403 |
| Ex. 146 | A-15 | E-6 | HOC-146 | 3.56 | 518 | 144.3 | 412 |
| Ex. 147 | A-15 | E-7 | HOC-147 | 3.48 | 517 | 145.1 | 391 |
| Ex. 148 | A-15 | E-8 | HOC-148 | 3.48 | 515 | 141.4 | 403 |
| Ex. 149 | A-15 | E-9 | HOC-149 | 3.81 | 516 | 144.3 | 412 |
| Ex. 150 | A-15 | E-10 | HOC-150 | 3.54 | 516 | 142.3 | 421 |
| Ex. 151 | A-16 | E-1 | HOC-151 | 3.65 | 518 | 142.3 | 391 |
| Ex. 152 | A-16 | E-2 | HOC-152 | 3.56 | 518 | 144.3 | 404 |
| Ex. 153 | A-16 | E-3 | HOC-153 | 3.45 | 518 | 142.3 | 374 |
| Ex. 154 | A-16 | E-4 | HOC-154 | 3.54 | 517 | 145.4 | 390 |
| Ex. 155 | A-16 | E-5 | HOC-155 | 3.56 | 515 | 144.2 | 391 |
| Ex. 156 | A-16 | E-6 | HOC-156 | 3.45 | 518 | 146.1 | 403 |
| Ex. 157 | A-16 | E-7 | HOC-157 | 3.56 | 518 | 144.3 | 412 |
| Ex. 158 | A-16 | E-8 | HOC-158 | 3.48 | 517 | 145.1 | 391 |
| Ex. 159 | A-16 | E-9 | HOC-159 | 3.48 | 515 | 141.4 | 403 |
| Ex. 160 | A-16 | E-10 | HOC-160 | 3.81 | 516 | 144.3 | 412 |
| Ex. 161 | B-1 | E-1 | HOC-161 | 3.55 | 516 | 141.8 | 412 |
| Ex. 162 | B-1 | E-2 | HOC-162 | 3.67 | 515 | 140.7 | 421 |
| Ex. 163 | B-1 | E-3 | HOC-163 | 3.54 | 518 | 144.1 | 391 |
| Ex. 164 | B-1 | E-4 | HOC-164 | 3.56 | 518 | 144.3 | 404 |
| Ex. 165 | B-1 | E-5 | HOC-165 | 3.45 | 518 | 142.3 | 374 |
| Ex. 166 | B-1 | E-6 | HOC-166 | 3.54 | 517 | 145.4 | 390 |
| Ex. 167 | B-1 | E-7 | HOC-167 | 3.56 | 515 | 144.2 | 391 |
| Ex. 168 | B-1 | E-8 | HOC-168 | 3.45 | 518 | 146.1 | 403 |
| Ex. 169 | B-1 | E-9 | HOC-169 | 3.56 | 518 | 144.3 | 412 |
| Ex. 170 | B-1 | E-10 | HOC-170 | 3.48 | 517 | 145.1 | 391 |
| Ex. 171 | B-2 | E-1 | HOC-171 | 3.48 | 515 | 141.4 | 403 |
| Ex. 172 | B-2 | E-2 | HOC-172 | 3.81 | 516 | 144.3 | 412 |
| Ex. 173 | B-2 | E-3 | HOC-173 | 3.54 | 516 | 142.3 | 421 |
| Ex. 174 | B-2 | E-4 | HOC-174 | 3.65 | 518 | 146.1 | 411 |
| Ex. 175 | B-2 | E-5 | HOC-175 | 3.55 | 518 | 144.3 | 374 |
| Ex. 176 | B-2 | E-6 | HOC-176 | 3.54 | 517 | 145.1 | 390 |
| Ex. 177 | B-2 | E-7 | HOC-177 | 3.81 | 516 | 141.2 | 390 |
| Ex. 178 | B-2 | E-8 | HOC-178 | 3.56 | 518 | 142.4 | 411 |
| Ex. 179 | B-2 | E-9 | HOC-179 | 3.58 | 518 | 146.2 | 402 |
| Ex. 180 | B-2 | E-10 | HOC-180 | 3.89 | 517 | 143.1 | 392 |
| Ex. 181 | B-3 | E-1 | HOC-181 | 3.56 | 515 | 146.5 | 399 |
| Ex. 182 | B-3 | E-2 | HOC-182 | 3.52 | 516 | 141.8 | 370 |
| Ex. 183 | B-3 | E-3 | HOC-183 | 3.74 | 515 | 140.7 | 380 |
| Ex. 184 | B-3 | E-4 | HOC-184 | 3.84 | 518 | 144.1 | 385 |
| Ex. 185 | B-3 | E-5 | HOC-185 | 3.45 | 518 | 144.3 | 412 |
| Ex. 186 | B-3 | E-6 | HOC-186 | 3.54 | 518 | 142.3 | 391 |
| Ex. 187 | B-3 | E-7 | HOC-187 | 3.65 | 517 | 144.3 | 412 |
| Ex. 188 | B-3 | E-8 | HOC-188 | 3.55 | 517 | 145.1 | 421 |
| Ex. 189 | B-3 | E-9 | HOC-189 | 3.67 | 518 | 144.2 | 391 |
| Ex. 190 | B-3 | E-10 | HOC-190 | 3.54 | 517 | 143.1 | 403 |
| Ex. 191 | B-4 | E-1 | HOC-191 | 3.56 | 515 | 146.5 | 412 |
| Ex. 192 | B-4 | E-2 | HOC-192 | 3.45 | 516 | 141.8 | 421 |
| Ex. 193 | B-4 | E-3 | HOC-193 | 3.52 | 515 | 140.7 | 391 |
| Ex. 194 | B-4 | E-4 | HOC-194 | 3.74 | 516 | 144.3 | 404 |
| Ex. 195 | B-4 | E-5 | HOC-195 | 3.54 | 516 | 142.3 | 401 |
| Ex. 196 | B-4 | E-6 | HOC-196 | 3.65 | 518 | 142.4 | 411 |
| Ex. 197 | B-4 | E-7 | HOC-197 | 3.55 | 516 | 144.2 | 412 |
| Ex. 198 | B-4 | E-8 | HOC-198 | 3.67 | 515 | 146.1 | 421 |
| Ex. 199 | B-4 | E-9 | HOC-199 | 3.54 | 518 | 144.3 | 391 |
| Ex. 200 | B-4 | E-10 | HOC-200 | 3.56 | 516 | 141.2 | 390 |
| Ex. 201 | C-1 | E-1 | HOC-201 | 3.45 | 518 | 142.3 | 374 |
| Ex. 202 | C-1 | E-2 | HOC-202 | 3.54 | 517 | 145.4 | 390 |
| Ex. 203 | C-1 | E-3 | HOC-203 | 3.56 | 515 | 144.2 | 391 |
| Ex. 204 | C-1 | E-4 | HOC-204 | 3.45 | 518 | 146.1 | 403 |
| Ex. 205 | C-1 | E-5 | HOC-205 | 3.56 | 518 | 144.3 | 412 |
| Ex. 206 | C-1 | E-6 | HOC-206 | 3.48 | 517 | 145.1 | 391 |
| Ex. 207 | C-1 | E-7 | HOC-207 | 3.48 | 515 | 141.4 | 403 |
| Ex. 208 | C-1 | E-8 | HOC-208 | 3.81 | 516 | 144.3 | 412 |
| Ex. 209 | C-1 | E-9 | HOC-209 | 3.54 | 516 | 142.3 | 421 |
| Ex. 210 | C-1 | E-10 | HOC-210 | 3.65 | 518 | 142.3 | 391 |
| Ex. 211 | C-2 | E-1 | HOC-211 | 3.56 | 518 | 144.3 | 404 |
| Ex. 212 | C-2 | E-2 | HOC-212 | 3.45 | 518 | 142.3 | 374 |
| Ex. 213 | C-2 | E-3 | HOC-213 | 3.54 | 517 | 145.4 | 390 |
| Ex. 214 | C-2 | E-4 | HOC-214 | 3.56 | 515 | 144.2 | 391 |
| Ex. 215 | C-2 | E-5 | HOC-215 | 3.45 | 518 | 146.1 | 403 |
| Ex. 216 | C-2 | E-6 | HOC-216 | 3.56 | 518 | 144.3 | 412 |
| Ex. 217 | C-2 | E-7 | HOC-217 | 3.48 | 517 | 145.1 | 391 |
| Ex. 218 | C-2 | E-8 | HOC-218 | 3.48 | 515 | 141.4 | 403 |
| Ex. 219 | C-2 | E-9 | HOC-219 | 3.81 | 516 | 144.3 | 412 |
| Ex. 220 | C-2 | E-10 | HOC-220 | 3.55 | 516 | 141.8 | 412 |
| Ex. 221 | C-3 | E-1 | HOC-221 | 3.67 | 515 | 140.7 | 421 |
| Ex. 222 | C-3 | E-2 | HOC-222 | 3.54 | 518 | 144.1 | 391 |
| Ex. 223 | C-3 | E-3 | HOC-223 | 3.56 | 518 | 144.3 | 404 |
| Ex. 224 | C-3 | E-4 | HOC-224 | 3.45 | 518 | 142.3 | 374 |
| Ex. 225 | C-3 | E-5 | HOC-225 | 3.54 | 517 | 145.4 | 390 |
| Ex. 226 | C-3 | E-6 | HOC-226 | 3.56 | 515 | 144.2 | 391 |
| Ex. 227 | C-3 | E-7 | HOC-227 | 3.45 | 518 | 146.1 | 403 |
| Ex. 228 | C-3 | E-8 | HOC-228 | 3.56 | 518 | 144.3 | 412 |
| Ex. 229 | C-3 | E-9 | HOC-229 | 3.48 | 517 | 145.1 | 391 |
| Ex. 230 | C-3 | E-10 | HOC-230 | 3.48 | 515 | 141.4 | 403 |
| Ex. 231 | C-4 | E-1 | HOC-231 | 3.81 | 516 | 144.3 | 412 |
| Ex. 232 | C-4 | E-2 | HOC-232 | 3.54 | 516 | 142.3 | 421 |
| Ex. 233 | C-4 | E-3 | HOC-233 | 3.65 | 518 | 142.3 | 391 |
| Ex. 234 | C-4 | E-4 | HOC-234 | 3.55 | 517 | 145.4 | 404 |
| Ex. 235 | C-4 | E-5 | HOC-235 | 3.67 | 515 | 144.2 | 401 |
| Ex. 236 | C-4 | E-6 | HOC-236 | 3.54 | 518 | 146.1 | 411 |
| Ex. 237 | C-4 | E-7 | HOC-237 | 3.45 | 518 | 144.3 | 374 |
| Ex. 238 | C-4 | E-8 | HOC-238 | 3.54 | 517 | 145.1 | 390 |
| Ex. 239 | C-4 | E-9 | HOC-239 | 3.45 | 518 | 142.3 | 374 |
| Ex. 240 | C-4 | E-10 | HOC-240 | 3.54 | 517 | 145.4 | 390 |
| Ex. 241 | D-1 | E-1 | HOC-241 | 3.56 | 515 | 144.2 | 391 |
| Ex. 242 | D-1 | E-2 | HOC-242 | 3.45 | 518 | 146.1 | 403 |
| Ex. 243 | D-1 | E-3 | HOC-243 | 3.56 | 518 | 144.3 | 412 |
| Ex. 244 | D-1 | E-4 | HOC-244 | 3.48 | 517 | 145.1 | 391 |
| Ex. 245 | D-1 | E-5 | HOC-245 | 3.48 | 515 | 141.4 | 403 |
| Ex. 246 | D-1 | E-6 | HOC-246 | 3.81 | 516 | 144.3 | 412 |
| Ex. 247 | D-1 | E-7 | HOC-247 | 3.54 | 516 | 142.3 | 421 |
| Ex. 248 | D-1 | E-8 | HOC-248 | 3.65 | 518 | 142.3 | 391 |
| Ex. 249 | D-1 | E-9 | HOC-249 | 3.56 | 518 | 144.3 | 404 |
| Ex. 250 | D-1 | E-10 | HOC-250 | 3.45 | 518 | 142.3 | 374 |
| Ex. 251 | D-2 | E-1 | HOC-251 | 3.54 | 517 | 145.4 | 390 |
| Ex. 252 | D-2 | E-2 | HOC-252 | 3.56 | 515 | 144.2 | 391 |
| Ex. 253 | D-2 | E-3 | HOC-253 | 3.45 | 518 | 146.1 | 403 |
| Ex. 254 | D-2 | E-4 | HOC-254 | 3.56 | 518 | 144.3 | 412 |
| Ex. 255 | D-2 | E-5 | HOC-255 | 3.48 | 517 | 145.1 | 391 |
| Ex. 256 | D-2 | E-6 | HOC-256 | 3.48 | 515 | 141.4 | 403 |
| Ex. 257 | D-2 | E-7 | HOC-257 | 3.81 | 516 | 144.3 | 412 |
| Ex. 258 | D-2 | E-8 | HOC-258 | 3.55 | 516 | 141.8 | 412 |
| Ex. 259 | D-2 | E-9 | HOC-259 | 3.67 | 515 | 140.7 | 421 |
| Ex. 260 | D-2 | E-10 | HOC-260 | 3.54 | 518 | 144.1 | 391 |
| Ex. 261 | D-3 | E-1 | HOC-261 | 3.56 | 518 | 144.3 | 404 |
| Ex. 262 | D-3 | E-2 | HOC-262 | 3.45 | 518 | 142.3 | 374 |
| Ex. 263 | D-3 | E-3 | HOC-263 | 3.54 | 517 | 145.4 | 390 |
| Ex. 264 | D-3 | E-4 | HOC-264 | 3.56 | 515 | 144.2 | 391 |
| Ex. 265 | D-3 | E-5 | HOC-265 | 3.45 | 518 | 146.1 | 403 |
| Ex. 266 | D-3 | E-6 | HOC-266 | 3.56 | 518 | 144.3 | 412 |
| Ex. 267 | D-3 | E-7 | HOC-267 | 3.48 | 517 | 145.1 | 391 |
| Ex. 268 | D-3 | E-8 | HOC-268 | 3.48 | 515 | 141.4 | 403 |
| Ex. 269 | D-3 | E-9 | HOC-269 | 3.81 | 516 | 144.3 | 412 |
| Ex. 270 | D-3 | E-10 | HOC-270 | 3.56 | 516 | 142.3 | 421 |
| Ex. 271 | D-4 | E-1 | HOC-271 | 3.45 | 518 | 142.3 | 411 |
| Ex. 272 | D-4 | E-2 | HOC-272 | 3.56 | 517 | 145.4 | 374 |
| Ex. 273 | D-4 | E-3 | HOC-273 | 3.48 | 515 | 144.2 | 390 |
| Ex. 274 | D-4 | E-4 | HOC-274 | 3.48 | 518 | 146.1 | 374 |
| Ex. 275 | D-4 | E-5 | HOC-275 | 3.81 | 518 | 144.3 | 390 |
| Ex. 276 | D-4 | E-6 | HOC-276 | 3.54 | 517 | 145.1 | 390 |
| Ex. 277 | D-4 | E-7 | HOC-277 | 3.65 | 515 | 141.4 | 391 |
| Ex. 278 | D-4 | E-8 | HOC-278 | 3.56 | 516 | 142.3 | 403 |
| Ex. 279 | D-4 | E-9 | HOC-279 | 3.48 | 517 | 145.4 | 412 |
| Ex. 280 | D-4 | E-10 | HOC-280 | 3.48 | 515 | 144.2 | 391 |
| C. Ex. 1 | A-1 | E-1 | Simple Mix. comA | 6.34 | 517 | 90.5 | 10 |

As shown in Table 2, the green organic EL devices of Examples 1 to 280, which used the homogeneous organic complexes HOC-1 to HOC-280 of the present invention as the emission layer, exhibited significantly superior performance in terms of efficiency, driving voltage, and lifespan compared to Comparative Example 1, which uses the simple mixture comA. In particular, it was confirmed that the green organic EL device of Example 1 demonstrated approximately a 50% reduction in driving voltage and more than a 40-fold increase in device lifespan compared to Comparative Example 1.

### [EVALUATION EXAMPLE 3: Thin Film Formation Evaluation]

For each of the green organic EL device manufactured in Examples 1 to 280 and Comparative Example 1, a thin film was formed through a continuous process. During this process, the change in weight ratio (content ratio) between the compounds before and after the thin film formation process was measured, and the results are shown in Table 3 below.

**TABLE 3**

| Sample | Pre-process (wt%) | | Post-Process (wt%) | | Temporal change (%) |
|---|---|---|---|---|---|
| | 1^{st} Organic Cpd. | 2^{nd} Organic Cpd. | 1^{st} Organic Cpd. | 2^{nd} Organic Cpd | |
| HOC-1 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-2 | 50 | 50 | 49.9 | 50.1 | 0.1 |
| | 60 | 40 | 59.9 | 40.1 | 0.1 |
| | 70 | 30 | 70.1 | 29.9 | 0.1 |
| HOC-3 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-4 | 50 | 50 | 50 | 50 | 0 |
| | 60 | 40 | 60.1 | 39.9 | 0.1 |
| | 70 | 30 | 70.1 | 29.9 | 0.1 |
| HOC-5 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-6 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-7 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-8 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-9 | 50 | 50 | 50.1 | 49.9 | 0.1 |
| | 60 | 40 | 60 | 40 | 0 |
| | 70 | 30 | 70 | 30 | 0 |
| HOC-10 | 50 | 50 | 50 | 50 | 0 |
| | 60 | 40 | 59.9 | 40.1 | 0.1 |
| | 70 | 30 | 69.8 | 30.2 | 0.2 |
| HOC-11 | 50 | 50 | 49. 9 | 50.1 | 0.1 |
| | 60 | 40 | 59.9 | 40.1 | 0.1 |
| | 70 | 30 | 69.9 | 30.1 | 0.1 |
| HOC-12 | 50 | 50 | 50 | 50 | 0 |
| | 60 | 40 | 60.1 | 39.9 | 0.1 |
| | 70 | 30 | 70.1 | 29.9 | 0.1 |
| HOC-13 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-14 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-15 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-16 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-17 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-18 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-19 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-20 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-21 | 50 | 50 | 50 | 50 | 0 |
| | 60 | 40 | 60.1 | 39.9 | 0.1 |
| | 70 | 30 | 70.1 | 29.9 | 0.1 |
| HOC-22 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-23 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-24 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-25 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-26 | 50 | 50 | 50.1 | 49.9 | 0.1 |
| | 60 | 40 | 60 | 40 | 0 |
| | 70 | 30 | 70 | 30 | 0 |
| HOC-27 | 50 | 50 | 50 | 50 | 0 |
| | 60 | 40 | 59.9 | 40.1 | 0.1 |
| | 70 | 30 | 69.8 | 30.2 | 0.2 |
| HOC-28 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-29 | 50 | 50 | 50 | 50 | 0 |
| | 60 | 40 | 60.1 | 39.9 | 0.1 |
| | 70 | 30 | 70.1 | 29.9 | 0.1 |
| HOC-30 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-31 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-32 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-33 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-34 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-35 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-36 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-37 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-38 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-39 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-40 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-41 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-42 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-43 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-44 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-45 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-46 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-47 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-48 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-49 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-50 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-51 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-52 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-53 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-54 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-55 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-56 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-57 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-58 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-59 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-60 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-61 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-62 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-63 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-64 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-65 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-66 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-67 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-68 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-69 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-70 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-71 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-72 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-73 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-74 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-75 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-76 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-77 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-78 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-79 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-80 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-81 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-82 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-83 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-84 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-85 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-86 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-87 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-88 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-89 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-90 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-91 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-92 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-93 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-94 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-95 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-96 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-97 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-98 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-99 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-100 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-101 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-102 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-103 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-104 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-105 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-106 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-107 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-108 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-109 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-110 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-111 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-112 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-113 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-114 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-115 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-116 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-117 | 50 | 50 | 49.9 | 50.1 | 0.1 |
| | 60 | 40 | 59.9 | 40.1 | 0.1 |
| | 70 | 30 | 70.1 | 29.9 | 0.1 |
| HOC-118 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-119 | 50 | 50 | 50 | 50 | 0 |
| | 60 | 40 | 60.1 | 39.9 | 0.1 |
| | 70 | 30 | 70.1 | 29.9 | 0.1 |
| HOC-120 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-121 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-122 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-123 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-124 | 50 | 50 | 50.1 | 49.9 | 0.1 |
| | 60 | 40 | 60 | 40 | 0 |
| | 70 | 30 | 70 | 30 | 0 |
| HOC-125 | 50 | 50 | 50 | 50 | 0 |
| | 60 | 40 | 59.9 | 40.1 | 0.1 |
| | 70 | 30 | 69.8 | 30.2 | 0.2 |
| HOC-126 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-127 | 50 | 50 | 50 | 50 | 0 |
| | 60 | 40 | 60.1 | 39.9 | 0.1 |
| | 70 | 30 | 70.1 | 29.9 | 0.1 |
| HOC-128 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-129 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-130 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-131 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-132 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-133 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-134 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-135 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-136 | 50 | 50 | 50 | 50 | 0 |
| | 60 | 40 | 60.1 | 39.9 | 0.1 |
| | 70 | 30 | 70.1 | 29.9 | 0.1 |
| HOC-137 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-138 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-139 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-140 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-141 | 50 | 50 | 50.1 | 49.9 | 0.1 |
| | 60 | 40 | 60 | 40 | 0 |
| | 70 | 30 | 70 | 30 | 0 |
| HOC-142 | 50 | 50 | 50 | 50 | 0 |
| | 60 | 40 | 59.9 | 40.1 | 0.1 |
| | 70 | 30 | 69.8 | 30.2 | 0.2 |
| HOC-143 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-144 | 50 | 50 | 50 | 50 | 0 |
| | 60 | 40 | 60.1 | 39.9 | 0.1 |
| | 70 | 30 | 70.1 | 29.9 | 0.1 |
| HOC-145 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-146 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-147 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-148 | 50 | 50 | 50 | 50 | 0 |
| | 60 | 40 | 60.1 | 39.9 | 0.1 |
| | 70 | 30 | 70.1 | 29.9 | 0.1 |
| HOC-149 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-150 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-151 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-152 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-153 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-154 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-155 | 50 | 50 | 50 | 50 | 0 |
| | 60 | 40 | 60.1 | 39.9 | 0.1 |
| | 70 | 30 | 70.1 | 29.9 | 0.1 |
| HOC-156 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-157 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-158 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-159 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-160 | 50 | 50 | 50.1 | 49.9 | 0.1 |
| | 60 | 40 | 60 | 40 | 0 |
| | 70 | 30 | 70 | 30 | 0 |
| HOC-161 | 50 | 50 | 50 | 50 | 0 |
| | 60 | 40 | 60.1 | 39.9 | 0.1 |
| | 70 | 30 | 70.1 | 29.9 | 0.1 |
| HOC-162 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-163 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-164 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-165 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-166 | 50 | 50 | 50.1 | 49.9 | 0.1 |
| | 60 | 40 | 60 | 40 | 0 |
| | 70 | 30 | 70 | 30 | 0 |
| HOC-167 | 50 | 50 | 50 | 50 | 0 |
| | 60 | 40 | 59.9 | 40.1 | 0.1 |
| | 70 | 30 | 69.8 | 30.2 | 0.2 |
| HOC-168 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-169 | 50 | 50 | 50 | 50 | 0 |
| | 60 | 40 | 60.1 | 39.9 | 0.1 |
| | 70 | 30 | 70.1 | 29.9 | 0.1 |
| HOC-170 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-171 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-172 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-173 | 50 | 50 | 50 | 50 | 0 |
| | 60 | 40 | 60.1 | 39.9 | 0.1 |
| | 70 | 30 | 70.1 | 29.9 | 0.1 |
| HOC-174 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-175 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-176 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-177 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-178 | 50 | 50 | 50.1 | 49.9 | 0.1 |
| | 60 | 40 | 60 | 40 | 0 |
| | 70 | 30 | 70 | 30 | 0 |
| HOC-179 | 50 | 50 | 50 | 50 | 0 |
| | 60 | 40 | 59.9 | 40.1 | 0.1 |
| | 70 | 30 | 69.8 | 30.2 | 0.2 |
| HOC-180 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-181 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-182 | 50 | 50 | 50 | 50 | 0 |
| | 60 | 40 | 60.1 | 39.9 | 0.1 |
| | 70 | 30 | 70.1 | 29.9 | 0.1 |
| HOC-183 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-184 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-185 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-186 | 50 | 50 | 50 | 50 | 0 |
| | 60 | 40 | 60.1 | 39.9 | 0.1 |
| | 70 | 30 | 70.1 | 29.9 | 0.1 |
| HOC-187 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-188 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-189 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-190 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-191 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-192 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-193 | 50 | 50 | 50 | 50 | 0 |
| | 60 | 40 | 60.1 | 39.9 | 0.1 |
| | 70 | 30 | 70.1 | 29.9 | 0.1 |
| HOC-194 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-195 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-196 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-197 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-198 | 50 | 50 | 50.1 | 49.9 | 0.1 |
| | 60 | 40 | 60 | 40 | 0 |
| | 70 | 30 | 70 | 30 | 0 |
| HOC-199 | 50 | 50 | 50 | 50 | 0 |
| | 60 | 40 | 60.1 | 39.9 | 0.1 |
| | 70 | 30 | 70.1 | 29.9 | 0.1 |
| HOC-200 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-201 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-202 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-203 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-204 | 50 | 50 | 50.1 | 49.9 | 0.1 |
| | 60 | 40 | 60 | 40 | 0 |
| | 70 | 30 | 70 | 30 | 0 |
| HOC-205 | 50 | 50 | 50 | 50 | 0 |
| | 60 | 40 | 59.9 | 40.1 | 0.1 |
| | 70 | 30 | 69.8 | 30.2 | 0.2 |
| HOC-206 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-207 | 50 | 50 | 50 | 50 | 0 |
| | 60 | 40 | 60.1 | 39.9 | 0.1 |
| | 70 | 30 | 70.1 | 29.9 | 0.1 |
| HOC-208 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-209 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-210 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-211 | 50 | 50 | 50.1 | 49.9 | 0.1 |
| | 60 | 40 | 60 | 40 | 0 |
| | 70 | 30 | 70 | 30 | 0 |
| HOC-212 | 50 | 50 | 50 | 50 | 0 |
| | 60 | 40 | 59.9 | 40.1 | 0.1 |
| | 70 | 30 | 69.8 | 30.2 | 0.2 |
| HOC-213 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-214 | 50 | 50 | 50 | 50 | 0 |
| | 60 | 40 | 60.1 | 39.9 | 0.1 |
| | 70 | 30 | 70.1 | 29.9 | 0.1 |
| HOC-215 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-216 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-217 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-218 | 50 | 50 | 50 | 50 | 0 |
| | 60 | 40 | 60.1 | 39.9 | 0.1 |
| | 70 | 30 | 70.1 | 29.9 | 0.1 |
| HOC-219 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-220 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-221 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-222 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-223 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-224 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-225 | 50 | 50 | 50 | 50 | 0 |
| | 60 | 40 | 60.1 | 39.9 | 0.1 |
| | 70 | 30 | 70.1 | 29.9 | 0.1 |
| HOC-226 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-227 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-228 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-229 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-230 | 50 | 50 | 50.1 | 49.9 | 0.1 |
| | 60 | 40 | 60 | 40 | 0 |
| | 70 | 30 | 70 | 30 | 0 |
| HOC-231 | 50 | 50 | 50 | 50 | 0 |
| | 60 | 40 | 60.1 | 39.9 | 0.1 |
| | 70 | 30 | 70.1 | 29.9 | 0.1 |
| HOC-232 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-233 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-234 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-235 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-236 | 50 | 50 | 50.1 | 49.9 | 0.1 |
| | 60 | 40 | 60 | 40 | 0 |
| | 70 | 30 | 70 | 30 | 0 |
| HOC-237 | 50 | 50 | 50 | 50 | 0 |
| | 60 | 40 | 59.9 | 40.1 | 0.1 |
| | 70 | 30 | 69.8 | 30.2 | 0.2 |
| HOC-238 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-239 | 50 | 50 | 50 | 50 | 0 |
| | 60 | 40 | 60.1 | 39.9 | 0.1 |
| | 70 | 30 | 70.1 | 29.9 | 0.1 |
| HOC-240 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-241 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-242 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-243 | 50 | 50 | 50 | 50 | 0 |
| | 60 | 40 | 60.1 | 39.9 | 0.1 |
| | 70 | 30 | 70.1 | 29.9 | 0.1 |
| HOC-244 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-245 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-246 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-247 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-248 | 50 | 50 | 50.1 | 49.9 | 0.1 |
| | 60 | 40 | 60 | 40 | 0 |
| | 70 | 30 | 70 | 30 | 0 |
| HOC-249 | 50 | 50 | 50 | 50 | 0 |
| | 60 | 40 | 59.9 | 40.1 | 0.1 |
| | 70 | 30 | 69.8 | 30.2 | 0.2 |
| HOC-250 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-251 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-252 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-253 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-254 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-255 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-256 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-257 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-258 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-259 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-260 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-261 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-262 | 50 | 50 | 50.1 | 49.9 | 0.1 |
| | 60 | 40 | 60 | 40 | 0 |
| | 70 | 30 | 70 | 30 | 0 |
| HOC-263 | 50 | 50 | 50 | 50 | 0 |
| | 60 | 40 | 59.9 | 40.1 | 0.1 |
| | 70 | 30 | 69.8 | 30.2 | 0.2 |
| HOC-264 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-265 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-266 | 50 | 50 | 50.2 | 49.8 | 0.2 |
| | 60 | 40 | 60.2 | 39.8 | 0.2 |
| | 70 | 30 | 70.1 | 29.9 | 0.1 |
| HOC-267 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-268 | 50 | 50 | 50.2 | 49.8 | 0.2 |
| | 60 | 40 | 60.1 | 39.9 | 0.1 |
| | 70 | 30 | 70.1 | 29.9 | 0.1 |
| HOC-269 | 50 | 50 | 50.1 | 49.9 | 0.1 |
| | 60 | 40 | 60 | 40 | 0 |
| | 70 | 30 | 70 | 30 | 0 |
| HOC-270 | 50 | 50 | 50 | 50 | 0 |
| | 60 | 40 | 59.9 | 40.1 | 0.1 |
| | 70 | 30 | 69.8 | 30.2 | 0.2 |
| HOC-271 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-272 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-273 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-274 | 50 | 50 | 50.1 | 49.9 | 0.1 |
| | 60 | 40 | 59.8 | 40.2 | 0.2 |
| | 70 | 30 | 69.8 | 30.2 | 0.2 |
| HOC-275 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-276 | 50 | 50 | 50.2 | 49.8 | 0.2 |
| | 60 | 40 | 60.1 | 39.9 | 0.1 |
| | 70 | 30 | 69.9 | 30.1 | 0.1 |
| HOC-277 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-278 | 50 | 50 | 49.9 | 50.1 | 0.1 |
| | 60 | 40 | 59.9 | 40.1 | 0.1 |
| | 70 | 30 | 69.9 | 30.1 | 0.1 |
| HOC-279 | 50 | 50 | 50.1 | 49.9 | 0.1 |
| | 60 | 40 | 59.8 | 40.2 | 0.2 |
| | 70 | 30 | 70.2 | 29.8 | 0.2 |
| HOC-280 | 50 | 50 | 50.1 | 49.9 | 0.1 |
| | 60 | 40 | 59.8 | 40.2 | 0.2 |
| | 70 | 30 | 69.8 | 30.2 | 0.2 |
| comA (C. Ex. 1) | 50 | 50 | 48.8 | 51.2 | 1.2 |
| | 60 | 40 | 58.1 | 41.9 | 1.9 |
| | 70 | 30 | 67.5 | 32.5 | 2.5 |

As shown in Table 3, as a result of measuring the change over time through a continuous process thin film using a homogeneous organic complexes HOC-1 to HOC-280(Examples 1 to 280) of the present invention as the emission layer of the green organic EL device, it was confirmed that the homogenous organic complexes were able to reproducibly form uniform thin films compared to the simple mixture comA (Comparative Example 1).

## Claims

1. A homogeneous organic complex for an organic electroluminescent device,
wherein the homogeneous organic complex comprises two types of organic compounds including a first organic compound and a second organic compound and is different in maximum emission wavelength from the first organic compound, the second organic compound, and a simple organic mixture of the first and second organic compounds.

2. The homogeneous organic complex of claim 1, wherein the maximum emission wavelength of the homogeneous organic complex may shift to a longer wavelength than the maximum emission wavelength of the first organic compound, the second organic compound, and the simple organic mixture of the first and second organic compounds.

3. The homogeneous organic complex of claim 1, wherein the homogeneous organic complex is a solid at room temperature.

4. The homogeneous organic complex of claim 1, wherein the homogeneous organic complex is formed by fully dissolving the first and second organic compounds in at least one organic solvent to form a homogeneous phase and solidifying the homogeneous phase.

5. The homogeneous organic complex of claim 4, wherein the homogeneous organic complex is compressed and molded under non-heat treatment conditions after solidification.

6. The homogeneous organic complex of claim 5, wherein the solidified homogeneous organic complex is in a form of a powder or stick, and
the compressed and molded homogeneous organic complex has a pellet shape selected from the group consisting of polyhedral, cylindrical, and spherical shapes.

7. The homogeneous organic complex of claim 1, wherein the first organic compound and the second organic compound have a deposition temperature difference of 0 to 30°C under a pressure of 10⁻⁶ torr.

8. The homogeneous organic complex of claim 1, wherein the first organic compound and the second organic compound are included at a weight ratio of 1:99 to 99:1.

9. The homogeneous organic complex of claim 1, wherein the homogeneous organic complex is free of inorganic substances and dopants.

10. The homogeneous organic complex of claim 1, wherein the first organic compound and the second organic compound are same or different and are each independently selected from the group consisting of host materials, electron injection materials, electron transport materials, electron blocking materials, hole injection materials, hole transport materials, hole blocking materials, and exciton blocking materials.

11. The homogeneous organic complex of claim 1, wherein the first organic compound and the second organic compounds are host materials.

12. The homogeneous organic complex of claim 1, wherein the first organic compound has higher hole properties than the second organic compound, and
the second organic compound comprises an electron withdrawing group (EWG) represented by at least one of the following Chemical Formulas: 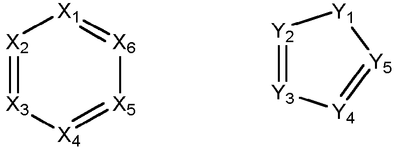 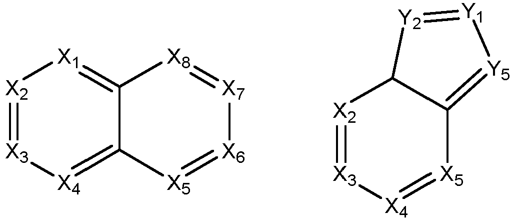
wherein,
X₁ to X₈ and Y₁ to Y₅, which are same or different, are each independently N or C(R), with a proviso that a monocyclic moiety or a polycyclic moiety comprises at least one N atom,
when two or more C(R) groups, the R's are same or different and are each independently selected from the group consisting of a hydrogen atom, a deuterium atom, a halogen, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, or may bond with an adjacent groups to form a fuse ring,
the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the arylphosphine group, the arylphosphine oxide group, and the arylamine group of R may have at least one substituent selected from the group consisting of a hydrogen atom, a deuterium atom (D), a halogen, a cyano group, a nitro group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkyl boron group of C₁-C₄₀, an arylboron group of C₆-C₆₀, an arylphosphine group of C₆-C₆₀, an arylphosphine oxide group of C₆-C₆₀, and an arylamine group of C₆-C₆₀, and when the substituents are plural in number, the substituents are the same as or different from each other.

13. The homogeneous organic complex of claim 13, wherein the second organic compound comprises at least one of nitrogen-containing moieties represented by the following Chemical Formulas:

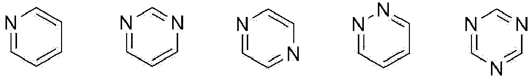

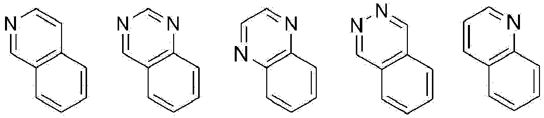

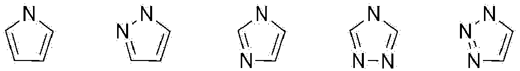

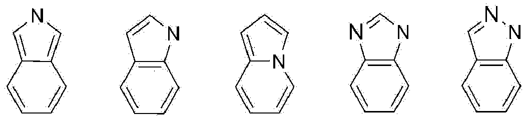

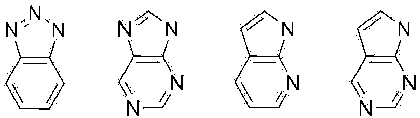

14. An organic electroluminescent device, comprising:
an anode;
a cathode disposed facing the anode; and
at least one organic layer disposed between the anode and the cathode,
wherein the at least one organic layer comprises the homogeneous organic complex of any one of claims 1 to 13.

15. The organic electroluminescent device of claim 14, wherein the at least one organic layer is formed by depositing the homogeneous organic complex, which is solid at room temperature.

16. A method for manufacturing a homogeneous organic complex of claim 1, the method comprising:
a first step of fully dissolving two or more types of organic compounds in at least one organic solvent to form a homogeneous phase and then solidifying same; and
a second step of compressing the solidified homogeneous organic complex under non-heat treatment conditions to mold same.

17. The method of claim 16, wherein the second step is carried out under a pressure of 20,000 to 40,000 kgf/cm².

18. The method of claim 16, wherein the solidified homogeneous organic complex prepared in the first step is in a form of a powder or stick, and
the homogeneous organic complex molded in the second step has a pellet shape selected from the group consisting of polyhedral, cylindrical, and spherical shapes.
